(19) Europäisches Patentamt / European Patent Office / Office européen des brevets

(11) EP 4 130 191 A1

(12) **EUROPEAN PATENT APPLICATION**
published in accordance with Art. 153(4) EPC

(43) Date of publication:
**08.02.2023 Bulletin 2023/06**

(21) Application number: **21779365.2**

(22) Date of filing: **19.03.2021**

(51) International Patent Classification (IPC):
***C09K 11/06*** *(1974.07)* ***H01L 51/50*** *(2006.01)*

(52) Cooperative Patent Classification (CPC):
**C09K 11/06; H01L 51/50**

(86) International application number:
**PCT/JP2021/011289**

(87) International publication number:
**WO 2021/200252 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020 JP 2020063320**

(71) Applicant: **NIPPON STEEL Chemical & Material Co., Ltd.**
**Tokyo 103-0027 (JP)**

(72) Inventors:
- **TADA, Masashi**
  **Tokyo 103-0027 (JP)**
- **INOUE, Munetomo**
  **Tokyo 103-0027 (JP)**
- **TERADA, Ayaka**
  **Tokyo 103-0027 (JP)**
- **SAGARA, Yuta**
  **Tokyo 103-0027 (JP)**

(74) Representative: **Vossius & Partner Patentanwälte Rechtsanwälte mbB**
**Siebertstraße 3**
**81675 München (DE)**

# (54) ORGANIC ELECTROLUMINESCENT DEVICE

(57) Provided is a blue light emitting organic EL device having high emission efficiency and a long lifetime. This organic EL device comprises one or more light emitting layers between an anode and a cathode opposite to each other, wherein at least one of the light emitting layers contains a first host, a second host, and a light emitting dopant; the first host is a carbazole compound or a bicarbazole compound; the second host is an indolocarbazole compound; and the light emitting dopant is a polycyclic aromatic compound represented by the general formula (4) or a polycyclic aromatic compound having this structure as a partial structure. In the formula, $Y^4$ is B, P, P=O, P=S, AL, Ga, As, Si-$R^4$, or Ge-$R^{41}$, and $X^4$ is O, N-$Ar^4$, S, or Se.

[Fig. 1]

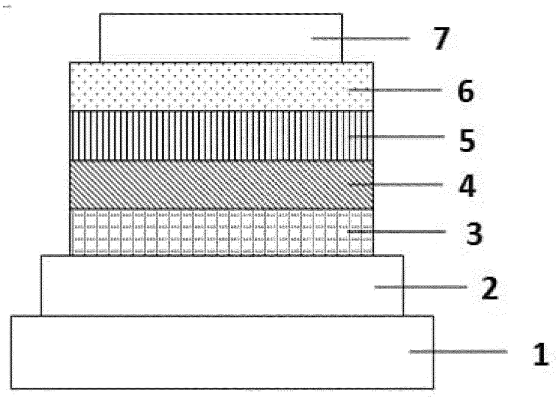




Processed by Luminess, 75001 PARIS (FR)

## Description

### Technical Field

The present invention relates to an organic electroluminescent device or element (also referred to as an organic EL device or element).

### Background Art

When a voltage is applied to an organic EL device, holes and electrons are injected from the anode and the cathode, respectively, into the light emitting layer. Then, the injected holes and electrons are recombined in the light emitting layer to thereby generate excitons. At this time, according to the electron spin statistics theory, singlet excitons and triplet excitons are generated at a ratio of 1:3. In the fluorescent organic EL device that uses emission caused by singlet excitons, the limit of the internal quantum efficiency is said to be 25%. On the other hand, it has been known that, in the phosphorescent organic EL device that uses emission caused by triplet excitons, the internal quantum efficiency can be enhanced up to 100% when intersystem crossing efficiently occurs from singlet excitons.

However, the blue phosphorescent organic EL device has a technical problem of extending the lifetime.

In recent years, a highly efficient organic EL device utilizing delayed fluorescence has been developed. For example, Patent Literature 1 discloses an organic EL device utilizing the Triplet-Triplet Fusion (TTF) mechanism, which is one of the mechanisms of delayed fluorescence. The TTF mechanism utilizes a phenomenon in which a singlet exciton is generated by the collision of two triplet excitons, and it is believed that the internal quantum efficiency can be enhanced up to 40%, in theory. However, its efficiency is low as compared with the efficiency of the phosphorescent organic EL device, and thus further improvement in efficiency is desired.

Patent Literature 2 discloses an organic EL device utilizing the Thermally Activated Delayed Fluorescence (TADF) mechanism. The TADF mechanism utilizes a phenomenon in which reverse intersystem crossing occurs from the triplet exciton to the singlet exciton in a material having a small energy difference between the singlet level and the triplet level, and it is believed that the internal quantum efficiency can be enhanced up to 100%, in theory. However, further improvement in lifetime characteristics is desired as in the phosphorescent device.

### Citation List

### Patent Literature

Patent Literature 1: International Publication No. WO2010/134350
Patent Literature 2: International Publication No. WO2011/070963
Patent Literature 3: International Publication No. WO2017/138526
Patent Literature 4: International Publication No. WO2018/198844
Patent Literature 5: International Publication No. WO2020/040298

Patent Literature 3 discloses an organic EL device using a TADF material typified by the following polycyclic aromatic compounds as a light emitting dopant, but does not disclose practical lifetime characteristics.

[C1]

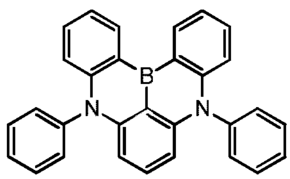
a1

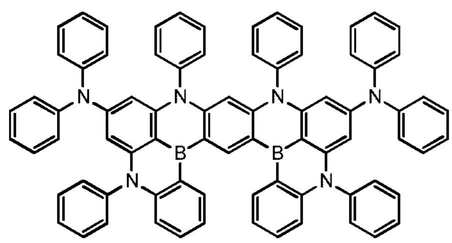
a2

Patent Literature 4 discloses a phosphorescent organic EL device using a mixture of an indolocarbazole compound and a carbazole compound typified by the following compounds in the light emitting layer, but does not disclose an organic EL device having a light emitting layer in which a polycyclic aromatic compound represented by the general formula (4) is mixed and exhibiting practical lifetime characteristics.

[C2]

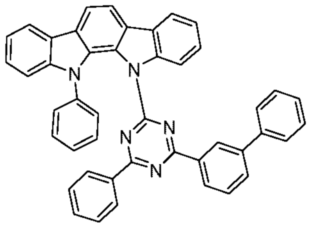

a3

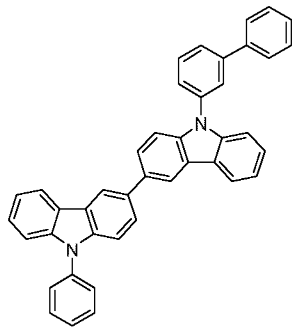

a4

Patent Literature 5 discloses an organic EL device using a mixture of a boron-based compound (a5), a TADF compound (a6), and a carbazole compound (a7) in the light emitting layer, but does not disclose an organic EL device exhibiting practical lifetime characteristics in which a mixture of a first host represented by the general formula (1) or the general formula (2) and a second host represented by the general formula (3) is used in the light emitting layer.

[C3]

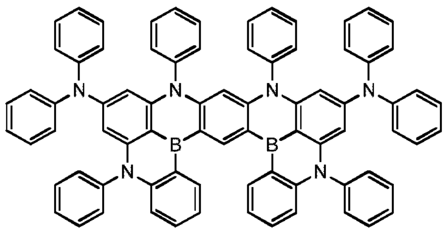

a5

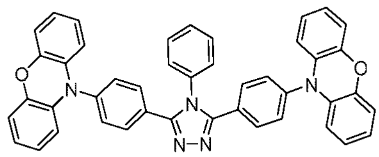

a6

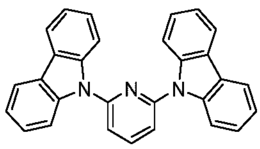

a7

Summary of Invention

In order to apply an organic EL device to a display device such as a flat panel display and a light source, it is necessary to improve the emission efficiency of the device and sufficiently ensure the stability of the device at the time of driving, at the same time. An object of the present invention is to provide a practically useful organic EL device having high efficiency and a long lifetime.

The present invention is an organic electroluminescent device comprising one or more light emitting layers between an anode and a cathode opposite to each other, wherein at least one of the light emitting layers contains hosts and a light emitting dopant, the hosts include a first host represented by the general formula (1) or the general formula (2) and a second host represented by the general formula (3); and the light emitting dopant contains a polycyclic aromatic compound represented by the general formula (4) or a polycyclic aromatic compound having a structure represented by the general formula (4) as a partial structure.

[C4]

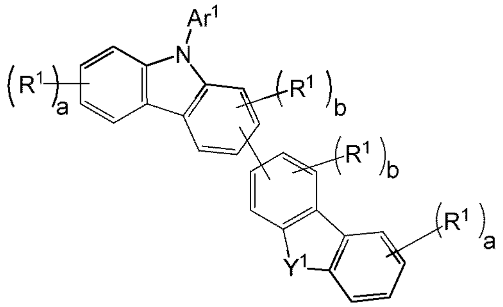

(1)

In the formula, $Y^1$ represents O, S, or N-$Ar^1$.

$Ar^1$ independently represents a substituted or unsubstituted aromatic hydrocarbon group having 6 to 18 carbon atoms, a substituted or unsubstituted aromatic heterocyclic group having 3 to 17 carbon atoms, or a linked aromatic group formed by linking 2 to 8 aromatic rings thereof.

$R^1$ independently represents deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.

a independently represents an integer of 0 to 4, and b independently represents an integer of 0 to 3.

[C5]

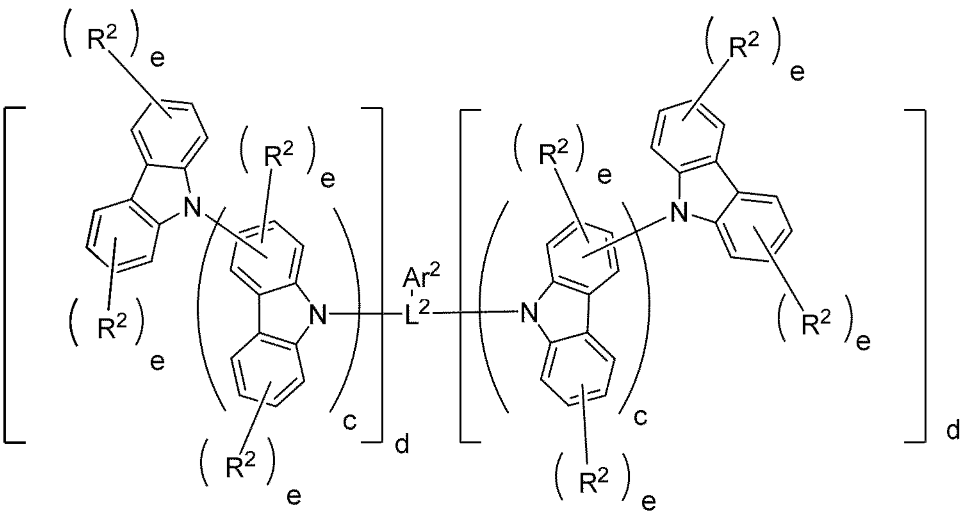

(2)

In the formula, c is independently an integer of 0 to 5, d is independently an integer of 0 to 2 and at least one d is 1 or more. e is independently an integer of 0 to 2.

$R^2$ is independently a cyano group, an aliphatic hydrocarbon group having 1 to 10 carbon atoms, or a substituted or unsubstituted aromatic hydrocarbon group having 6 to 18 carbon atoms, and

$L^2$ is a substituted or unsubstituted aromatic hydrocarbon group having 6 to 18 carbon atoms or a substituted or unsubstituted aromatic heterocyclic group having 3 to 17 carbon atoms.

$Ar^2$ is hydrogen, a cyano group, an aliphatic hydrocarbon group having 1 to 10 carbon atoms, a substituted or unsubstituted aromatic hydrocarbon group having 6 to 18 carbon atoms, a substituted or unsubstituted aromatic heterocyclic group having 3 to 17 carbon atoms, or a linked aromatic group in which 2 to 3 of these aromatic rings are linked to each other.

[C6]

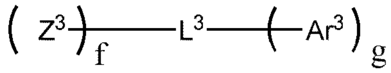

(3)

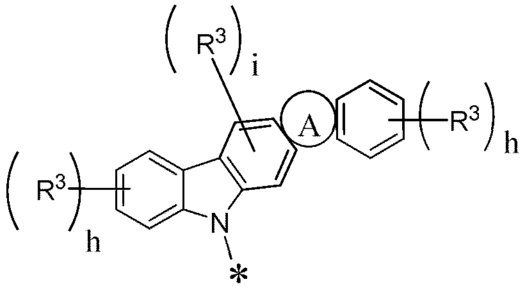

(3a)

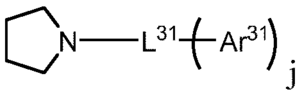

(3b)

In the formula, $Z^3$ is an indolocarbazole ring-containing group represented by the formula (3a), * is a bonding site to $L^3$, and

the ring A is a heterocyclic ring represented by the formula (3b) and is fused with an adjacent ring at an arbitrary position.
each of $L^3$ and $L^{31}$ is independently a substituted or unsubstituted aromatic hydrocarbon group having 6 to 30 carbon atoms, or a substituted or unsubstituted aromatic heterocyclic group having 3 to 17 carbon atoms.
each of $Ar^3$ and $Ar^{31}$ is independently a substituted or unsubstituted aromatic hydrocarbon group having 6 to 30 carbon atoms, a substituted or unsubstituted aromatic heterocyclic group having 3 to 17 carbon atoms, or a linked aromatic group in which 2 to 8 of these aromatic rings are linked to each other.
$R^3$ independently is an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.
f represents an integer of 1 to 3, g represents an integer of 0 to 3, h independently represents an integer of 0 to 4, i represents an integer of 0 to 2, and j represents an integer of 0 to 3.

[C7]

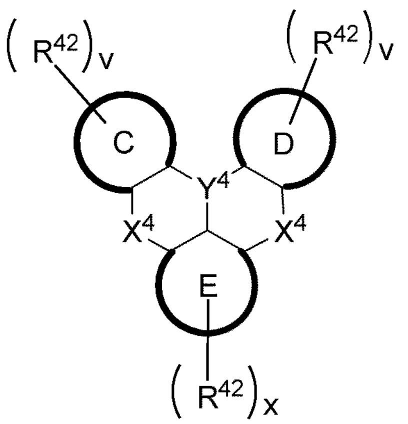

(4)

In the formula, the ring C, the ring D, and the ring E are independently an aromatic hydrocarbon ring having 6 to 24 carbon atoms or an aromatic heterocyclic ring having 3 to 17 carbon atoms.

$Y^4$ is B, P, P=O, P=S, AL, Ga, As, Si-$R^4$, or Ge-$R^{41}$,
$X^4$ is independently O, N-$Ar^4$, S, or Se,
each of $R^4$ and $R^{41}$ is independently an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms,
$Ar^4$ is independently a substituted or unsubstituted aromatic hydrocarbon group having 6 to 18 carbon atoms, a substituted or unsubstituted aromatic heterocyclic group having 3 to 17 carbon atoms, or a linked aromatic group in which 2 to 8 of these aromatic rings are linked to each other, N-$Ar^4$ is optionally bonded to the ring C, the ring D, or the ring E to form a heterocyclic ring containing N,
each $R^{42}$ independently represents a cyano group, deuterium, a diarylamino group having 12 to 44 carbon atoms, an arylheteroarylamino group having 12 to 44 carbon atoms, a diheteroarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms, and
each v independently represents an integer of 0 to 4, and x represents an integer of 0 to 3.
At least one hydrogen in the ring C, the ring D, the ring E, $R^4$, $R^{41}$, $R^{42}$, and $Ar^4$ is optionally replaced with a halogen or deuterium.

Examples of the polycyclic aromatic compound having a structure represented by the general formula (4) as a partial structure include a polycyclic aromatic compound represented by the following formula (5) or a boron-containing polycyclic aromatic compound represented by the following formula (6).

[C8]

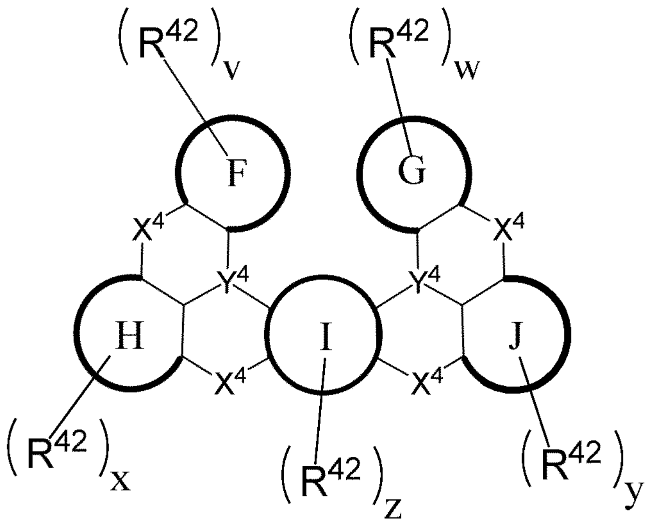

(5)

In the formula, each of the ring F, the ring G, the ring H, the ring I, and the ring J is independently an aromatic hydrocarbon ring having 6 to 24 carbon atoms or an aromatic heterocyclic ring having 3 to 17 carbon atoms, and at least one hydrogen in the ring F, the ring G, the ring H, the ring I, and the ring J is optionally replaced with a halogen or deuterium.
$X^4$, $Y^4$, $R^{42}$, x, and v are as defined in the general formula (4), w represents an integer of 0 to 4, y represents an integer of 0 to 3, and z represents an integer of 0 to 2.

[C9]

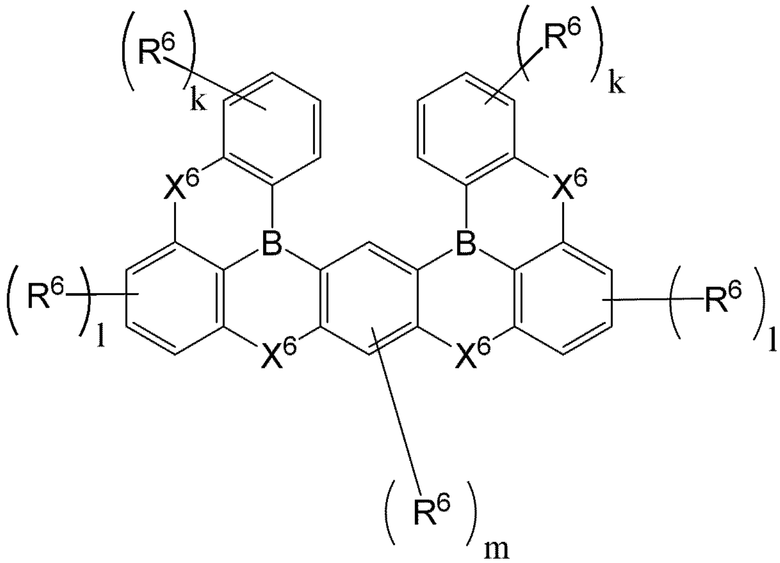

(6)

In the formula, $X^6$ independently represents N-$Ar^6$, O, or S, provided that at least one $X^6$ represents N-$Ar^6$. $Ar^6$ independently represents a substituted or unsubstituted aromatic hydrocarbon group having 6 to 18 carbon atoms, a substituted or unsubstituted aromatic heterocyclic group having 3 to 17 carbon atoms, or a linked aromatic group formed by linking 2 to 8 aromatic rings thereof, and N-$Ar^6$ is optionally bonded to an aromatic ring to which $X^6$ is bonded to form a heterocyclic ring containing N.

$R^6$ independently represents a cyano group, deuterium, a diarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.

k independently represents an integer of 0 to 4, l independently represents an integer of 0 to 3, and m represents an integer of 0 to 2.

The first host is preferably a first host represented by the general formula (1), and $Y^1$ in the general formula (1) is preferably N-$Ar^1$. Preferred examples of the general formula (1) include the following formula (7).

[C10]

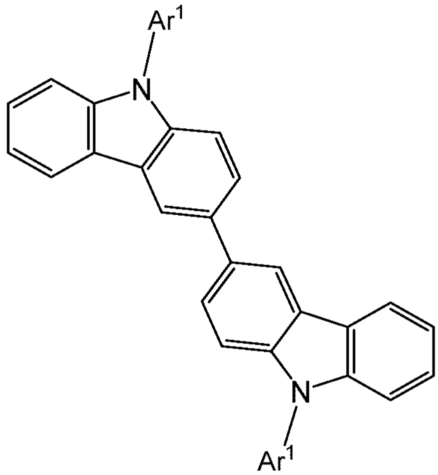

(7)

In the formula, $Ar^1$ is as defined in the general formula (1).

Another mode of the present invention is the above organic electroluminescent device containing a first host represented by the general formula (2) and a second host represented by the general formula (3) in the light emitting layer.

Preferred examples of the general formula (2) include the following formula (8).

[C11]

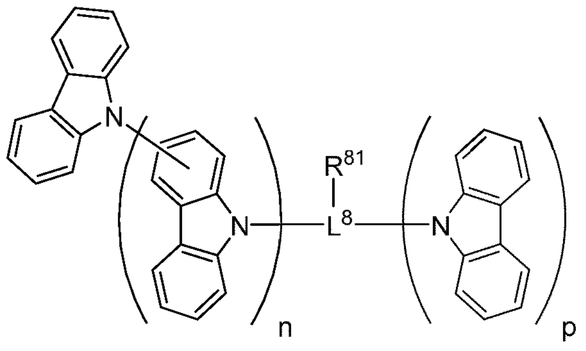

(8)

In the formula, n is an integer of 1 to 5, p is an integer of 0 to 1,

$L^8$ represents a group produced from benzene, dibenzofuran, or dibenzothiophene.
$R^{81}$ represents hydrogen or a group produced from benzene, dibenzofuran, or dibenzothiophene.

The light emitting dopant preferably has a difference between excited singlet energy (S1) and excited triplet energy (T1) (ΔEST) of 0.20 eV or less, and more preferably 0.10 eV or less.

It is preferred that 99.9 to 90 wt% of the hosts and 0.10 to 10 wt% of the light emitting dopant be contained in the light emitting layer, and that the first host be contained in an amount of 10 to 90 wt% and the second host be contained in an amount of 90 to 10 wt%, based on the hosts.

The present invention is an organic EL device comprising one or more light emitting layers between an anode and a cathode opposite to each other, wherein at least one of the light emitting layers contains an organic emission material having a difference between excited singlet energy (S1) and excited triplet energy (T1) (ΔEST) of 0.20 eV or less as a light emitting dopant, and also contains the above first host and second host.

Since the organic EL device of the present invention contains a specific light emitting dopant and a plurality of specific host materials in the light emitting layer, the organic EL device of the present invention is considered to be an organic EL device having a low driving voltage, high emission efficiency, and a long lifetime.

The reason for the low driving voltage of the organic EL device of the present invention is considered that the carbazole compound used as the first host material has characteristics such that holes are easily injected and the indolocarbazole compound used as the second host material has characteristics such that electrons are easily injected, and thus holes and electrons are presumed to be injected at a lower voltage, so that excitons are generated.

The reason for the high emission efficiency of the organic EL device of the present invention is considered that the carbazole compound has characteristics such that holes are easily injected and the indolocarbazole compound has characteristics such that electrons are easily injected, so that the balance between the holes and electrons in the light emitting layer can be maintained.

The reason for the long lifetime of the organic EL device of the present invention is considered that, when a voltage is applied to the organic EL device, holes and electrons are preferentially injected into the first host consisting of the carbazole compound and the second host consisting of the indolocarbazole compound, respectively, so that the electrochemical burden on the light emitting dopant is reduced.

Brief Description of Drawing

[Figure 1] Figure 1 shows a cross-sectional view of one example of the organic EL device.

Description of Embodiments

The organic EL device of the present invention has one or more light emitting layers between an anode and a cathode opposite to each other, and at least one of the light emitting layers contains a first host, a second host, and a light emitting dopant.

The above first host is selected from the compounds represented by the general formula (1) or the general formula (2), and the second host is selected from the compounds represented by the general formula (3). The light emitting dopant is selected from the polycyclic aromatic compounds represented by the general formula (4) or the

polycyclic aromatic compounds having a structure represented by the general formula (4) as a partial structure. The polycyclic aromatic compound having a structure represented by the general formula (4) as a partial structure is also referred to as the substructured polycyclic aromatic compound.

The above compound represented by the general formula (1) or (2) used in the present invention as the first host will be described.

In the general formula (1), $Y^1$ represents O, S, or N-$Ar^1$. $Y^1$ preferably represents O or N-$Ar^1$, and more preferably N-$Ar^1$.

Examples of a preferred mode of the general formula (1) include the general formula (7). In the general formulas (1) and (7), common symbols have the same meaning.

$Ar^1$ independently represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 aromatic rings thereof. $Ar^1$ is preferably a substituted or unsubstituted aromatic hydrocarbon group having 6 to 12 carbon atoms, or a substituted or unsubstituted linked aromatic group formed by linking 2 to 4 aromatic rings thereof. $Ar^1$ is more preferably a phenyl group, a biphenyl group, or a terphenyl group.

When $Ar^1$ is an unsubstituted aromatic hydrocarbon group, aromatic heterocyclic group, or linked aromatic group, specific examples of $Ar^1$ include a group produced by removing one hydrogen atom from benzene, naphthalene, acenaphthene, acenaphthylene, azulene, anthracene, chrysene, pyrene, phenanthrene, triphenylene, fluorene, benzo[a] anthracene, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, pyridine, pyrimidine, triazine, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a compound formed by linking 2 to 8 of these compounds. Preferred examples thereof include a group produced by removing one hydrogen atom from benzene, naphthalene, acenaphthene, acenaphthylene, azulene, and a compound formed by linking 2 to 4 of these compounds. More preferred examples thereof include a group produced from benzene, biphenyl, and terphenyl.

As used herein, the linked aromatic group refers to a group in which aromatic rings in the aromatic hydrocarbon group or the aromatic heterocyclic group are linked through a single bond, and these rings may be linked in a linear or branched form. The aromatic rings may be identical or different from each other. When a group corresponds to the linked aromatic group, the group is different from the substituted aromatic hydrocarbon group or the substituted aromatic heterocyclic group.

$R^1$ independently represents deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. Preferably, $R^1$ is an aliphatic hydrocarbon group having 1 to 8 carbon atoms, a substituted or unsubstituted aromatic hydrocarbon group having 6 to 12 carbon atoms, or a substituted or unsubstituted aromatic heterocyclic group having 3 to 15 carbon atoms. More preferably, $R^1$ is a substituted or unsubstituted aromatic hydrocarbon group having 6 to 10 carbon atoms, or a substituted or unsubstituted aromatic heterocyclic group having 3 to 12 carbon atoms.

It is preferred that $Ar^1$ and $R^1$ be not a group produced from pyridine, pyrimidine, or triazine.
a represents an integer of 0 to 4, and b represents an integer of 0 to 3. Preferably, a is an integer of 0 to 1, and b is an integer of 0 to 1.

When $R^1$ is an aliphatic hydrocarbon group having 1 to 10 carbon atoms, specific examples thereof include methyl, ethyl, propyl, butyl, pentyl, hexyl, heptyl, octyl, and nonyl. Preferred examples thereof include methyl, ethyl, propyl, butyl, pentyl, hexyl, heptyl, and octyl.

When $R^1$ is an unsubstituted aromatic hydrocarbon group having 6 to 18 carbon atoms or unsubstituted aromatic heterocyclic group having 3 to 17 carbon atoms, specific examples thereof are the same as the description for $Ar^1$ described above.

As used herein, the substituted aromatic hydrocarbon group, aromatic heterocyclic group, or linked aromatic group may have a substituent, and the substituent is preferably deuterium, a cyano group, a triarylsilyl group, an aliphatic hydrocarbon group having 1 to 10 carbon atoms, or a diarylamino group having 12 to 44 carbon atoms. Here, when the substituent is an aliphatic hydrocarbon group having 1 to 10 carbon atoms, the substituent may be linear, branched, or cyclic. The number of substituents is 0 to 5, and preferably 0 to 2. When the aromatic hydrocarbon group or the aromatic heterocyclic group has a substituent, the number of carbon atoms of the substituent is not included in the calculation of the number of carbon atoms. However, it is preferred that the total number of carbon atoms including the number of carbon atoms of the substituent satisfy the above range.

Specific examples of the above substituents include cyano, methyl, ethyl, propyl, i-propyl, butyl, t-butyl, pentyl, cyclopentyl, hexyl, cyclohexyl, heptyl, octyl, nonyl, decyl, diphenylamino, naphthylphenylamino, dinaphthylamino, dianthranilamino, diphenanthrenylamino, and dipyrenylamino. Preferred examples thereof include cyano, methyl, ethyl, propyl, butyl, pentyl, hexyl, heptyl, octyl, diphenylamino, naphthylphenylamino, and dinaphthylamino.

As used herein, it is recognized that hydrogen may be deuterium. That is, in the general formulas (1) to (4) and the like, a part or the whole of H included in the skeleton such as carbazole and the substituent such as $R^1$ and $Ar^1$ may be deuterium.

Specific examples of the compounds represented by the general formula (1) are shown below, but the compounds are not limited to these exemplified compounds.

[C12]

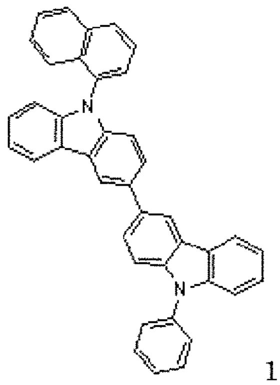
1-1

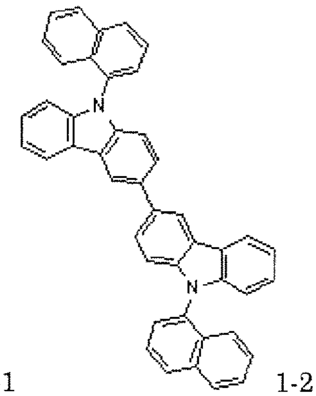
1-2

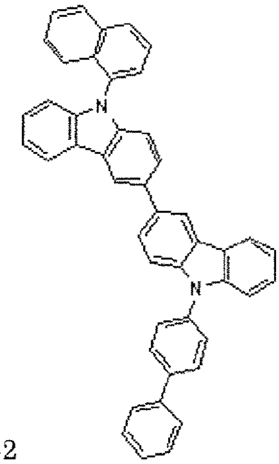
1-3

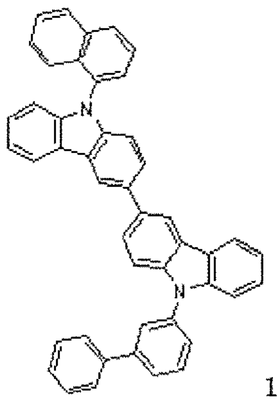
1-4

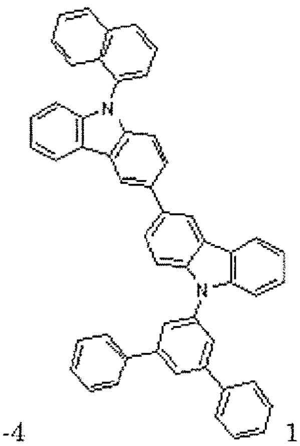
1-5

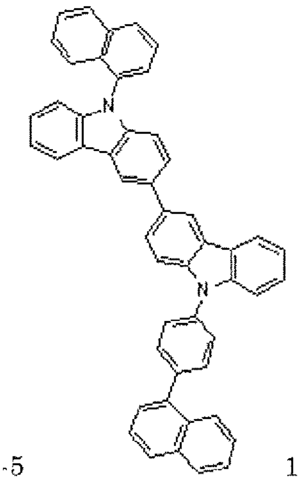
1-6

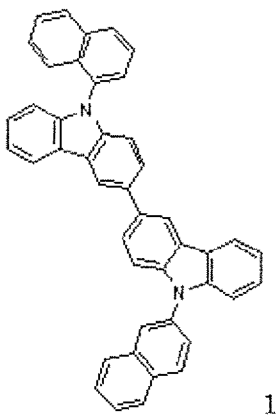
1-7

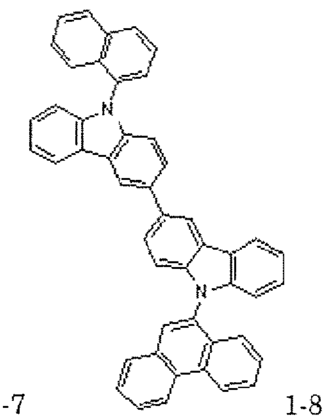
1-8

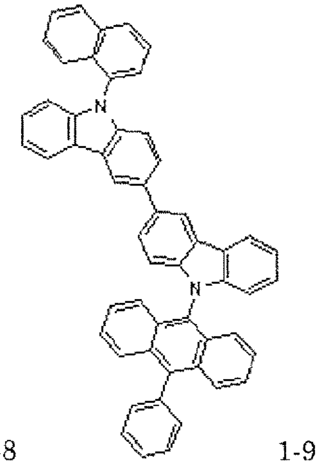
1-9

[C13]

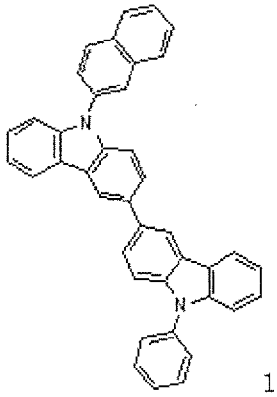
1-10

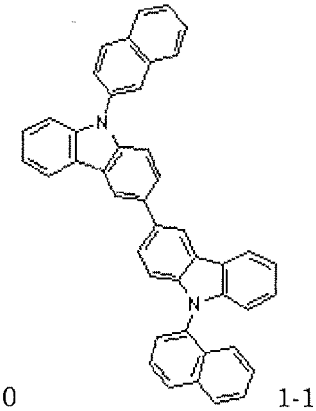
1-11

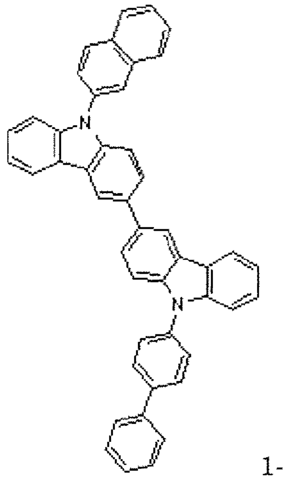
1-12

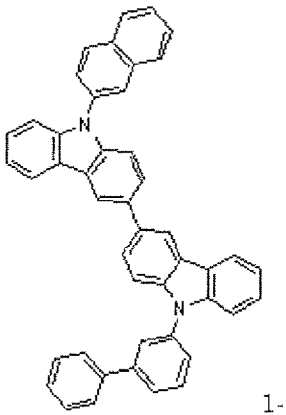
1-13

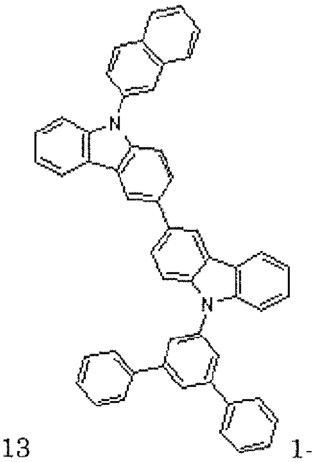
1-14

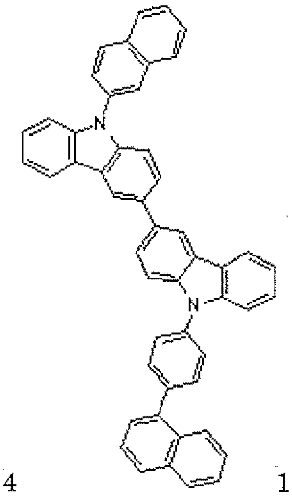
1-15

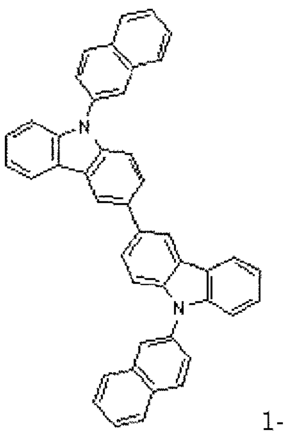
1-16

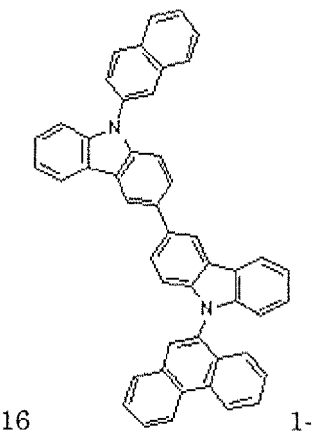
1-17

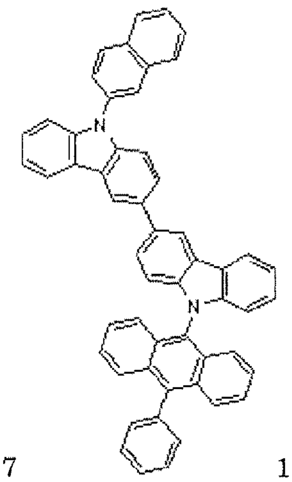
1-18

[C14]

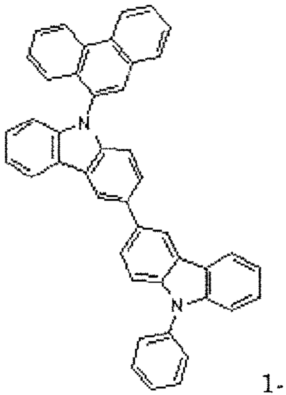
1-19

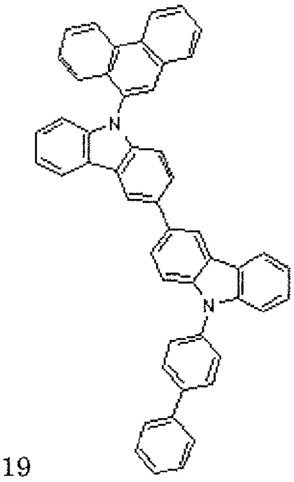
1-20

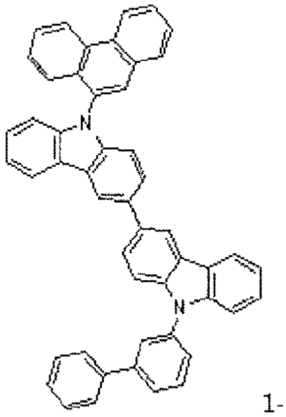
1-21

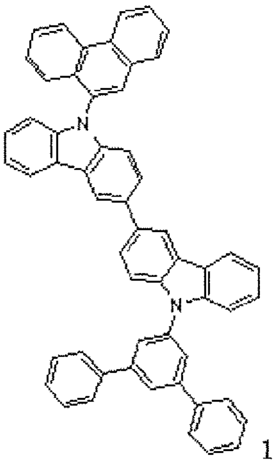
1-22

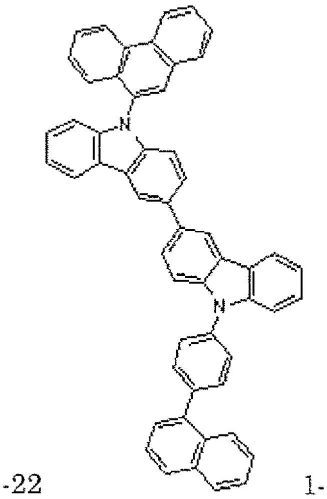
1-23

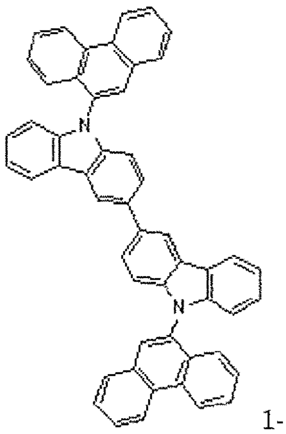
1-24

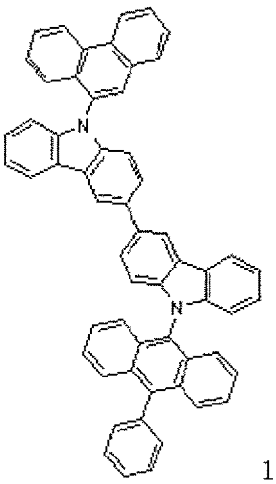
1-25

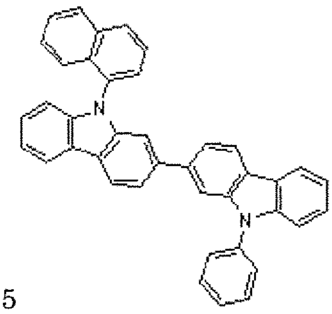
1-26

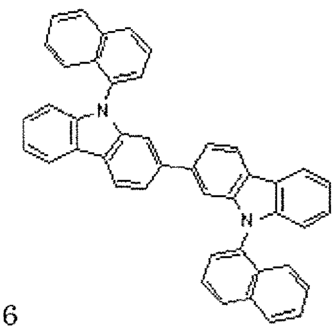
1-27

[C15]

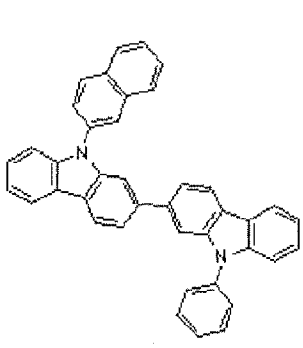 1-28 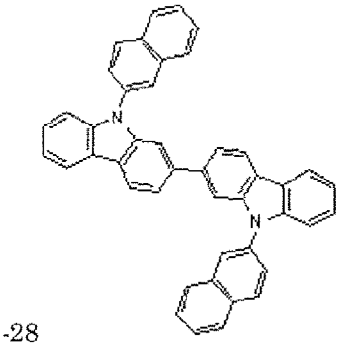 1-29 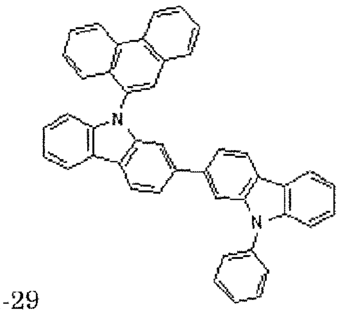 1-30

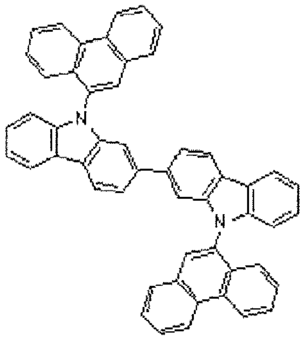 1-31 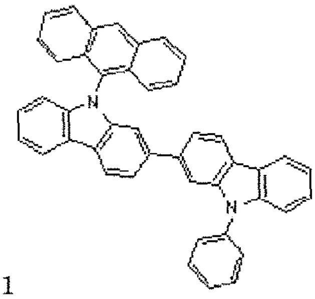 1-32 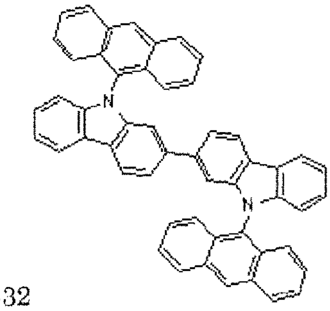 1-33

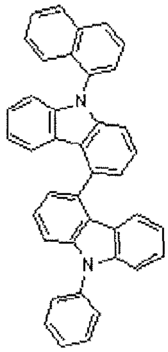 1-34 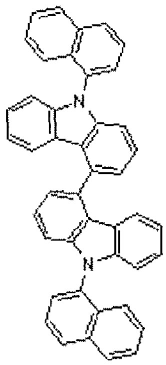 1-35 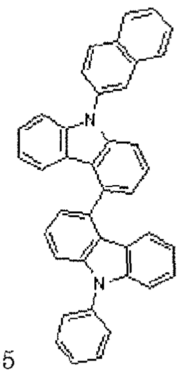 1-36 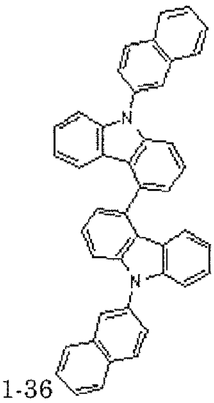 1-37

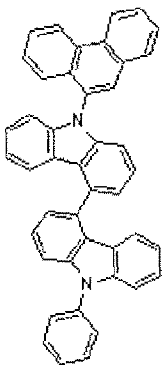 1-38 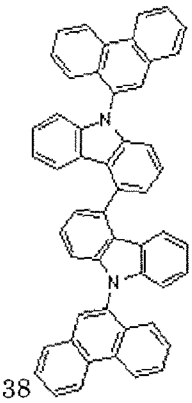 1-39 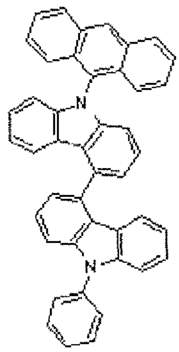 1-40 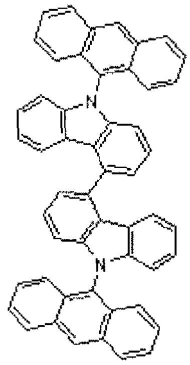 1-41

[C16]

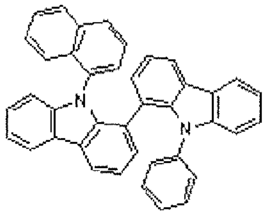
1-42

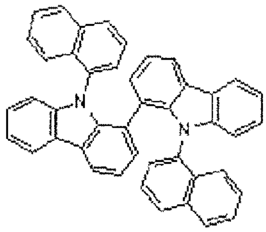
1-43

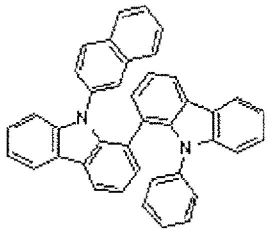
1-44

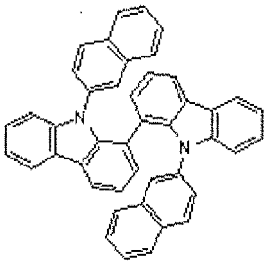
1-45

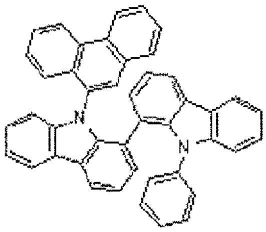
1-46

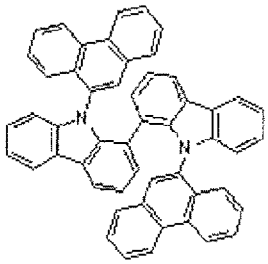
1-47

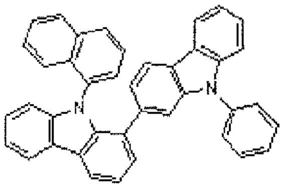
1-48

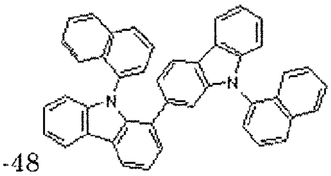
1-49

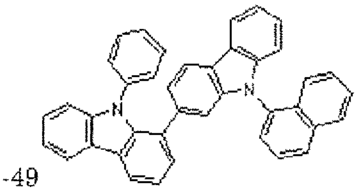
1-50

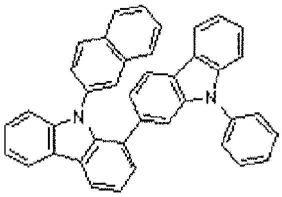
1-51

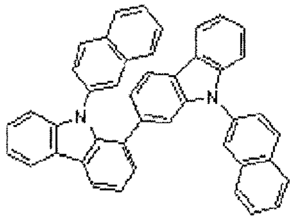
1-52

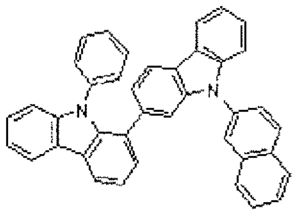
1-53

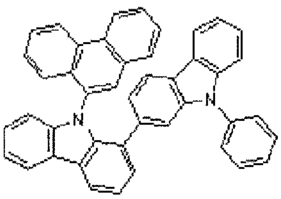
1-54

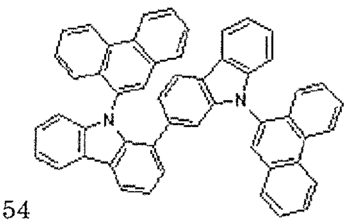
1-55

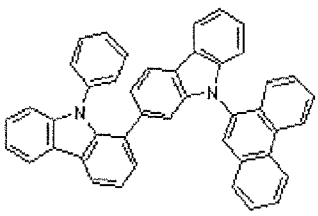
1-56

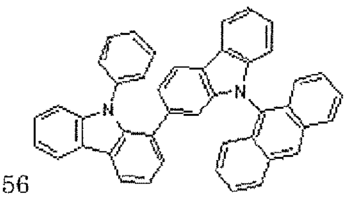
1-57

[C17]

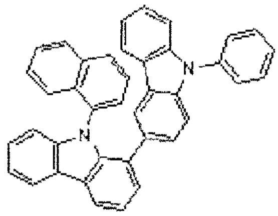
1-58

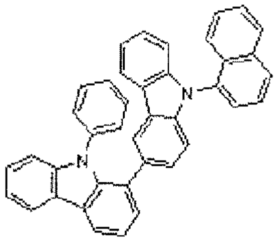
1-59

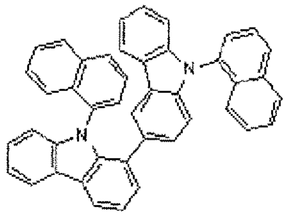
1-60

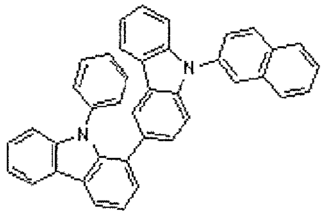
1-61

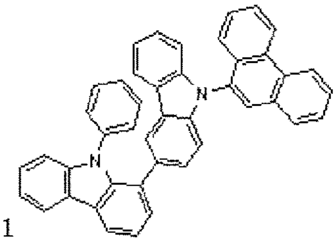
1-62

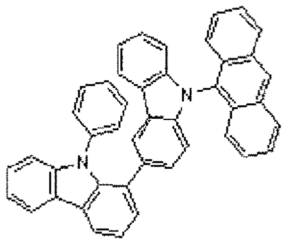
1-63

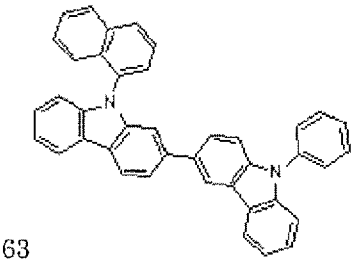
1-64

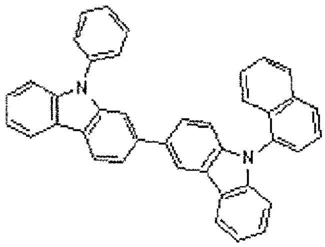
1-65

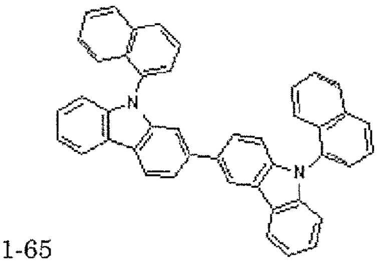
1-66

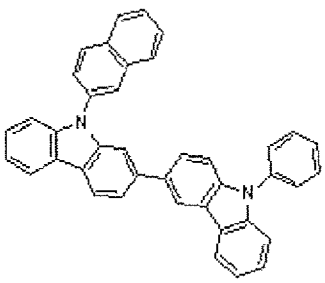
1-67

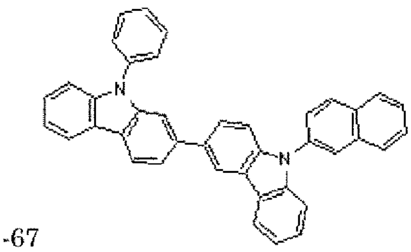
1-68

[C18]

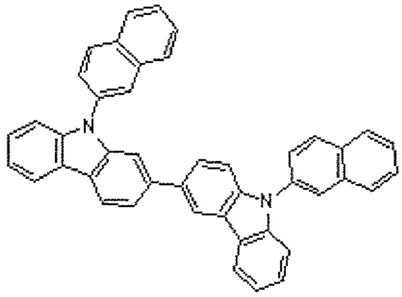

1-69

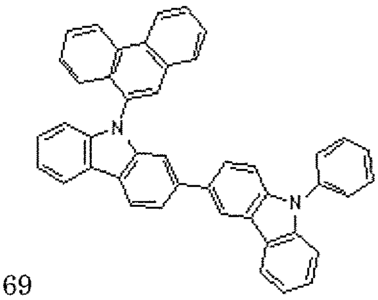

1-70

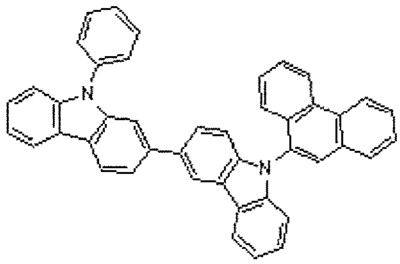

1-71

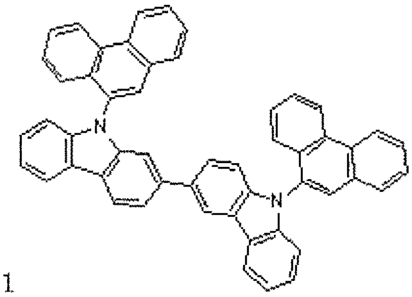

1-72

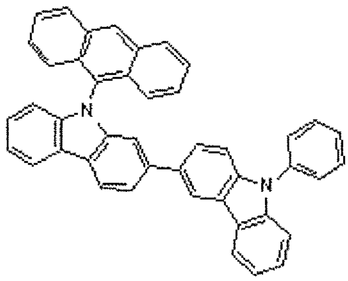

1-73

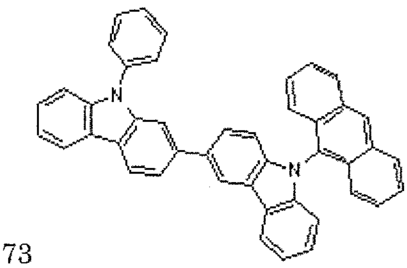

1-74

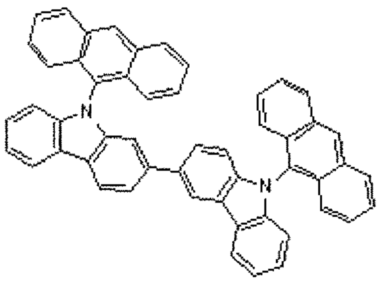

1-75

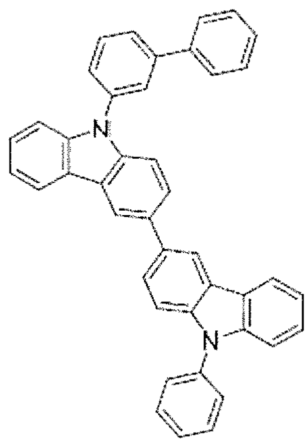

1-76

[C19]

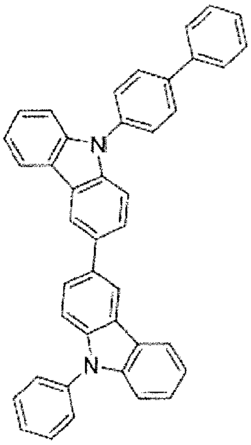
1-77

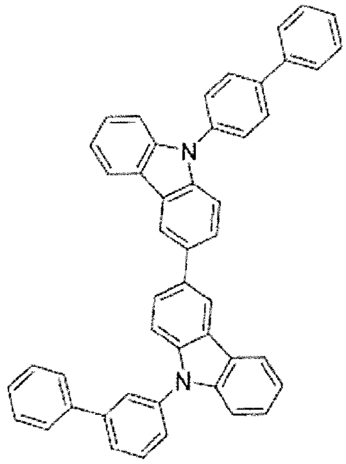
1-78

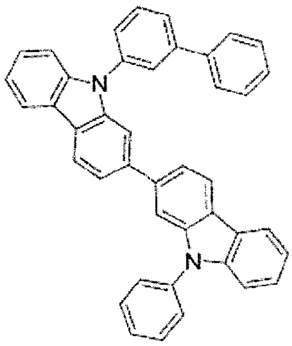
1-79

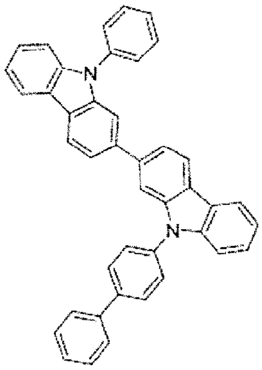
1-80

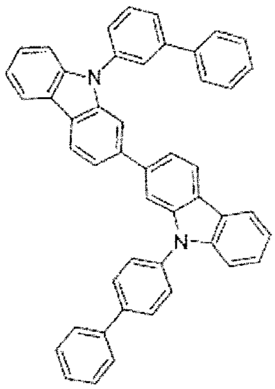
1-81

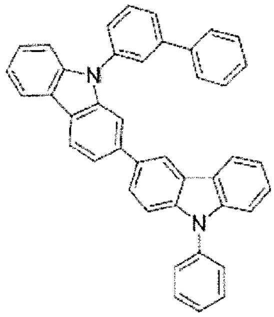
1-82

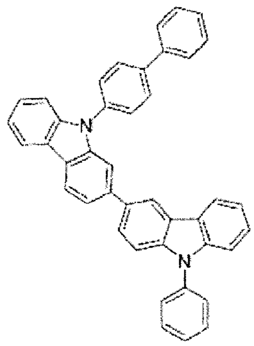
1-83

[C20]

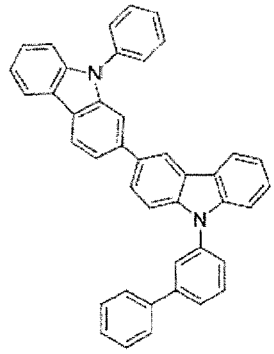

1-84

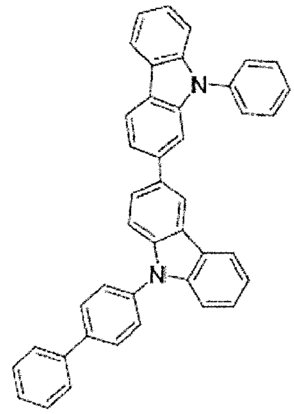

1-85

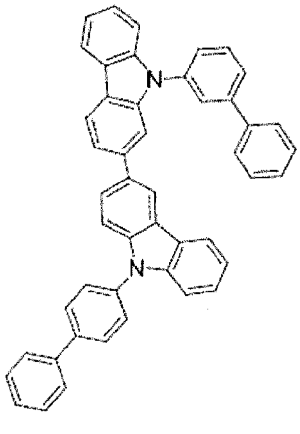

1-86

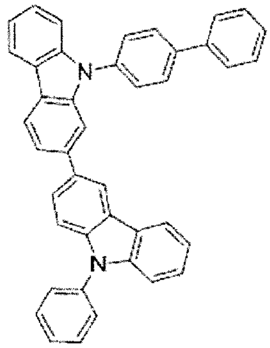

1-87

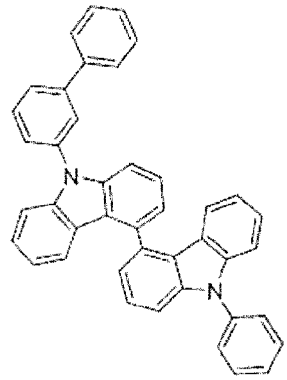

1-88

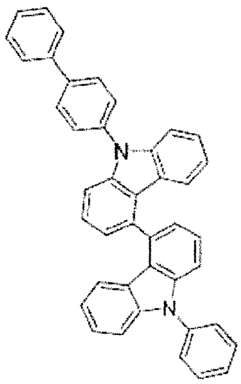

1-89

[C21]

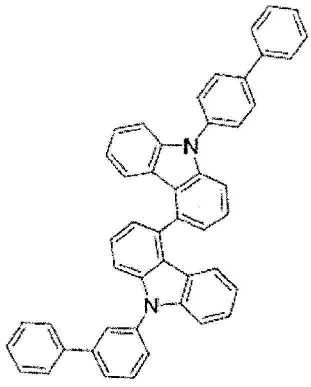
1-90

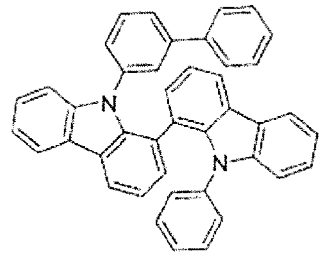
1-91

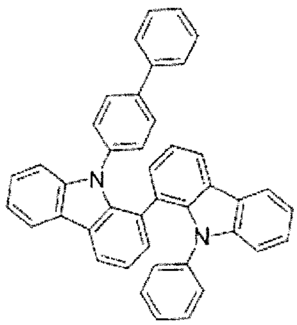
1-92

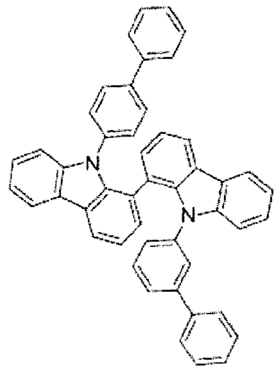
1-93

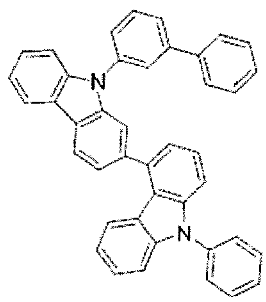
1-94

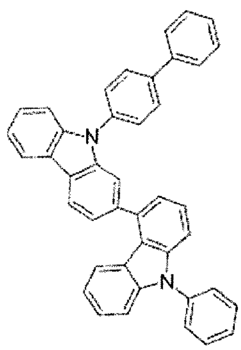
1-95

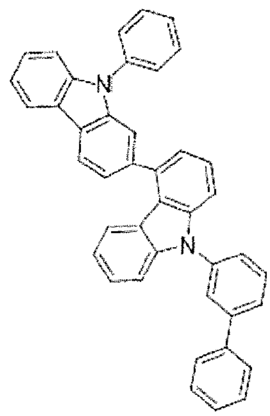
1-96

[C22]

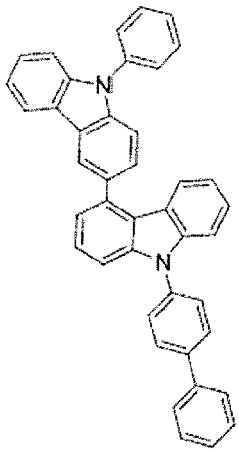
1-97

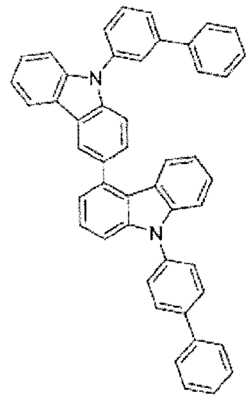
1-98

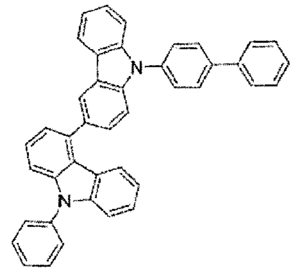
1-99

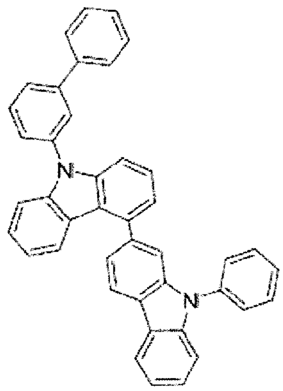
1-100

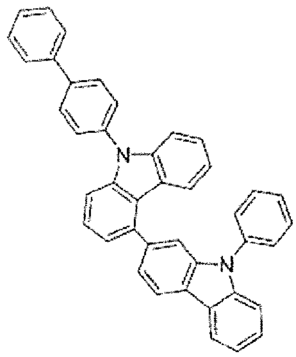
1-101

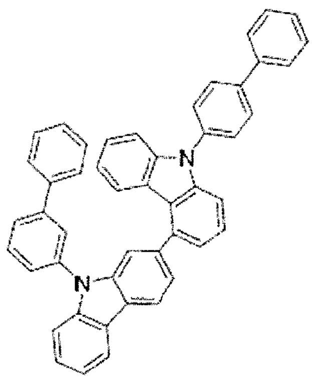
1-102

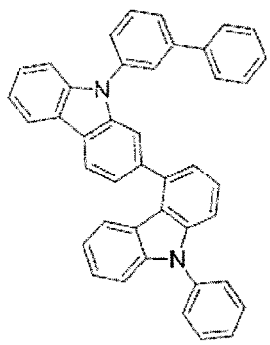
1-103

[C23]

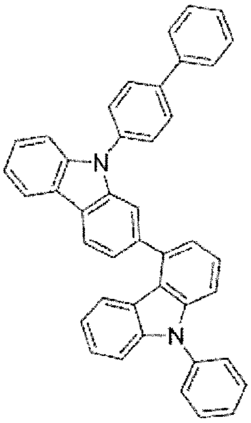

1-104

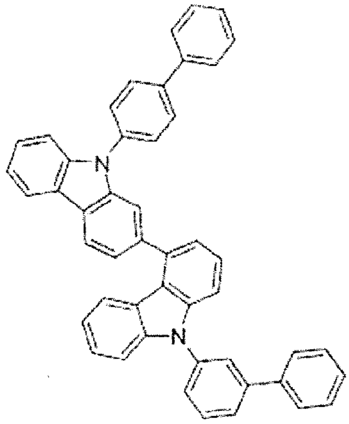

1-105

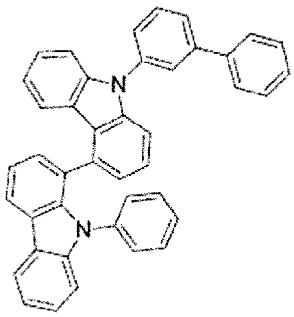

1-106

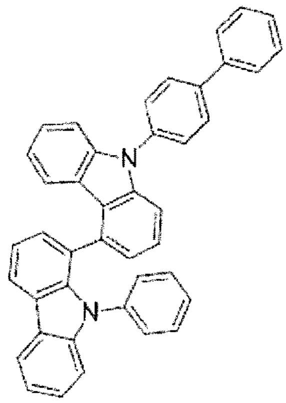

1-107

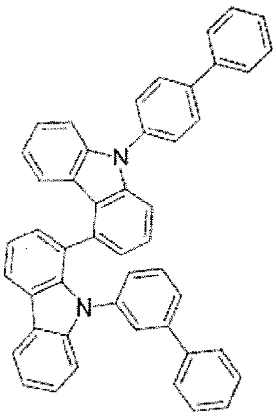

1-108

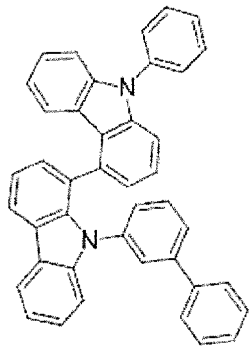

1-109

[C24]

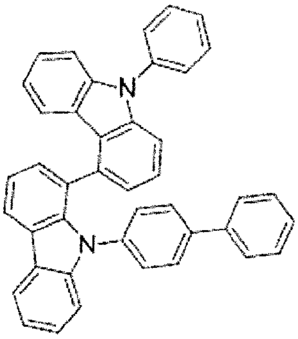

1-110

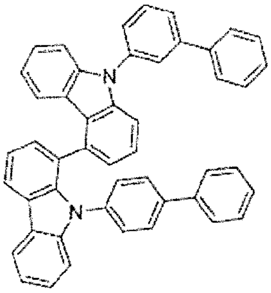

1-111

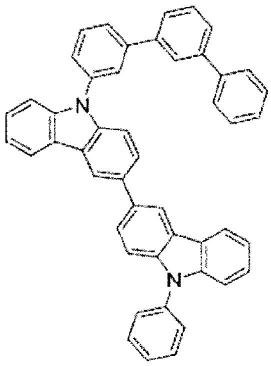

1-112

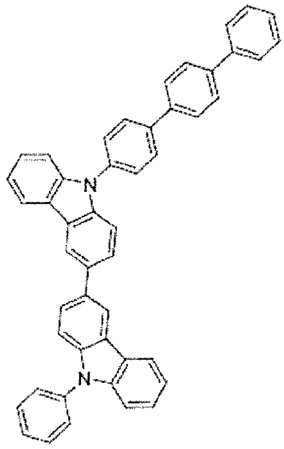

1-113

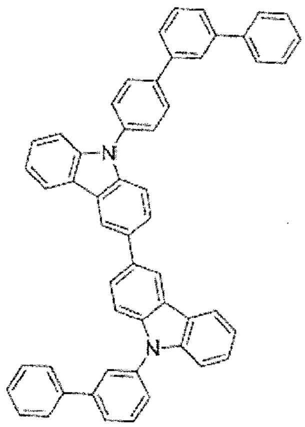

1-114

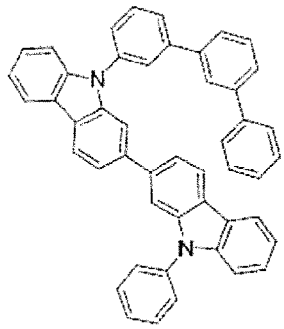

1-115

[C25]

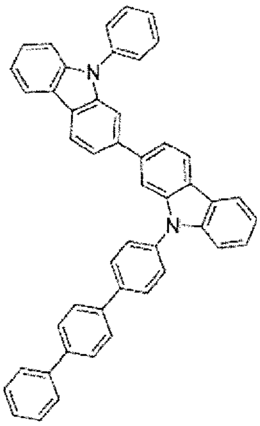

1-116

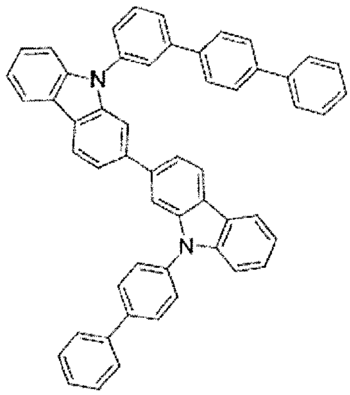

1-117

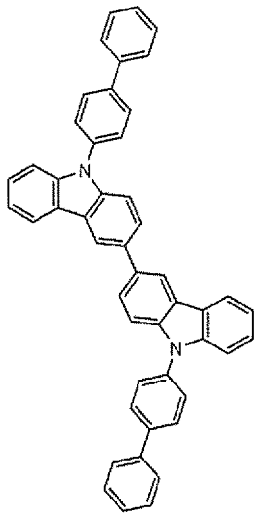

1-118

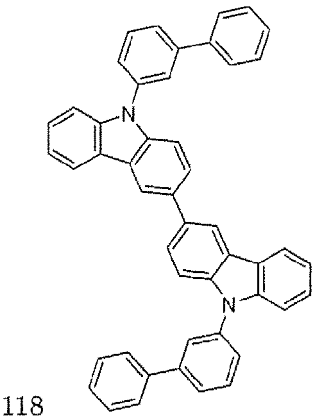

1-119

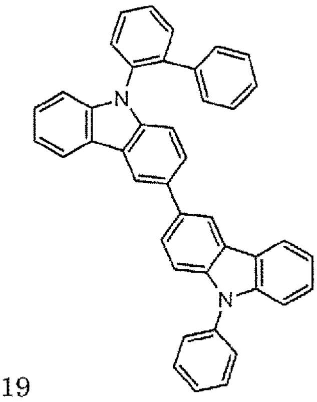

1-120

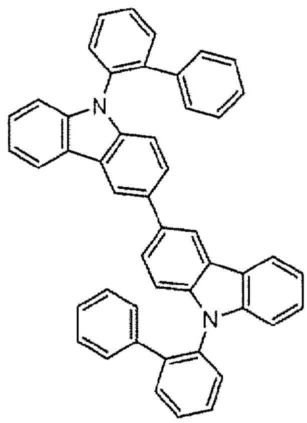

1-121

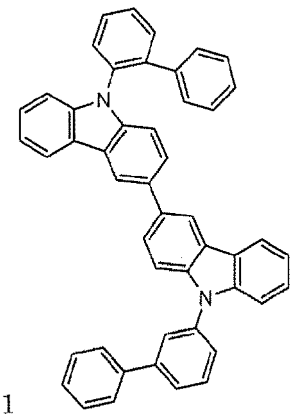

1-122

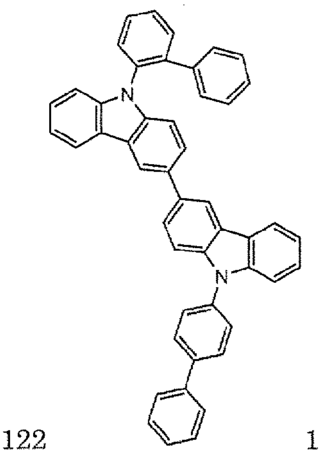

1-123

[C26]

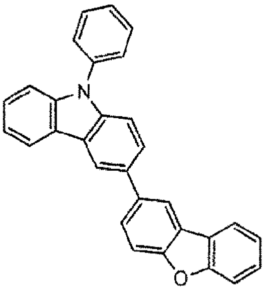 1-124 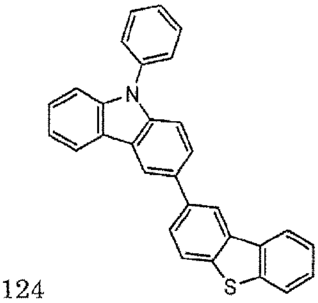 1-125 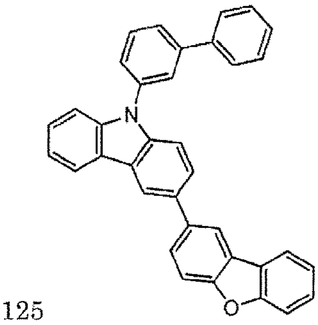 1-126

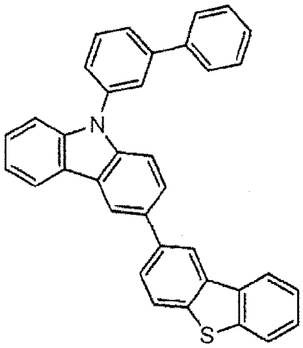 1-127 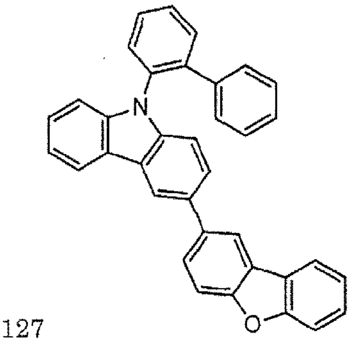 1-128

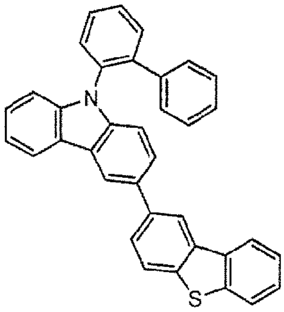 1-129 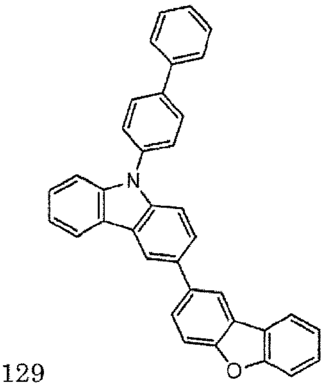 1-130 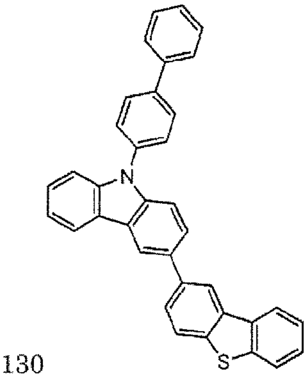 1-131

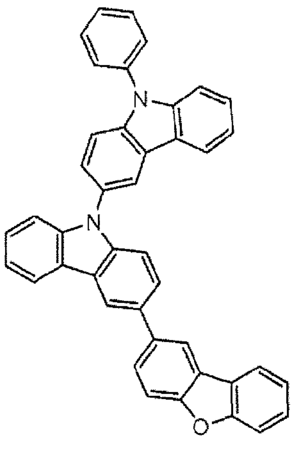 1-132 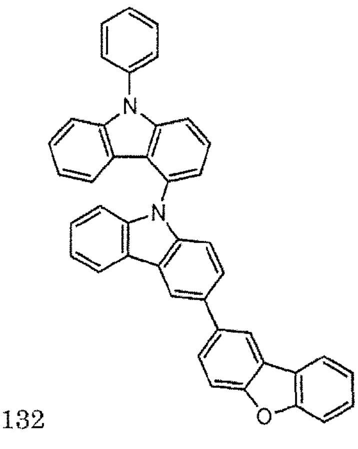 1-133

[C27]

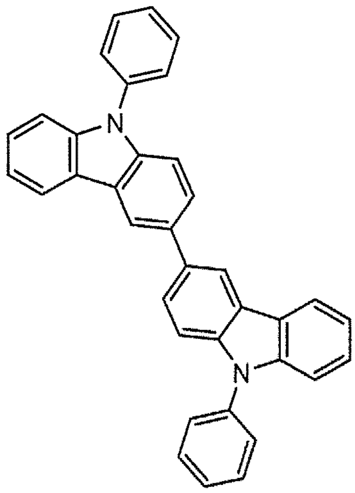

1-134

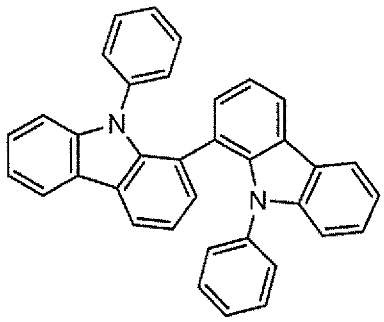

1-135

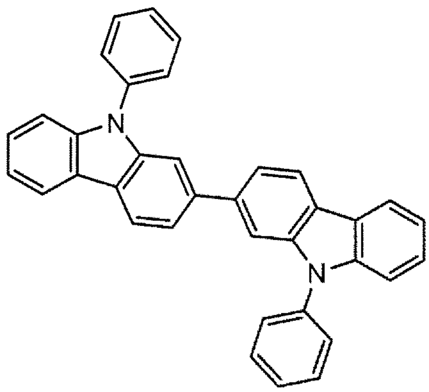

1-136

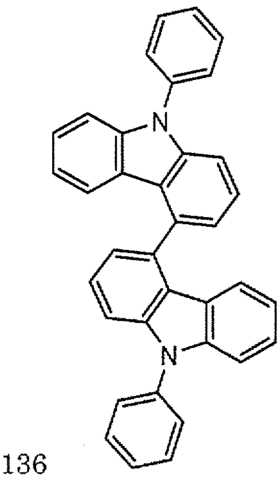

1-136

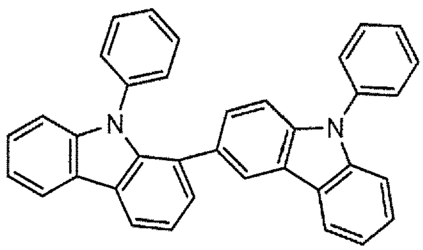

1-137

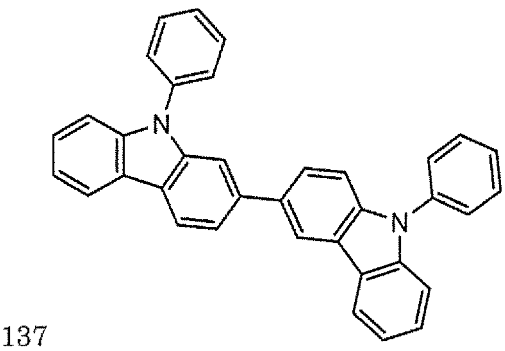

1-138

[C28]

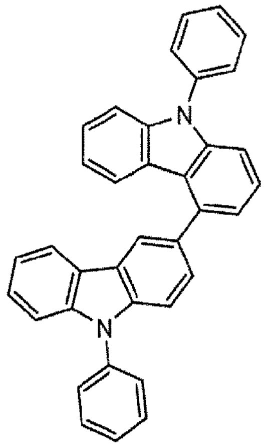

1-139

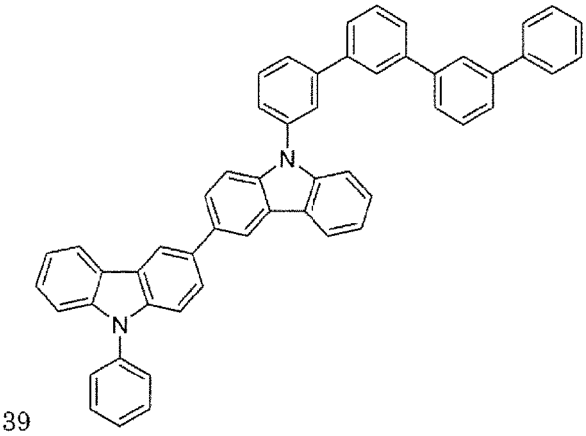

1-140

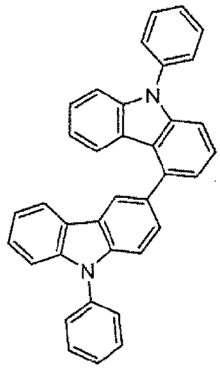

1-141

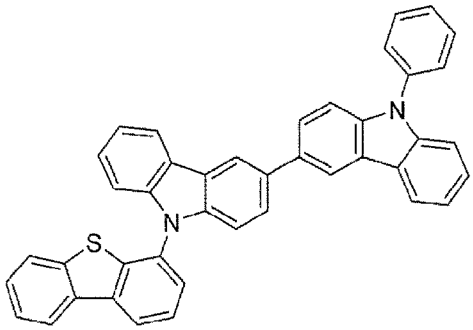

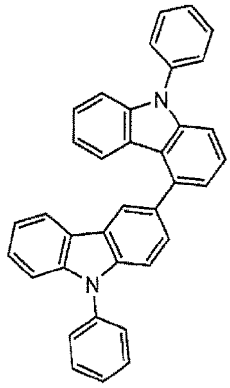

1-142

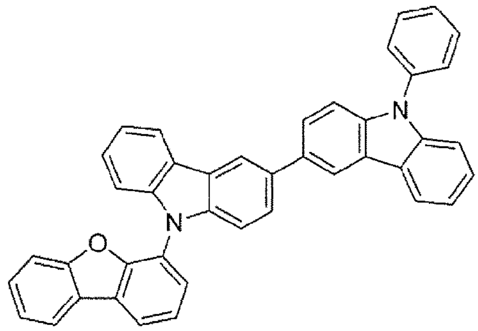

1-143

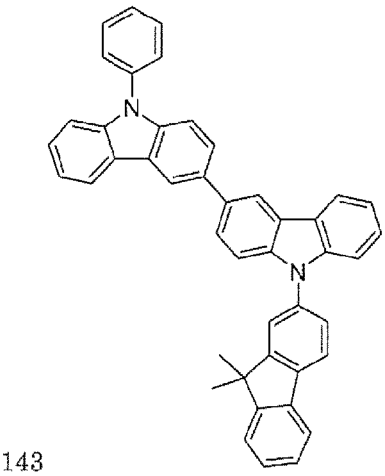

1-144

[C29]

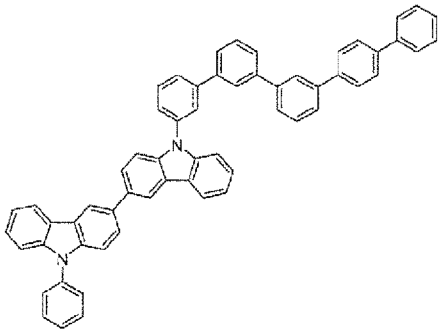

1-150

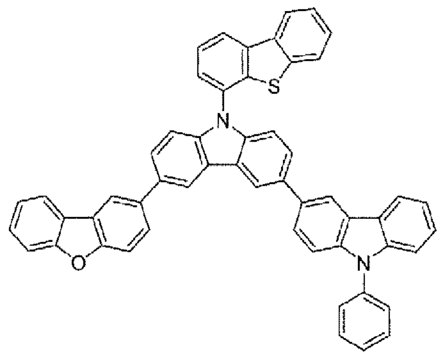

1-151

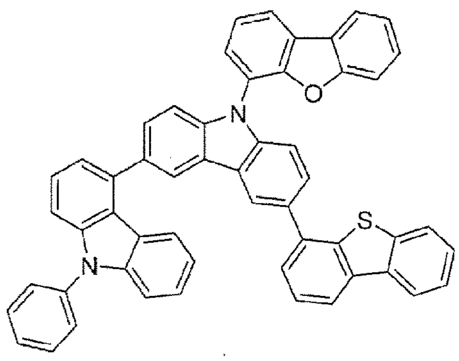

1-152

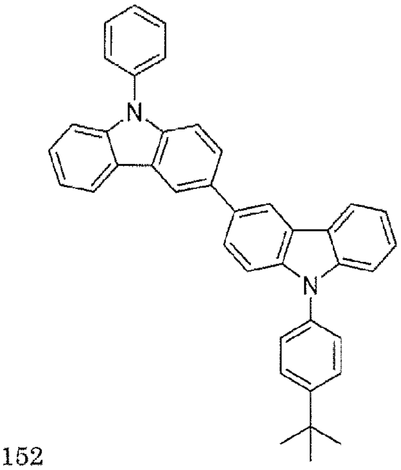

1-153

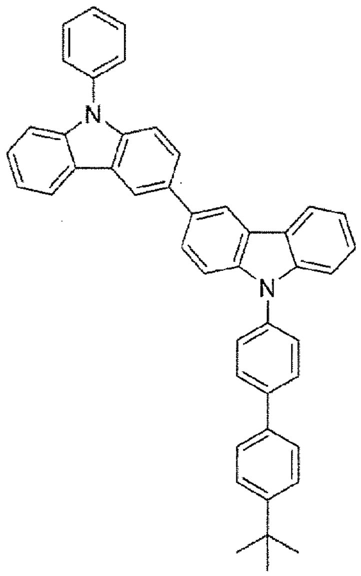

1-154

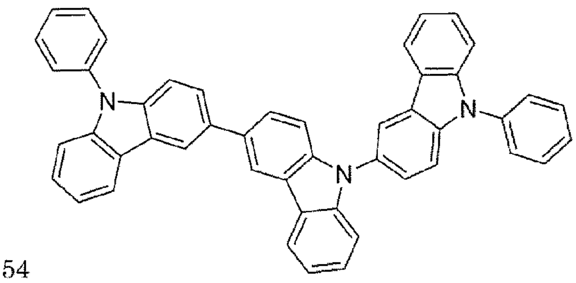

1-155

The compound represented by the general formula (2) will be described.

In the general formula (2), c is independently an integer of 0 to 5, d is independently an integer of 0 to 2 and at least one d is 1 or more. e is independently an integer of 0 to 2. Preferably, c is an integer of 1 to 2, the sum of two d is an integer of 1 to 4, and e is an integer of 0 to 1.

$R^2$ is independently a cyano group, an aliphatic hydrocarbon group having 1 to 10 carbon atoms, or a substituted or unsubstituted aromatic hydrocarbon group having 6 to 18 carbon atoms. $R^2$ is preferably an aliphatic hydrocarbon group having 1 to 8 carbon atoms, or a substituted or unsubstituted aromatic hydrocarbon group having 6 to 12 carbon atoms, and more preferably a substituted or unsubstituted aromatic hydrocarbon group having 6 to 10 carbon atoms.

When $R^2$ is an aliphatic hydrocarbon group having 1 to 10 carbon atoms, specific examples thereof are the same as the case where $R^1$ is an aliphatic hydrocarbon group having 1 to 10 carbon atoms in the general formula (1) .

When $R^2$ is an unsubstituted aromatic hydrocarbon group having 6 to 18 carbon atoms, specific examples

thereof are the same as the description for $Ar^1$ described above.

$L^2$ is a substituted or unsubstituted aromatic hydrocarbon group having 6 to 18 carbon atoms or a substituted or unsubstituted aromatic heterocyclic group having 3 to 17 carbon atoms. $L^2$ is preferably a substituted or unsubstituted aromatic hydrocarbon group having 6 to 12 carbon atoms or a substituted or unsubstituted aromatic heterocyclic group having 3 to 15 carbon atoms. $L^2$ is more preferably a substituted or unsubstituted aromatic hydrocarbon group having 6 to 10 carbon atoms or a substituted or unsubstituted aromatic heterocyclic group having 3 to 12 carbon atoms.

When $L^2$ is an unsubstituted aromatic hydrocarbon group having 6 to 18 carbon atoms or an unsubstituted aromatic heterocyclic group having 3 to 17 carbon atoms, specific examples thereof are the same as the case where $Ar^1$ is an unsubstituted aromatic hydrocarbon group having 6 to 18 carbon atoms or an unsubstituted aromatic heterocyclic group having 3 to 17 carbon atoms in the general formula (1). The valence may differ from those in $Ar^1$. $L^2$ is recognized to be a 2d + 1 valent group.

$Ar^2$ independently represents hydrogen, deuterium, an aliphatic hydrocarbon group having 1 to 10 carbon atoms, a substituted or unsubstituted aromatic hydrocarbon group having 6 to 18 carbon atoms, a substituted or unsubstituted aromatic heterocyclic group having 3 to 17 carbon atoms, or a linked aromatic group formed by linking 2 to 3 groups thereof. $Ar^2$ is preferably an aliphatic hydrocarbon group having 1 to 8 carbon atoms, a substituted or unsubstituted aromatic hydrocarbon group having 6 to 12 carbon atoms, a substituted or unsubstituted aromatic heterocyclic group having 3 to 15 carbon atoms, or a linked aromatic group in which 2 to 3 of these aromatic rings are linked to each other. $Ar^2$ is more preferably a substituted or unsubstituted aromatic hydrocarbon group having 6 to 10 carbon atoms, a substituted or unsubstituted aromatic heterocyclic group having 3 to 12 carbon atoms, or a linked aromatic group in which 2 to 3 of these aromatic rings are linked to each other.

It is preferred that $Ar^2$, $L^2$, and $R^2$ be not a group produced from pyridine, pyrimidine, or triazine.

When $Ar^2$ is an aliphatic hydrocarbon group having 1 to 10 carbon atoms, specific examples thereof are the same as the case where $R^1$ in the general formula (1) is an aliphatic hydrocarbon group having 1 to 10 carbon atoms. When $Ar^2$ is a substituted or unsubstituted aromatic hydrocarbon group having 6 to 18 carbon atoms or a substituted or unsubstituted aromatic heterocyclic group having 3 to 17 carbon atoms, specific examples thereof are the same as the case where $Ar^1$ in the general formula (1) is a substituted or unsubstituted aromatic hydrocarbon group having 6 to 18 carbon atoms or a substituted or unsubstituted aromatic heterocyclic group having 3 to 17 carbon atoms.

Examples of a preferred mode of the general formula (2) include the formula (8).

In the formula (8), n is an integer of 1 to 5, and p is an integer of 0 to 1. Preferably, n is an integer of 1 to 2, and p is 0.

$L^8$ represents a group produced from benzene, dibenzofuran, or dibenzothiophene. $R^{81}$ represents hydrogen or a group produced from benzene, dibenzofuran, or dibenzothiophene.

Specific examples of the compounds represented by the general formula (2) are shown below, but the compounds are not limited to these exemplified compounds.

[C30]

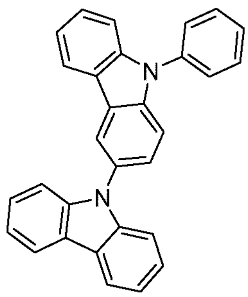

2-1

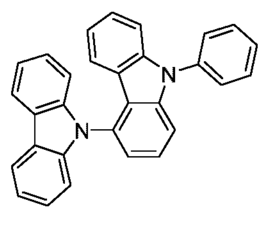

2-2

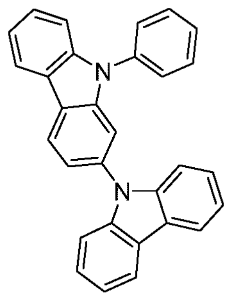

2-3

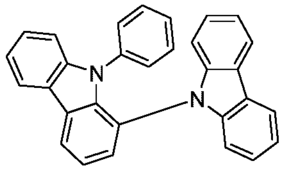

2-4

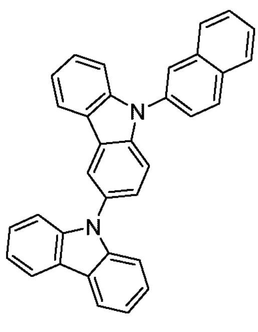

2-5

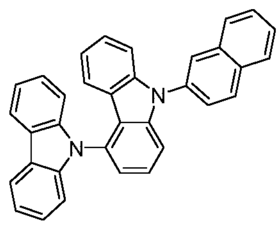

2-6

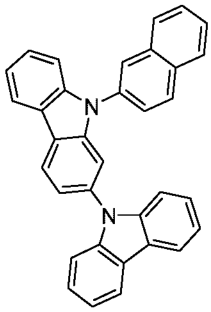 2-7 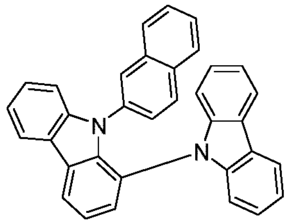 2-8 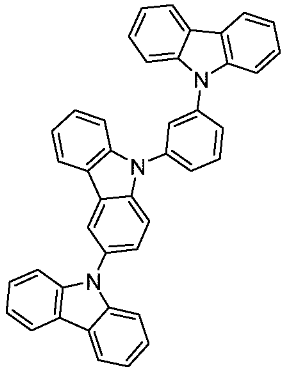 2-9

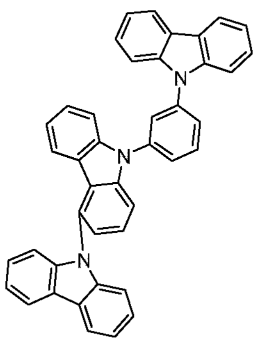 2-10 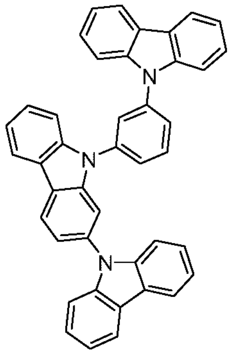 2-11 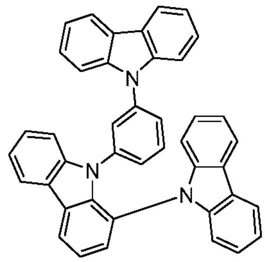 2-12

[C31]

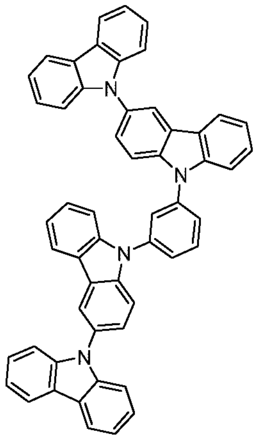 2-13 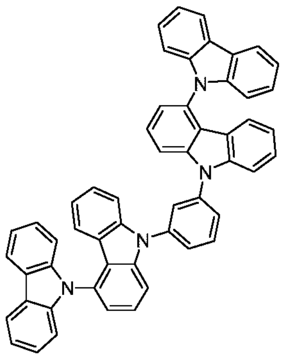 2-14 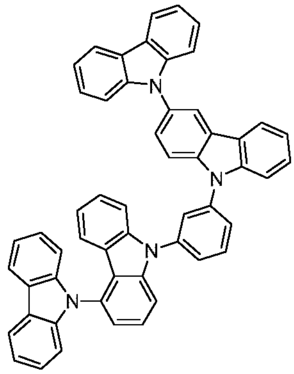 2-15

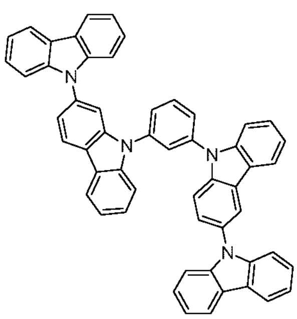 2-16 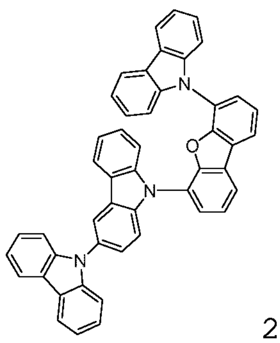 2-17 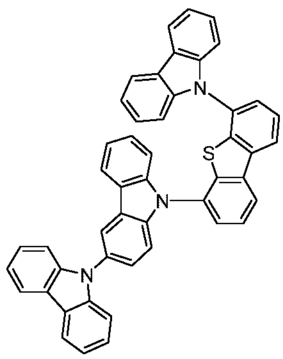 2-18

[C32]

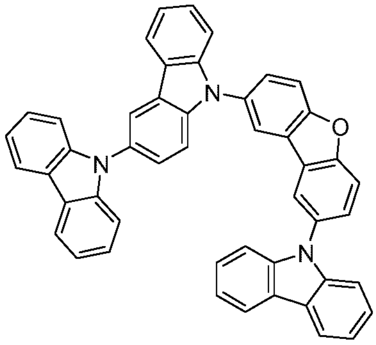
2-19

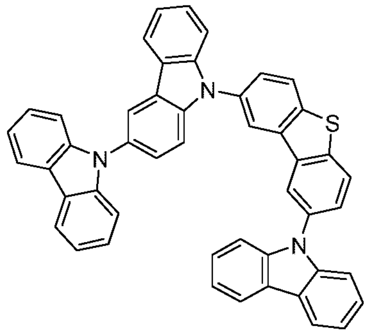
2-20

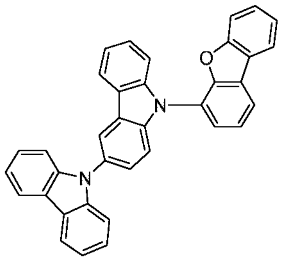
2-21

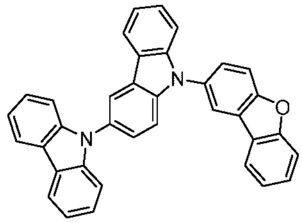
2-22

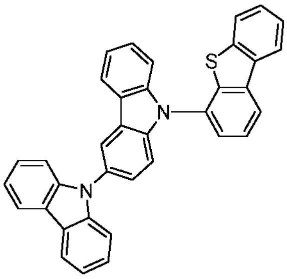
2-23

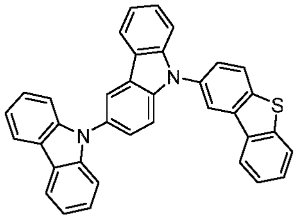
2-24

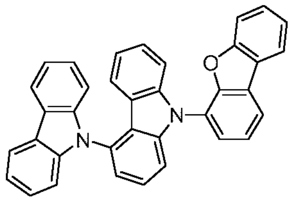
2-25

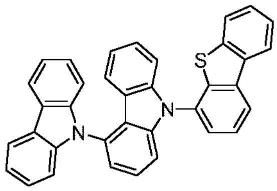
2-26

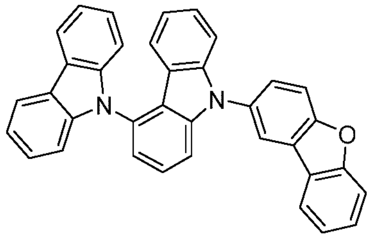
2-27

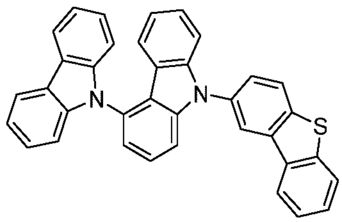
2-28

[C33]

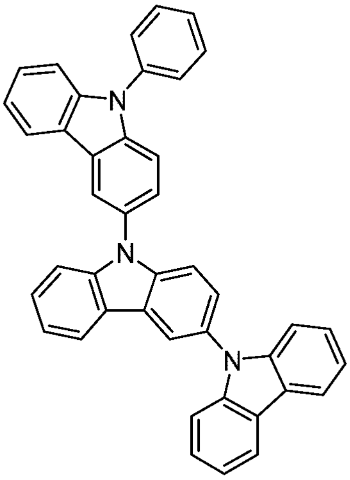
2-29

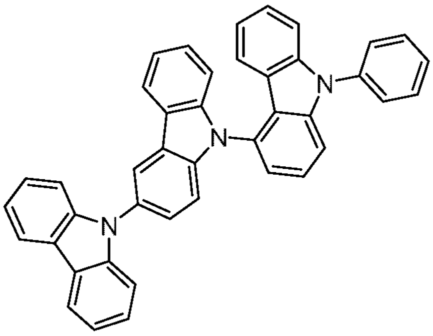
2-30

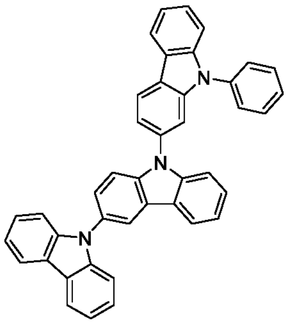
2-31

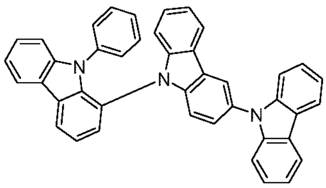
2-32

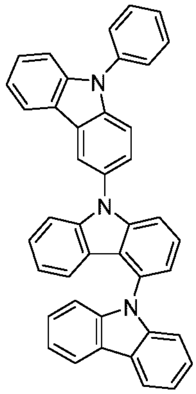
2-33

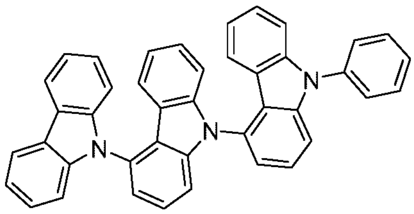
2-34

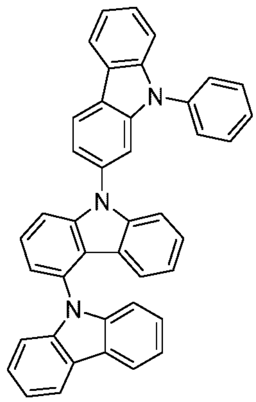
2-35

[C34]

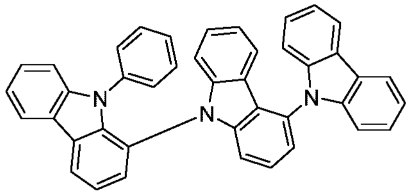

2-36

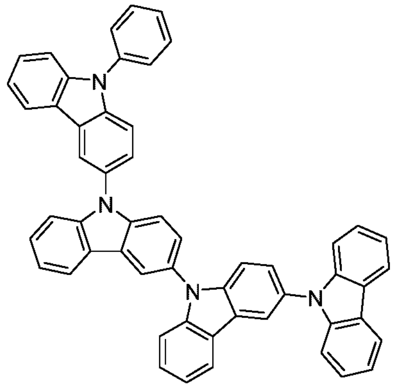

2-37

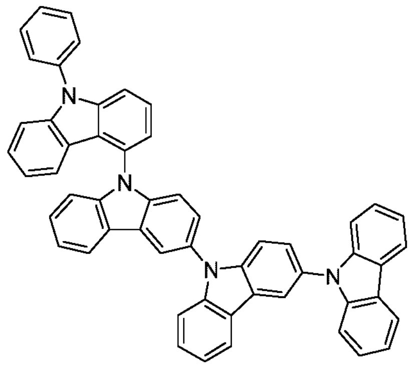

2-38

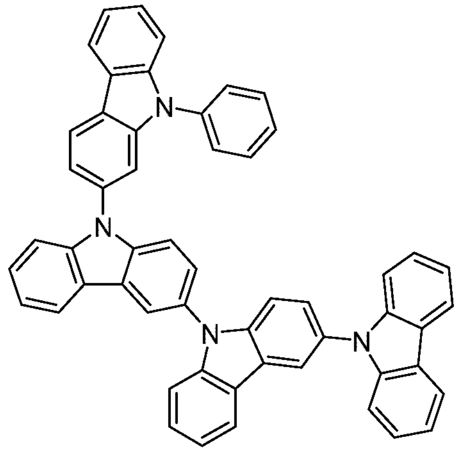

2-39

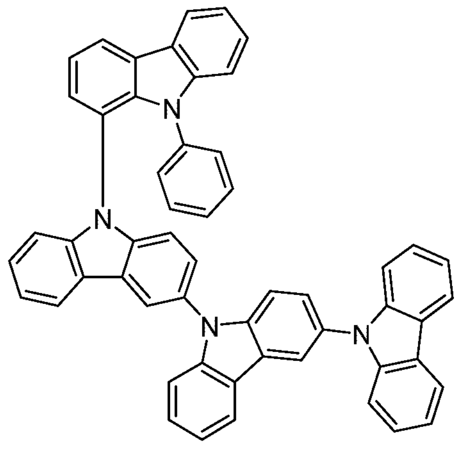

2-40

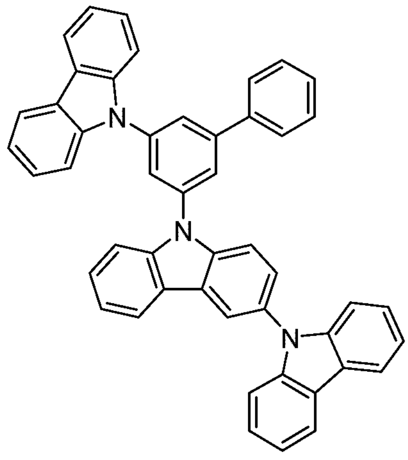

2-41

[C35]

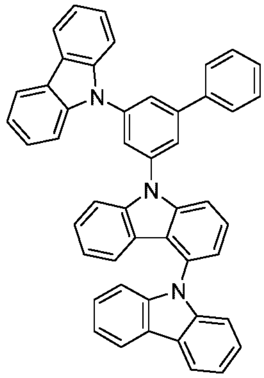
2-42

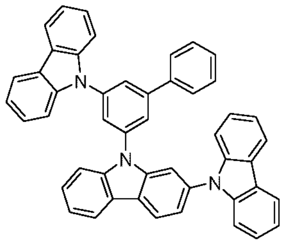
2-43

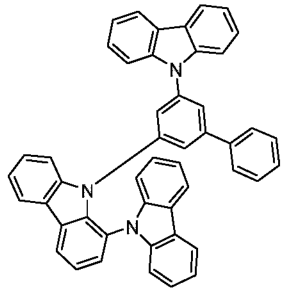
2-44

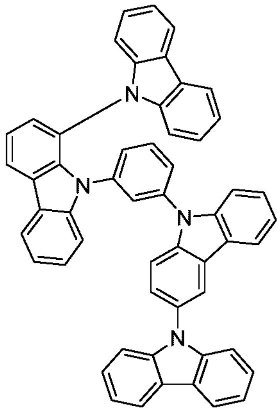
2-45

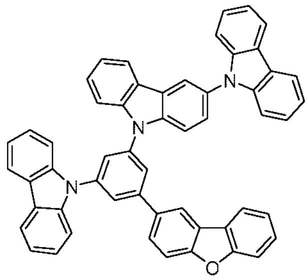
2-46

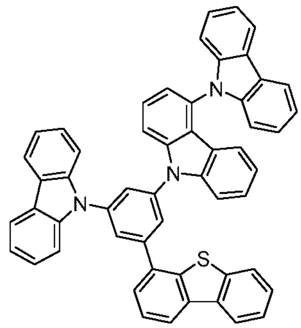
2-47

[C36]

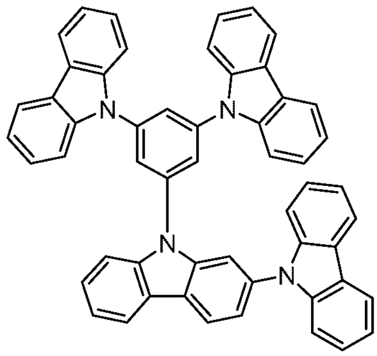
2-48

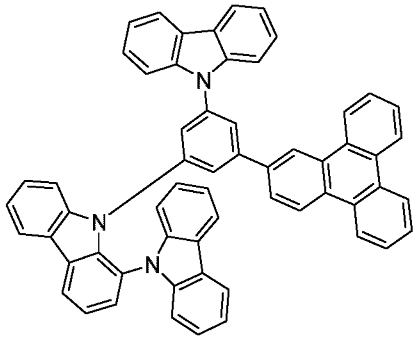
2-49

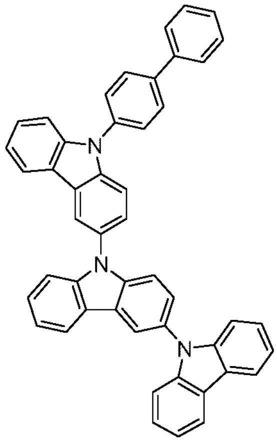

2-50

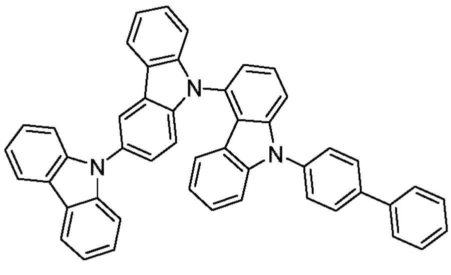

2-51

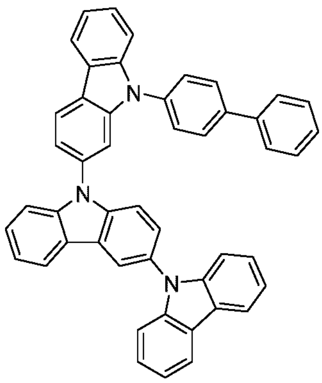

2-52

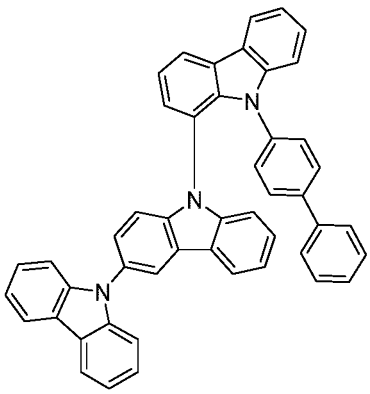

2-53

[C37]

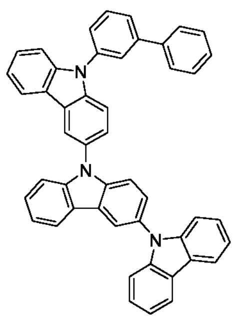

2-54

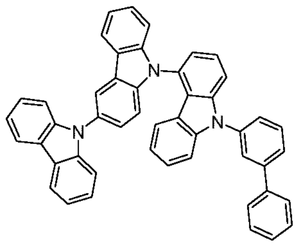

2-55

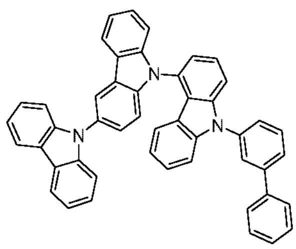

2-56

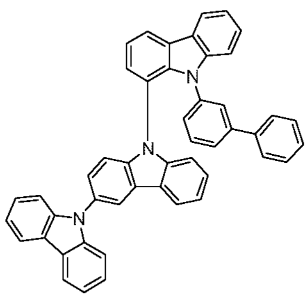

2-57

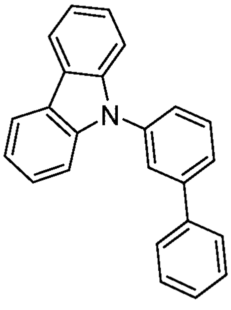
2-58

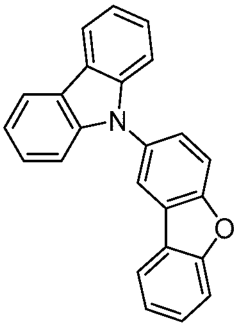
2-59

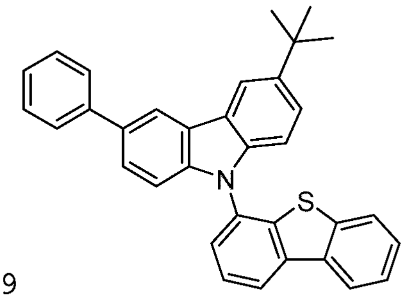
2-60

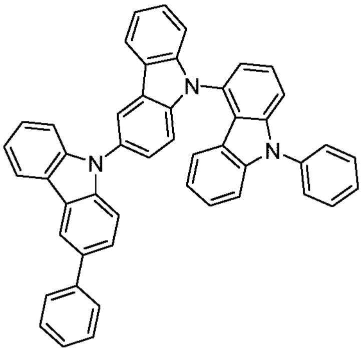
2-61

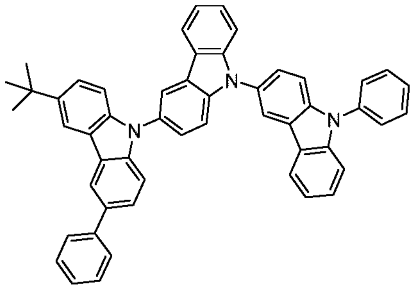
2-62

The compound represented by the general formula (3) will be described.

In the general formula (3), $Z^3$ is an indolocarbazole ring-containing group represented by the formula (3a), and * is a bonding site to $L^3$. The ring A is a heterocyclic ring represented by the formula (3b), and this heterocyclic ring is fused with an adjacent ring at an arbitrary position.

f represents an integer of 1 to 3, and is preferably 1. g represents an integer of 0 to 3, and j represents an integer of 0 to 3. Preferably, g is an integer of 0 to 2, and j is an integer of 0 to 2.

Preferred examples of the general formula (3) include the following formula (9) and formula (10).

[C38]

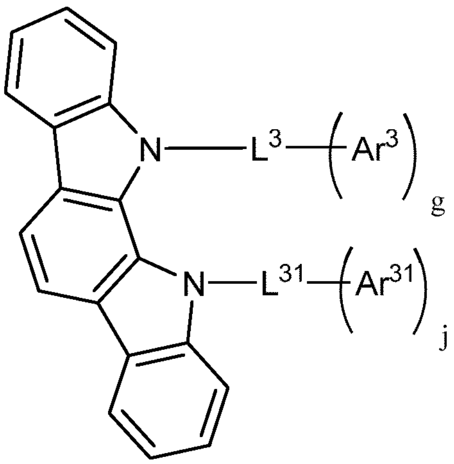

(9)

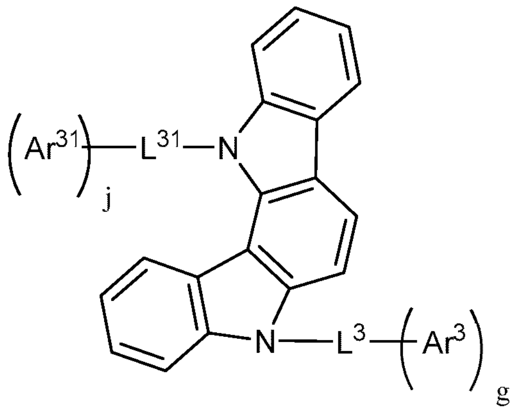

(10)

In the general formula (3), the formula (9), and the formula (10), common symbols have the same meaning.

Each of $L^3$ and $L^{31}$ independently represents a substituted or unsubstituted aromatic hydrocarbon group having 6 to 30 carbon atoms or a substituted or unsubstituted aromatic heterocyclic group having 3 to 17 carbon atoms. Each of $L^3$ and $L^{31}$ preferably represents an aromatic hydrocarbon group having 6 to 20 carbon atoms or an aromatic heterocyclic group having 3 to 15 carbon atoms. Each of $L^3$ and $L^{31}$ is more preferably a group produced from benzene, naphthalene, pyridine, triazine, dibenzofuran, or carbazole.

Each of $Ar^3$ and $Ar^{31}$ is independently a substituted or unsubstituted aromatic hydrocarbon group having 6 to 30 carbon atoms, a substituted or unsubstituted aromatic heterocyclic group having 3 to 17 carbon atoms, or a linked aromatic group in which 2 to 8 of these aromatic rings are linked to each other. Each of $Ar^3$ and $Ar^{31}$ is preferably a substituted or unsubstituted an aromatic hydrocarbon group having 6 to 20 carbon atoms, a substituted or unsubstituted aromatic heterocyclic group having 3 to 17 carbon atoms, or a substituted or unsubstituted linked aromatic group formed by linking 2 to 4 aromatic rings thereof, and more preferably a substituted or unsubstituted aromatic hydrocarbon group having 6 to 18 carbon atoms, a substituted or unsubstituted aromatic heterocyclic group having 3 to 12 carbon atoms, or a linked aromatic group in which 2 to 3 of these aromatic rings are linked to each other.

$Ar^3$ and $Ar^{31}$ are preferably a phenyl group, a biphenyl group, or a terphenyl group. The terphenyl group may be linked in a linear or branched form. A linked aromatic group in which benzene, carbazole, and 2 to 3 aromatic rings thereof are linked is also preferred.

When $L^3$ and $L^{31}$ or $Ar^3$ and $Ar^{31}$ are an unsubstituted aromatic hydrocarbon group having 6 to 30 carbon atoms or aromatic heterocyclic group having 3 to 17 carbon atoms, specific examples thereof include a group produced from benzene, naphthalene, acenaphthene, acenaphthylene, azulene, anthracene, chrysene, pyrene, phenanthrene, triphenylene, fluorene, benzo[a]anthracene, tetracene, pentacene, hexacene, coronene, heptacene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, or carbazole.

However, $L^3$ and $L^{31}$ are a g + f valent group or a j + 1 valent group.

$Ar^3$ and $Ar^{31}$ may be a linked aromatic group, and examples of the linked aromatic group are the same as the case where $Ar^1$ is a linked aromatic group in the general formula (1), except that the aromatic hydrocarbon group that forms the linked aromatic group has 6 to 30 carbon atoms.

When $Ar^3$ and $Ar^{31}$ have a substituent, examples of the substituent are the same as the case where $Ar^1$ has a substituent in the general formula (1).

Each $R^3$ independently represents an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. Each $R^3$ is preferably an aliphatic hydrocarbon group having 1 to 8 carbon atoms, a substituted or unsubstituted aromatic hydrocarbon group having 6 to 12 carbon atoms, or a substituted or unsubstituted aromatic heterocyclic group having 3 to 15 carbon atoms. Each $R^3$ is more preferably a substituted or unsubstituted aromatic hydrocarbon group having 6 to 10 carbon atoms or a substituted or unsubstituted aromatic heterocyclic group having 3 to 12 carbon atoms.

h independently represents an integer of 0 to 4, and i represents an integer of 0 to 2. Preferably, h is an integer of 0 to 1, and i is an integer of 0 to 1.

When $R^3$ is an aliphatic hydrocarbon group having 1 to 10 carbon atoms, specific examples thereof are the same as the case of $R^1$, and when $R^3$ is a substituted or unsubstituted aromatic hydrocarbon group having 6 to 18 carbon atoms or a substituted or unsubstituted aromatic heterocyclic group having 3 to 17 carbon atoms, specific examples thereof are the same as the case where $Ar^1$ is a substituted or unsubstituted aromatic hydrocarbon group having 6 to 18 carbon atoms or a substituted or unsubstituted aromatic heterocyclic group having 3 to 17 carbon atoms in the general formula (1).

Specific examples of the compounds represented by the general formula (3) are shown below, but the compounds are not limited to these exemplified compounds.

[C39]

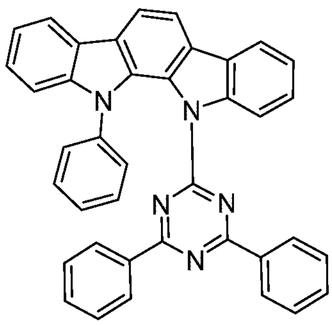
3-1

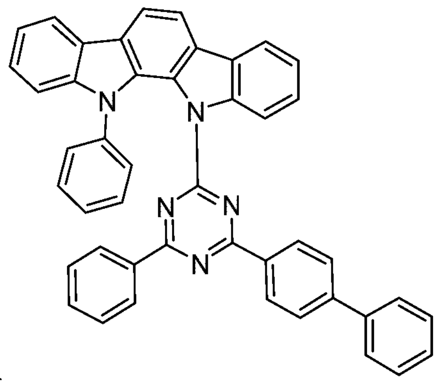
3-2

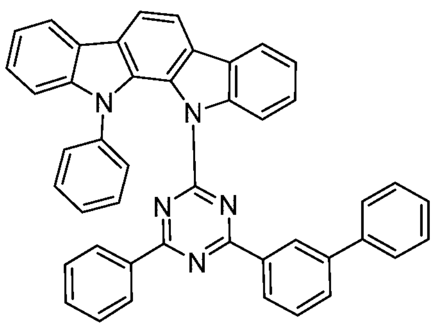
3-3

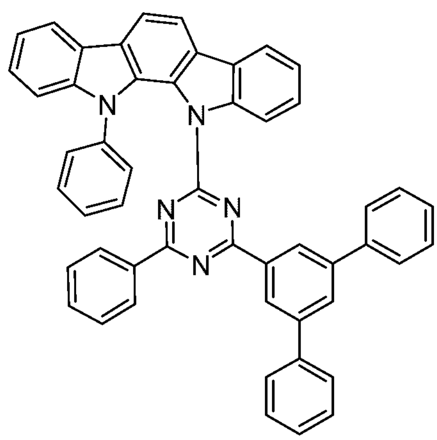
3-4

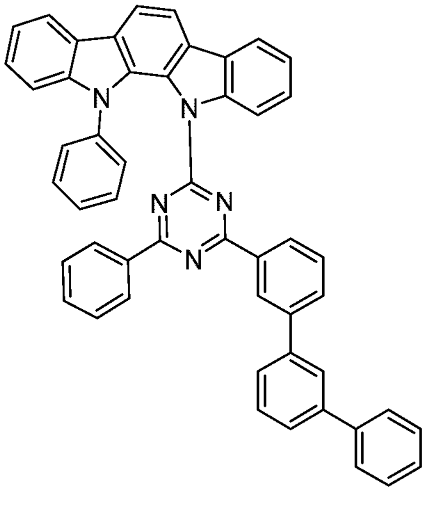
3-5

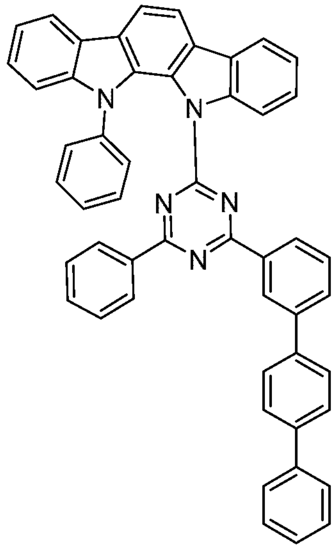
3-6

[C40]

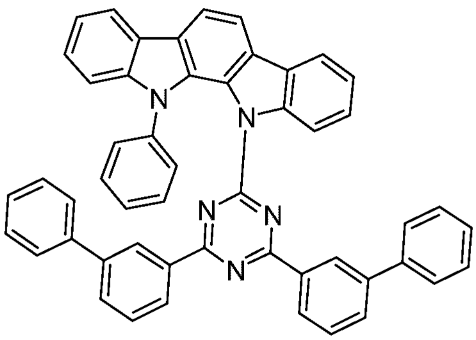
3-7

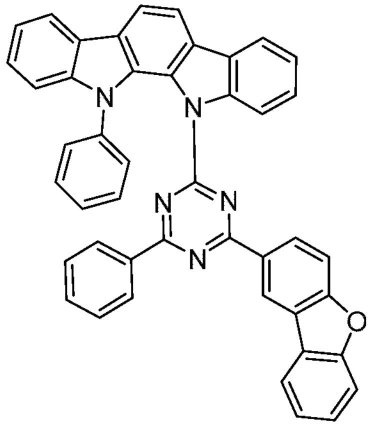
3-8

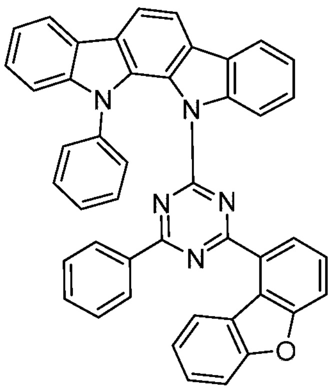
3-9

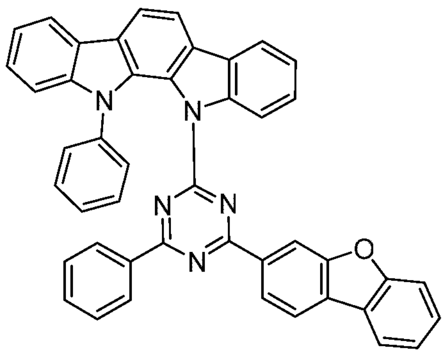
3-10

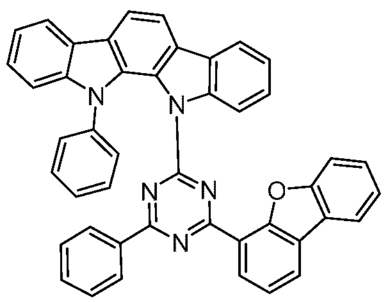
3-11

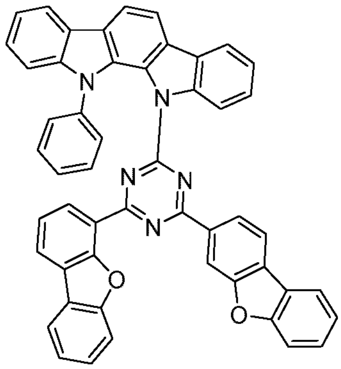
3-12

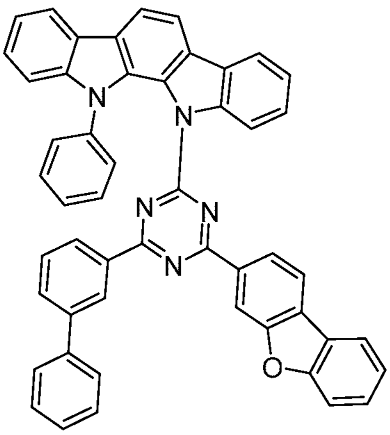
3-13

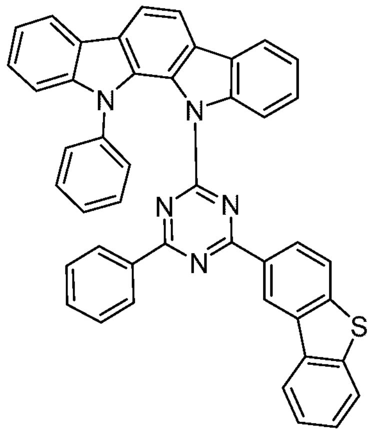
3-14

[C41]

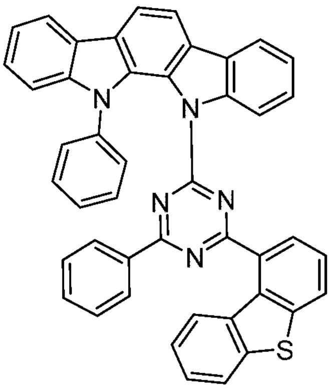
3-15

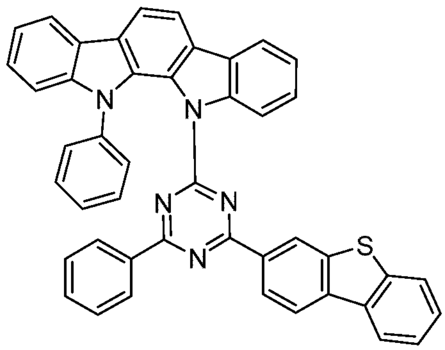
3-16

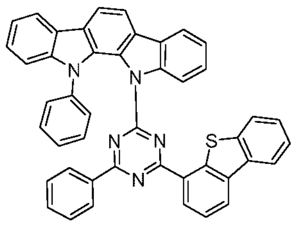
3-17

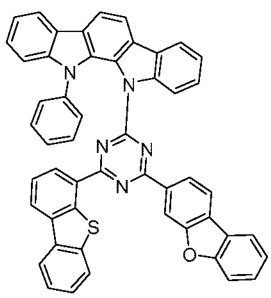
3-18

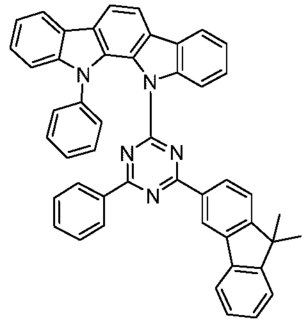
3-19

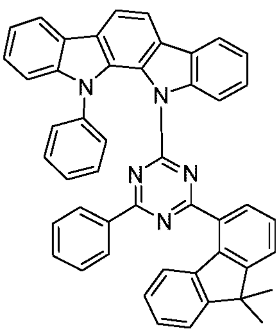
3-20

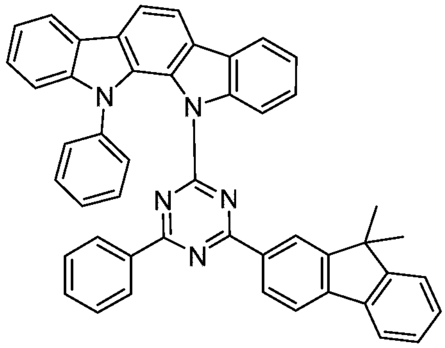
3-21

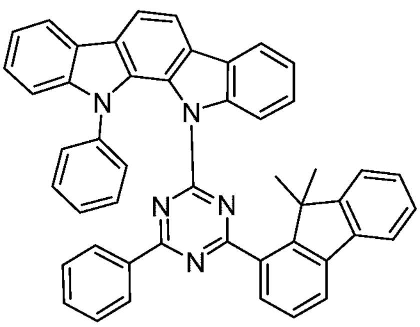
3-22

[C42]

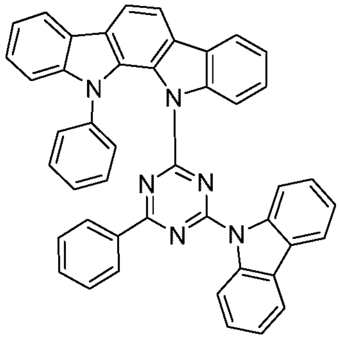
3-23

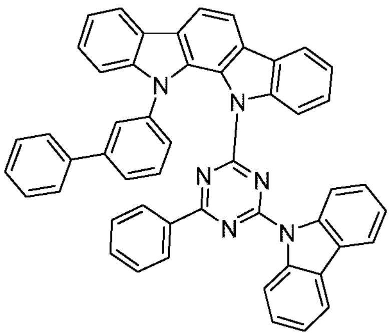
3-24

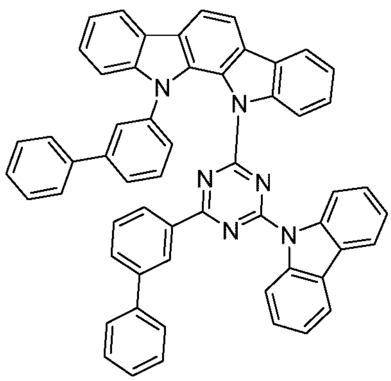
3-25

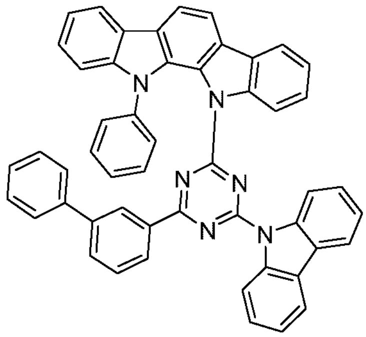
3-26

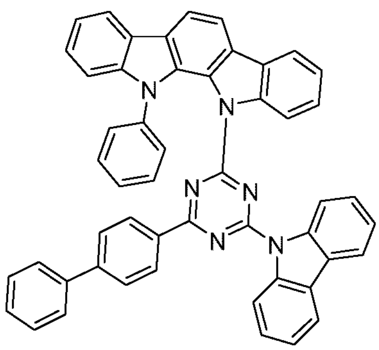
3-27

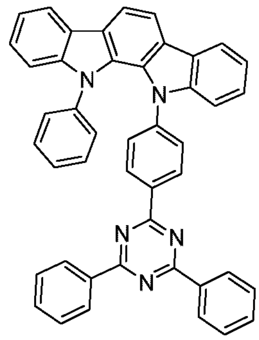
3-28

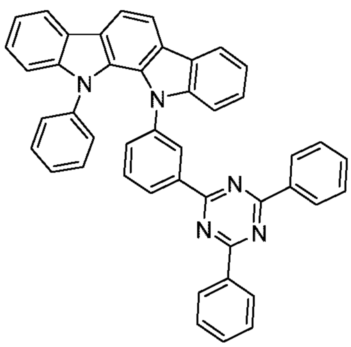
3-29

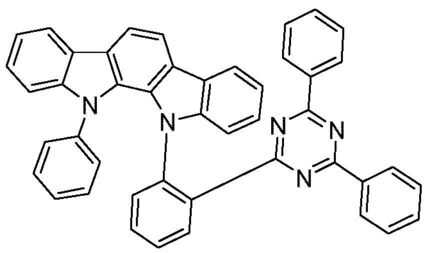
3-30

[C43]

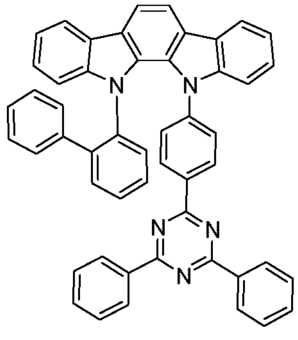

3-31

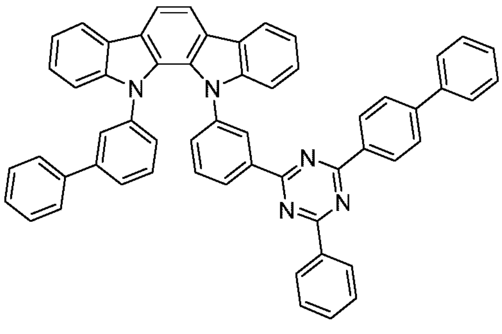

3-32

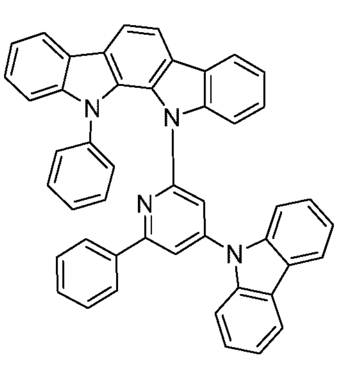

3-33

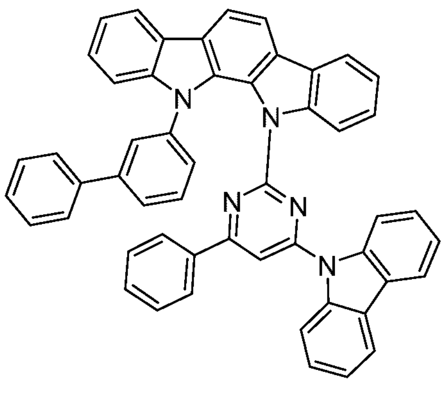

3-34

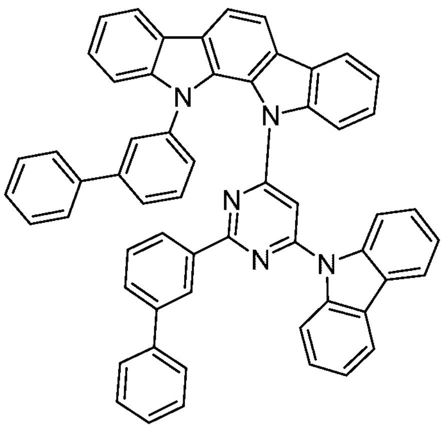

3-35

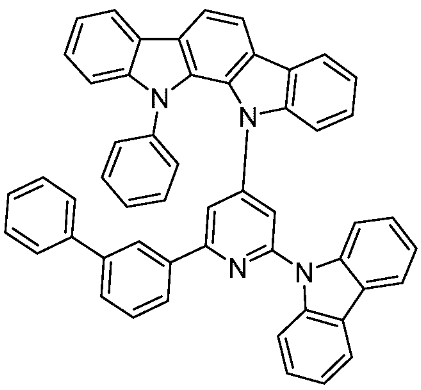

3-36

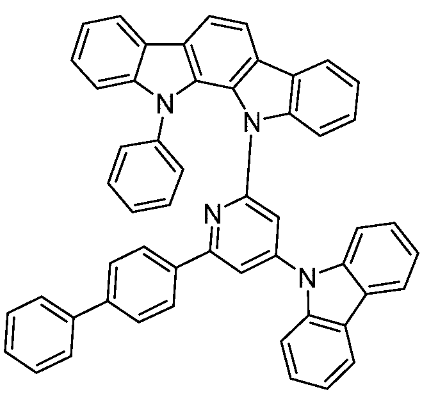

3-37

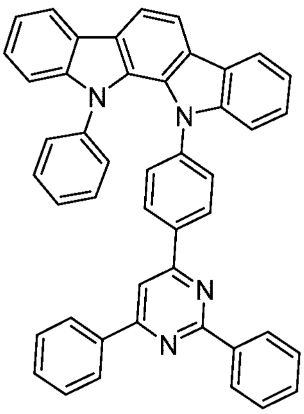

3-38

[C44]

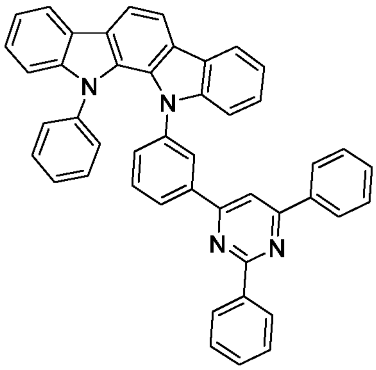

3-39

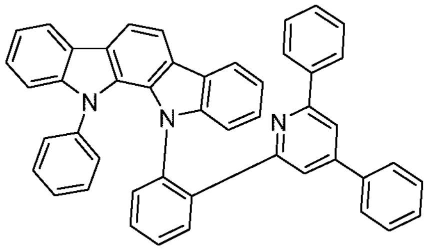

3-40

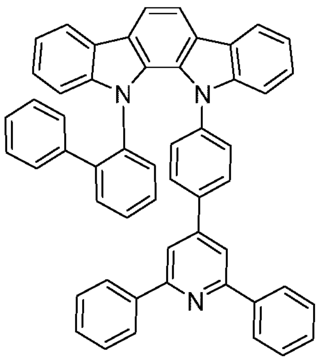

3-41

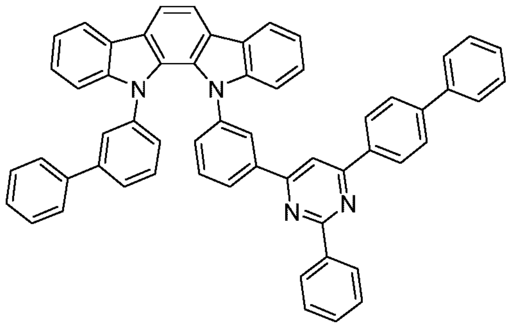

3-42

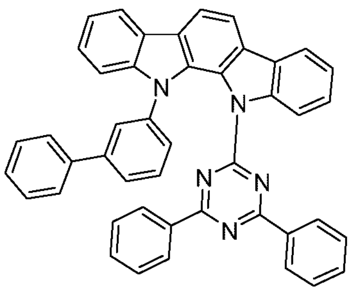

3-43

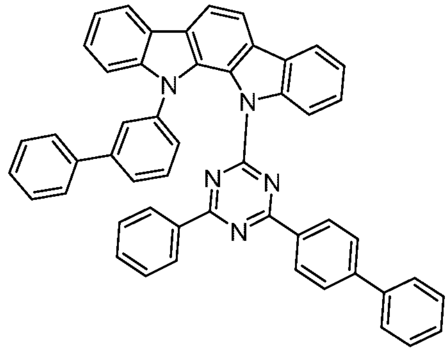

3-44

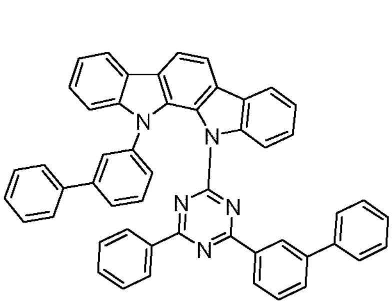

3-45

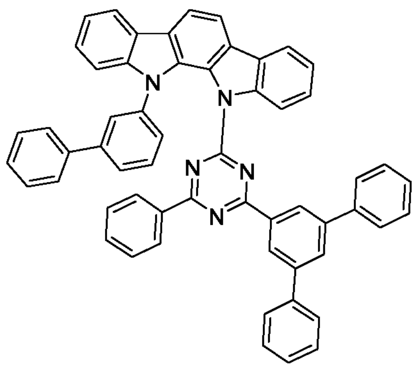

3-46

[C45]

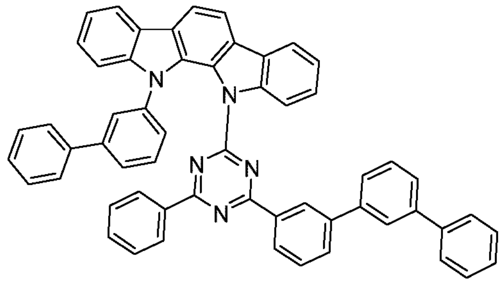

3-47

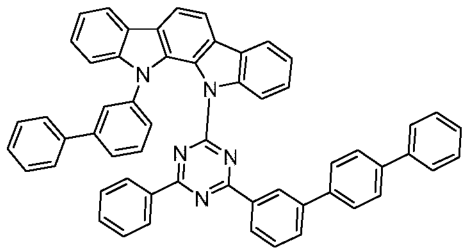

3-48

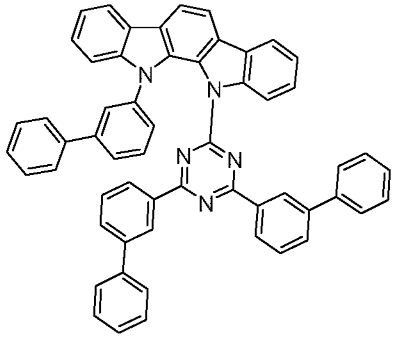

3-49

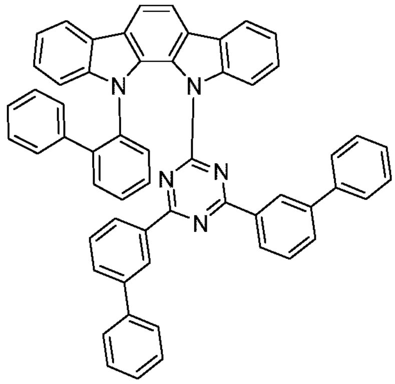

3-50

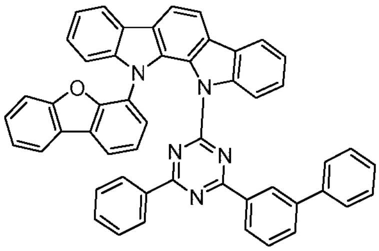

3-51

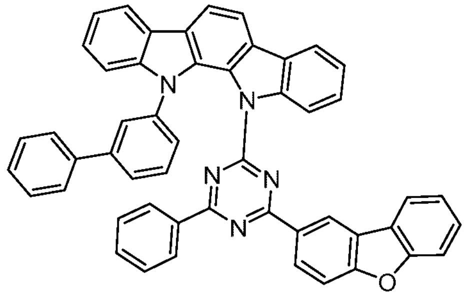

3-52

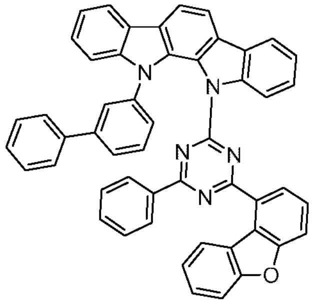

3-53

[C46]

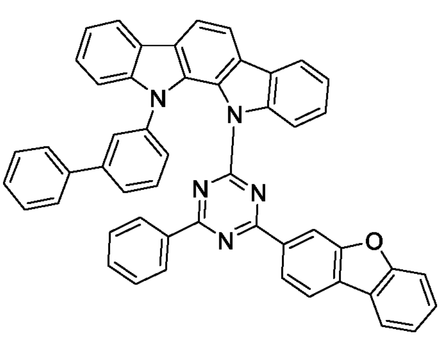

3-54

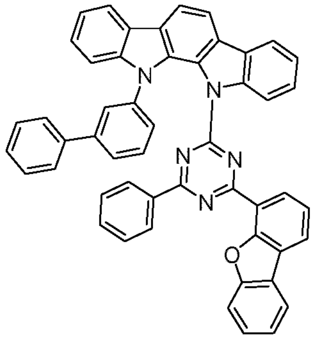

3-55

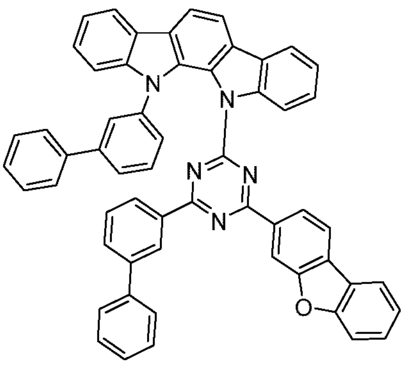

3-56

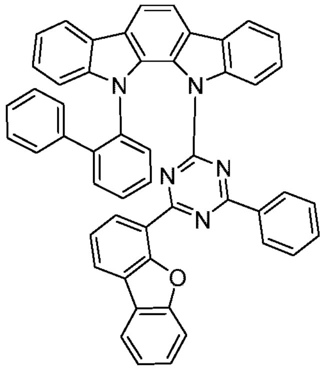

3-57

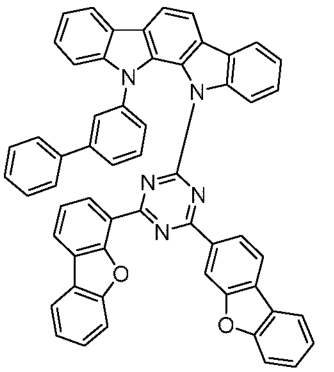

3-58

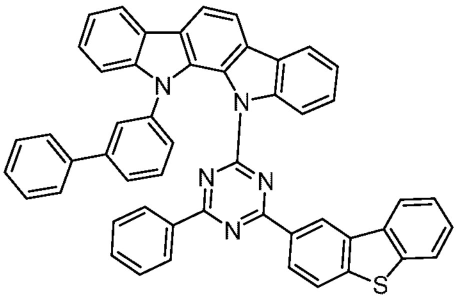

3-59

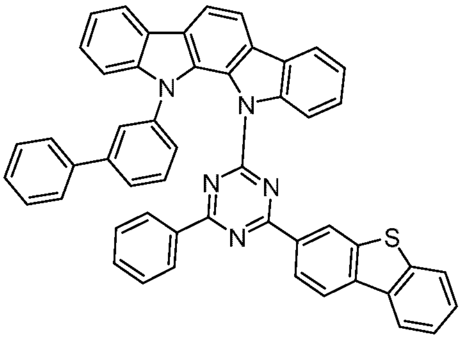

3-60

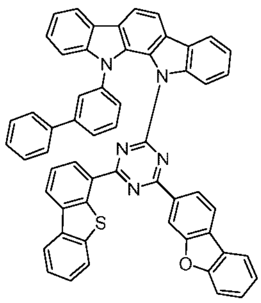

3-61

[C47]

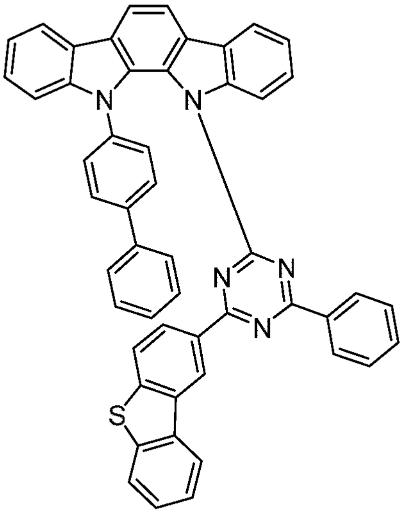
3-62

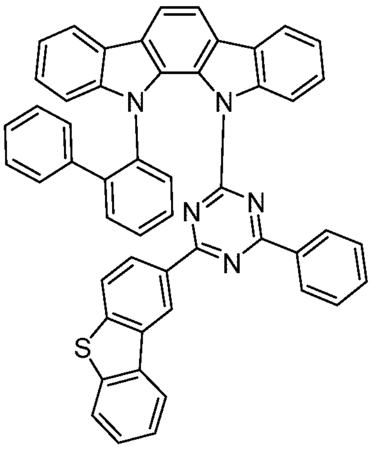
3-63

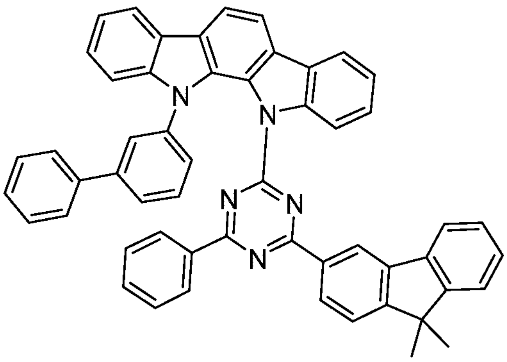
3-64

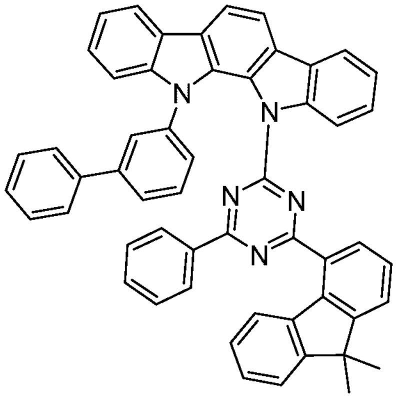
3-65

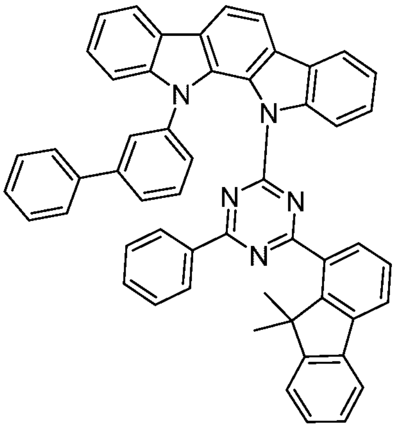
3-66

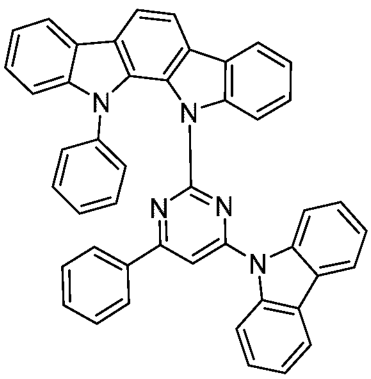
3-67

[C48]

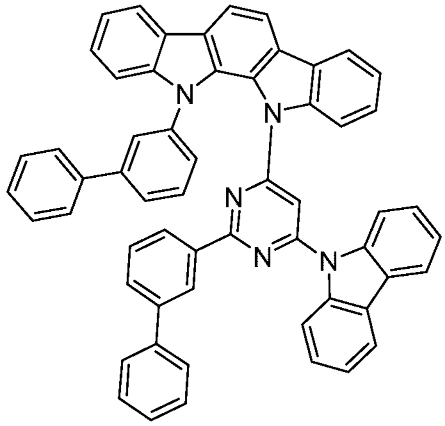

3-68

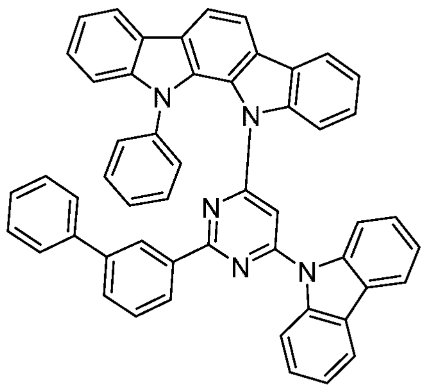

3-69

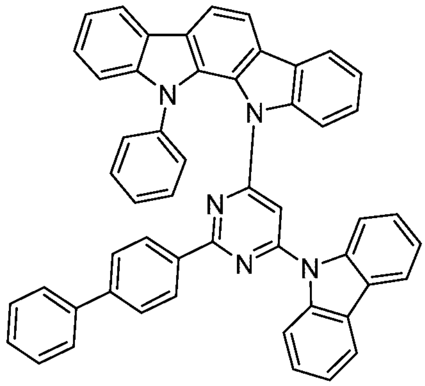

3-70

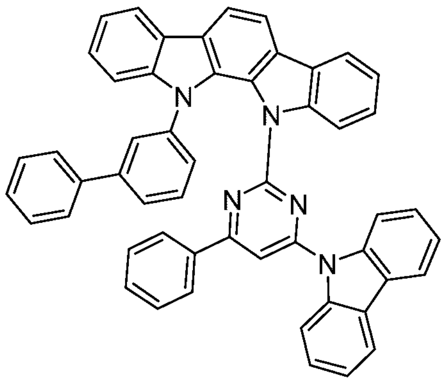

3-71

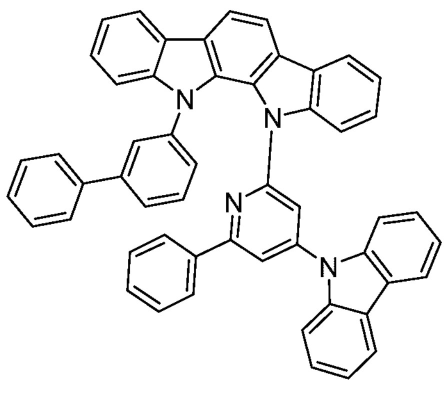

3-72

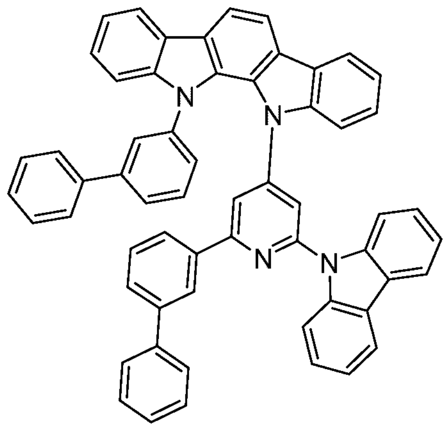

3-73

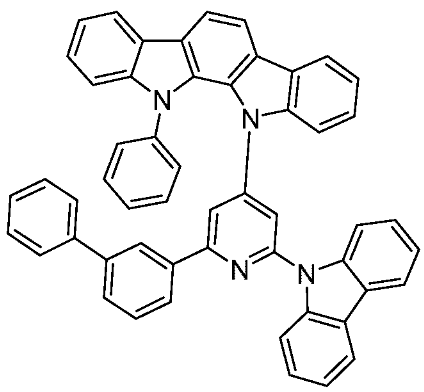

3-74

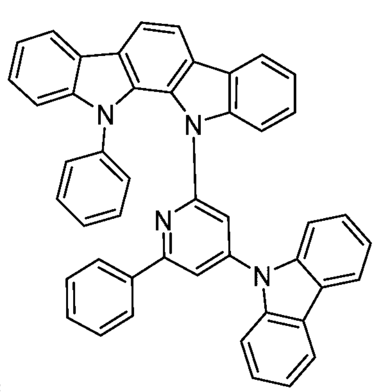

3-75

[C49]

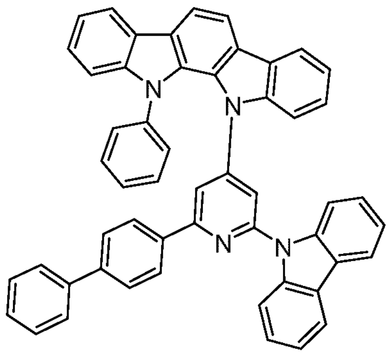

3-76

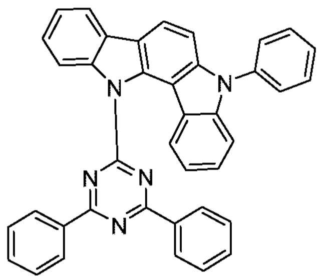

3-77

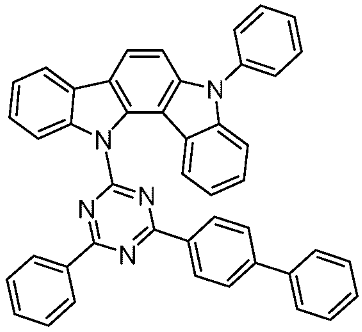

3-78

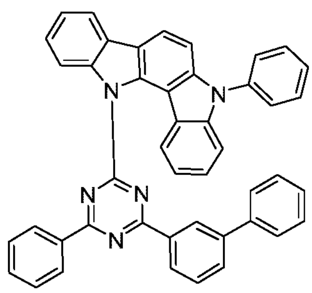

3-79

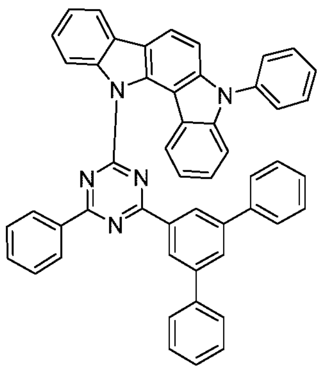

3-80

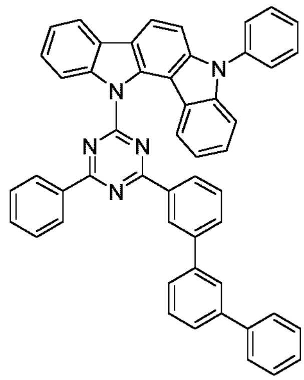

3-81

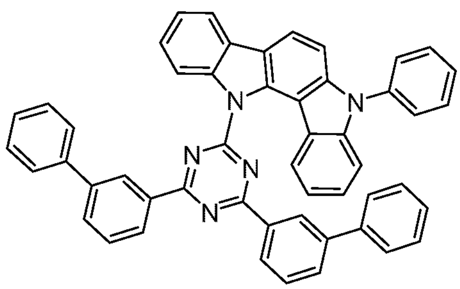

3-82

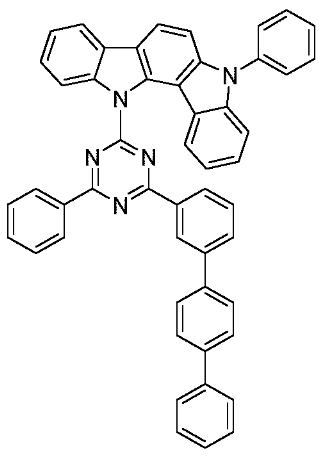

3-83

[C50]

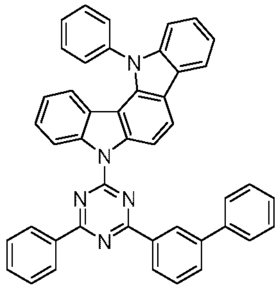
3-84

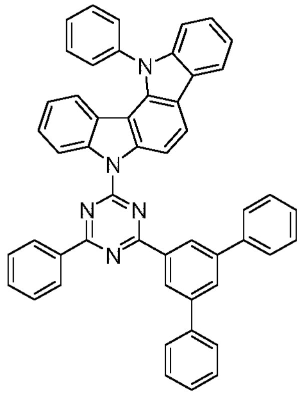
3-85

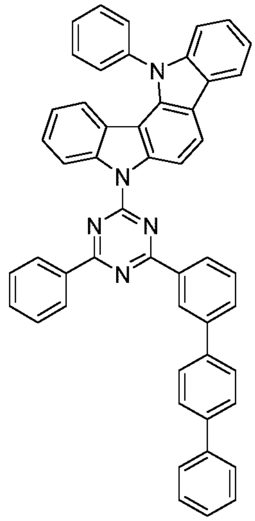
3-86

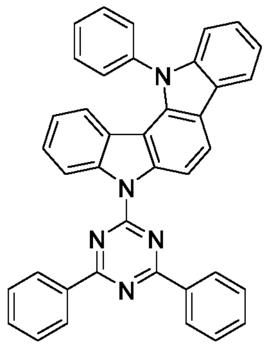
3-87

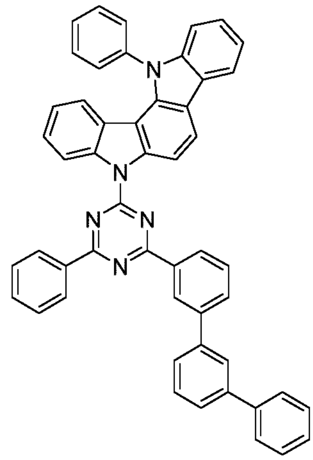
3-88

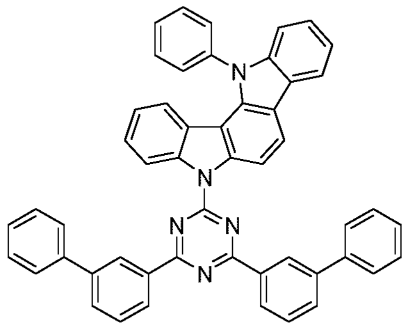
3-89

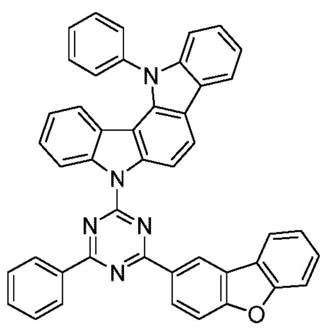
3-90

[C51]

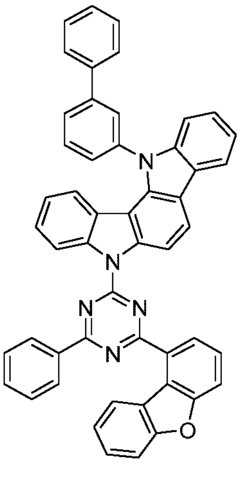
3-91

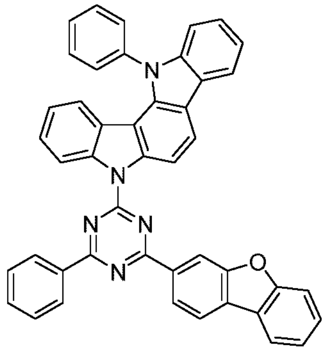
3-92

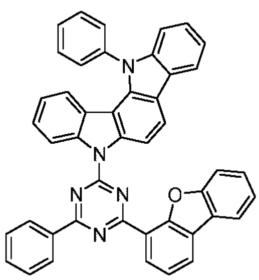
3-93

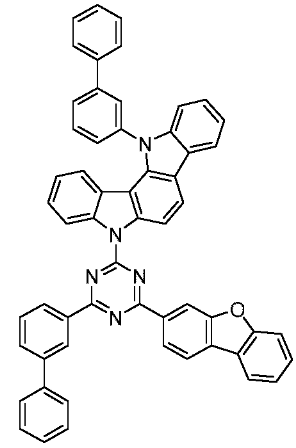
3-94

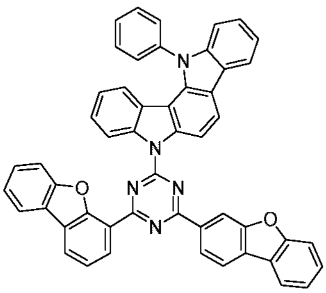
3-95

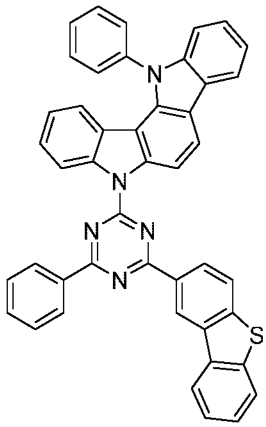
3-96

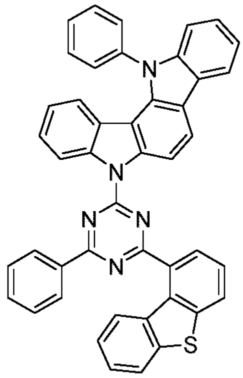
3-97

[C52]

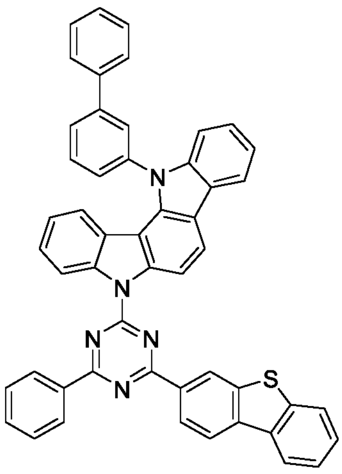
3-98

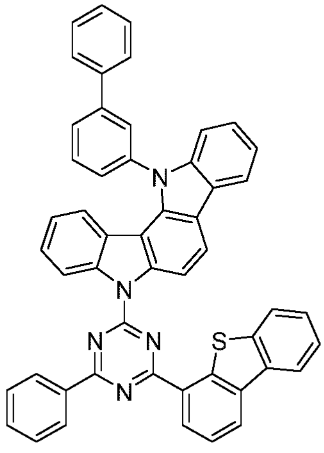
3-99

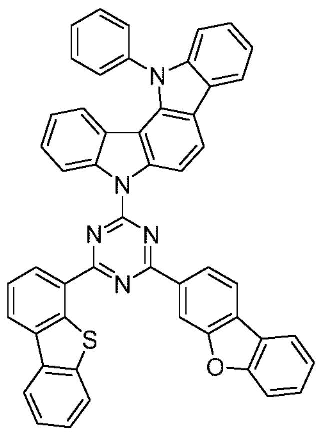
3-100

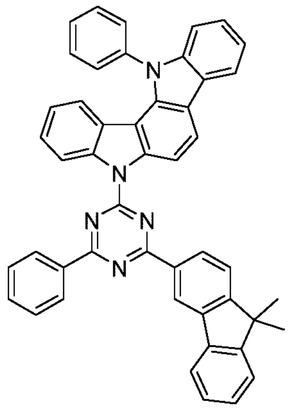
3-101

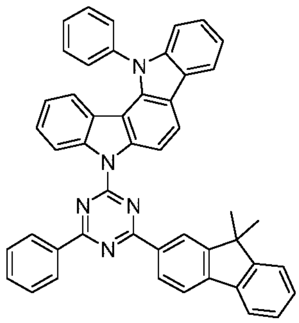
3-102

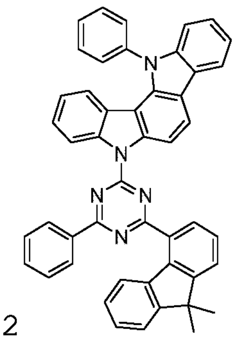
3-103

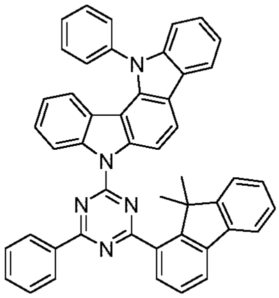
3-104

[C53]

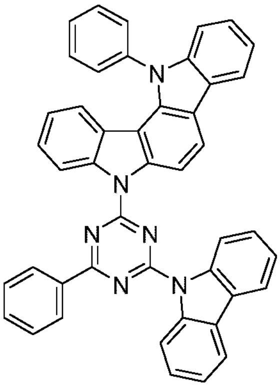
3-105

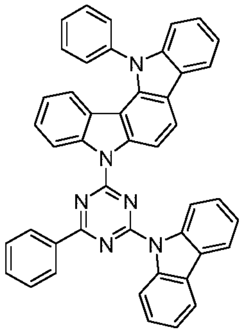
3-106

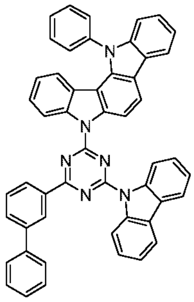
3-107

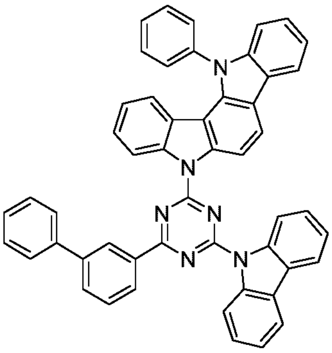
3-108

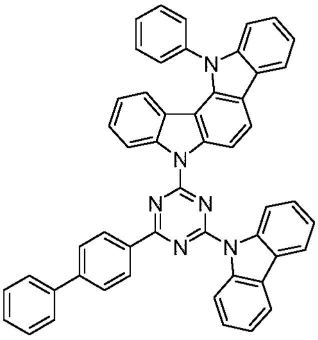
3-109

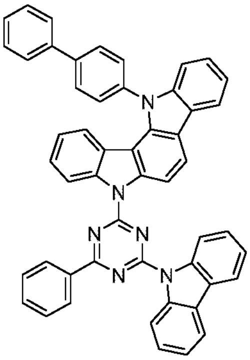
3-110

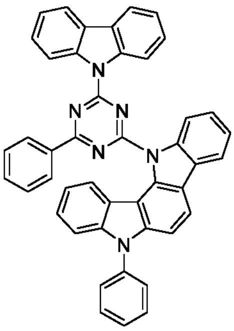
3-111

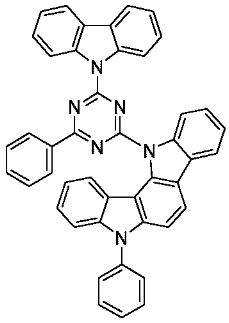
3-112

[C54]

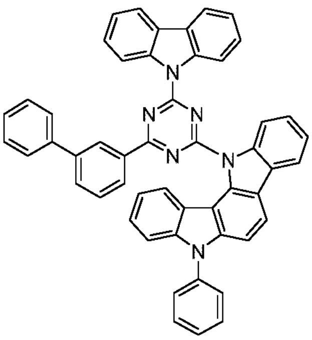
3-113

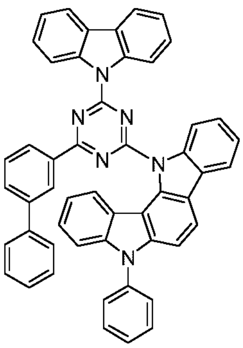
3-114

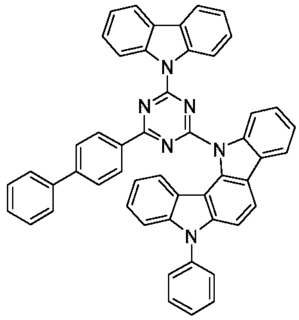
3-115

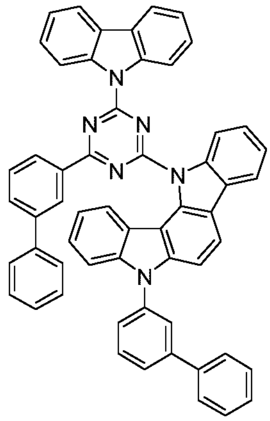
3-116

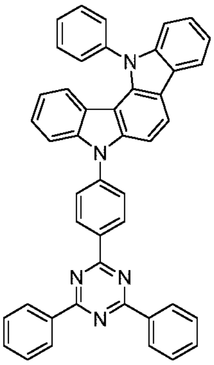
3-117

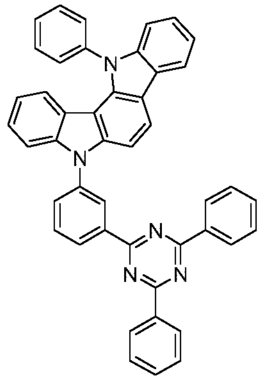
3-118

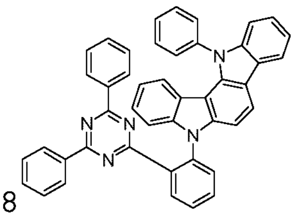
3-119

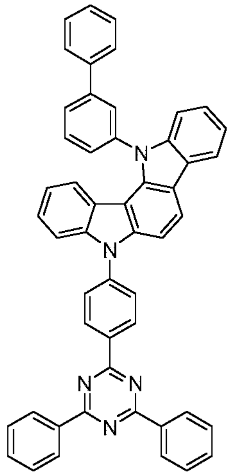
3-120

[C55]

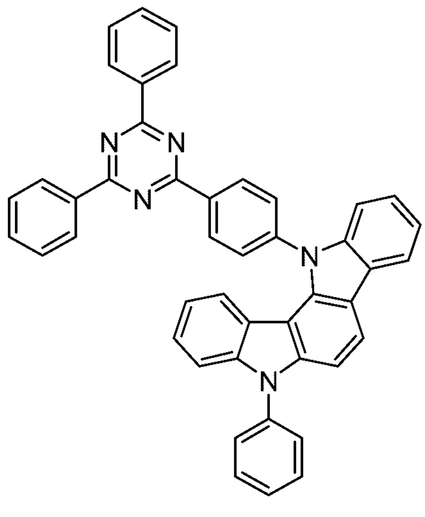
3-121

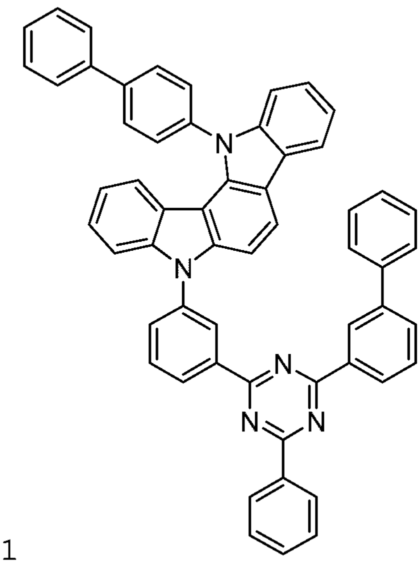
3-122

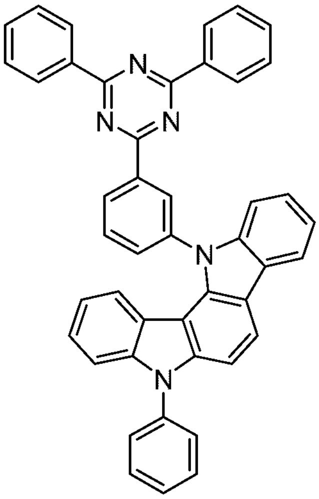
3-123

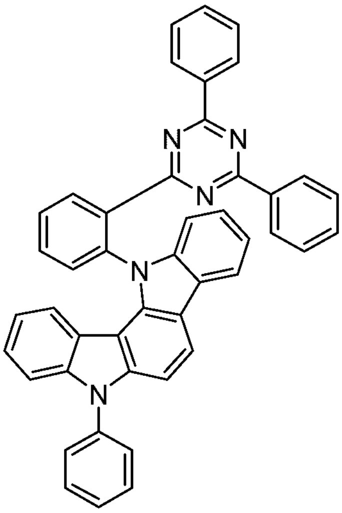
3-124

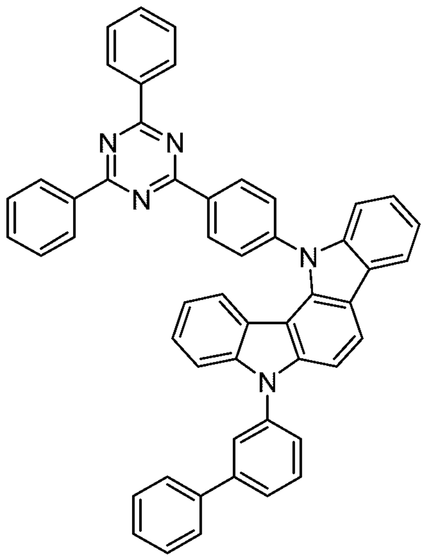
3-125

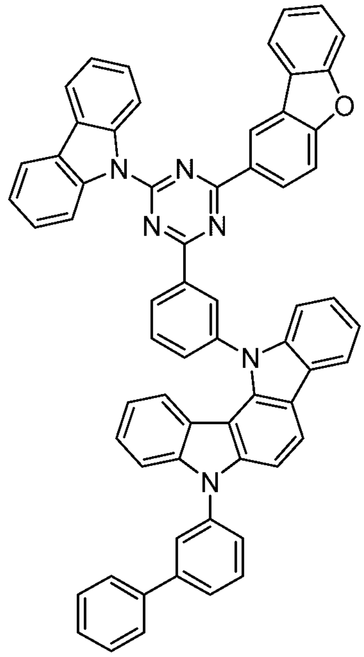
3-126

[C56]

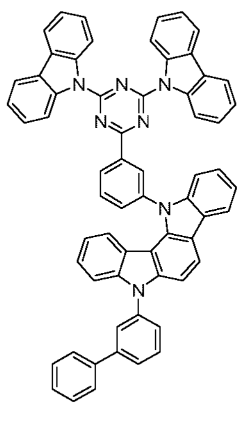
3-127

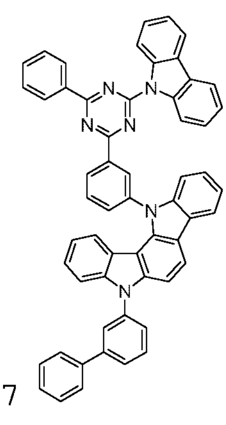
3-128

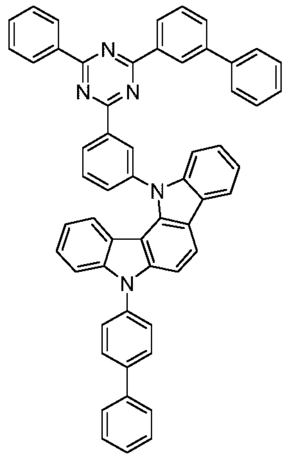

3-129

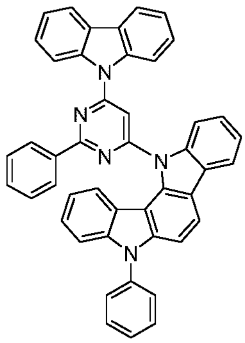

3-130

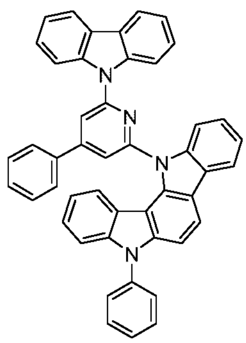

3-131

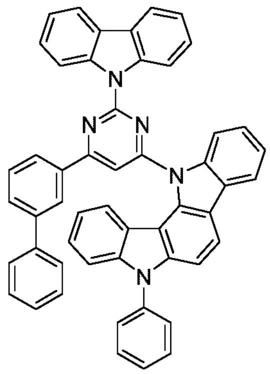

3-132

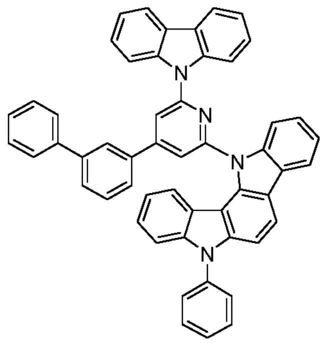

3-133

[C57]

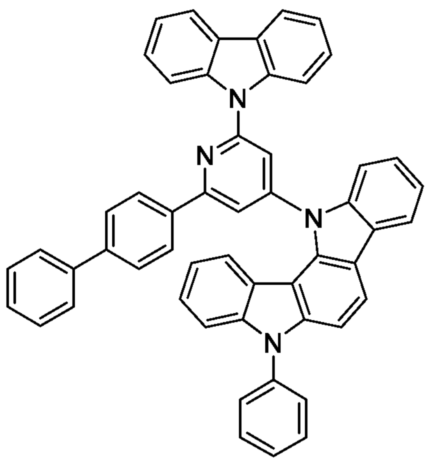

3-134

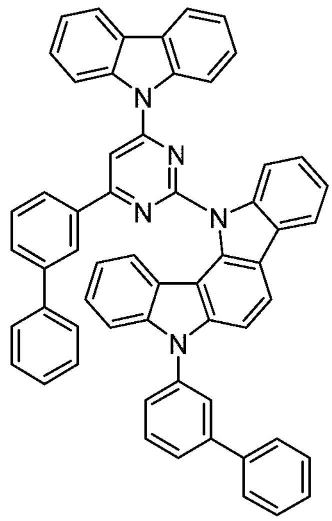

3-135

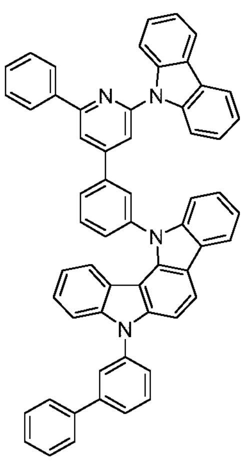
3-136

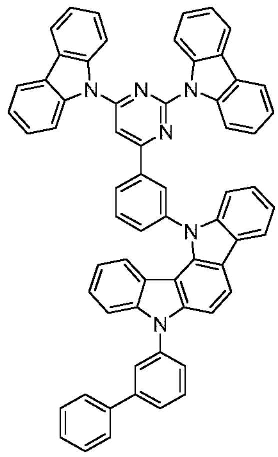
3-137

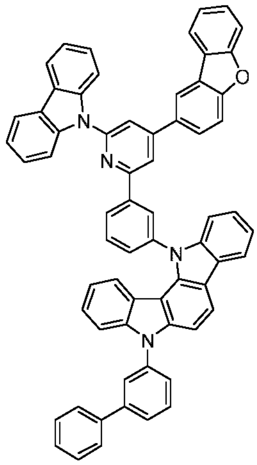
3-138

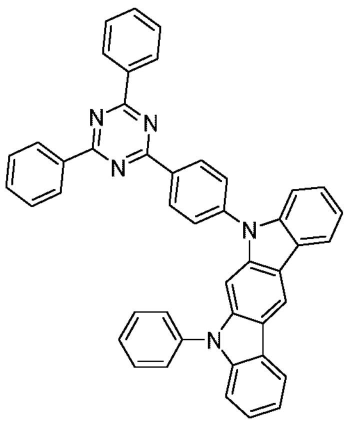
3-139

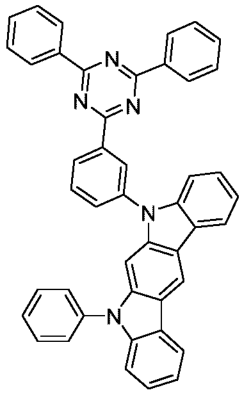
3-140

[C58]

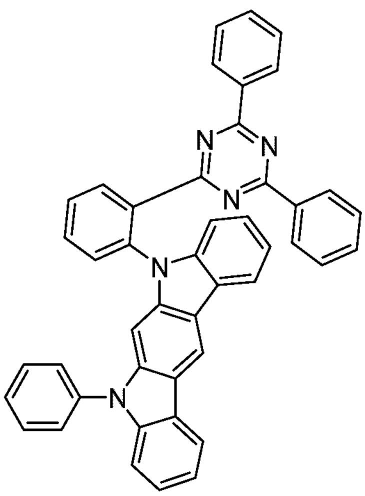
3-141

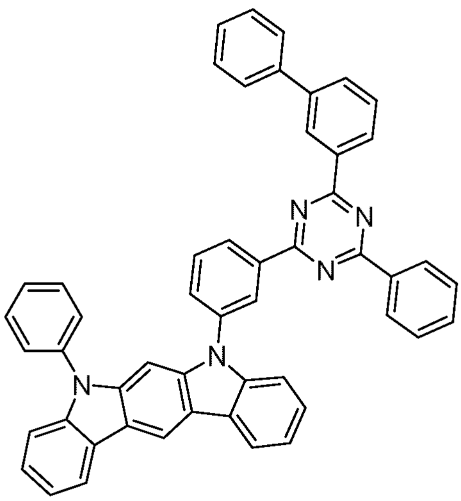
3-142

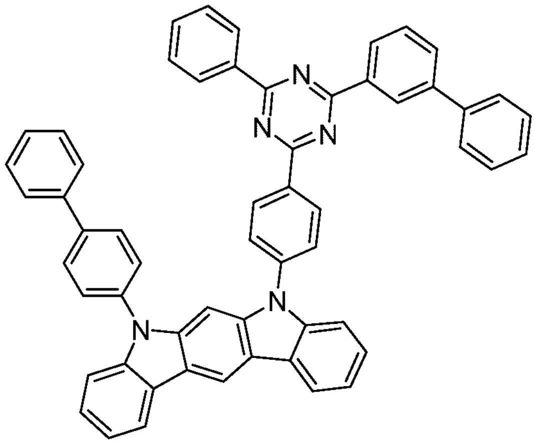

3-143

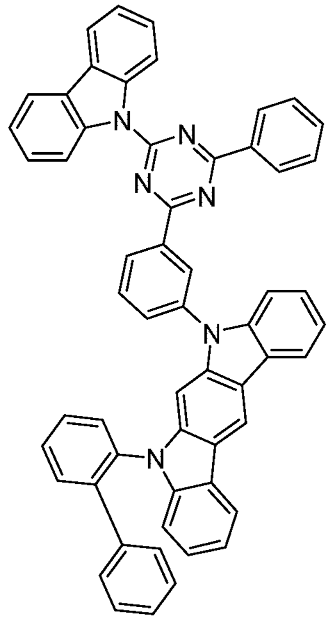

3-144

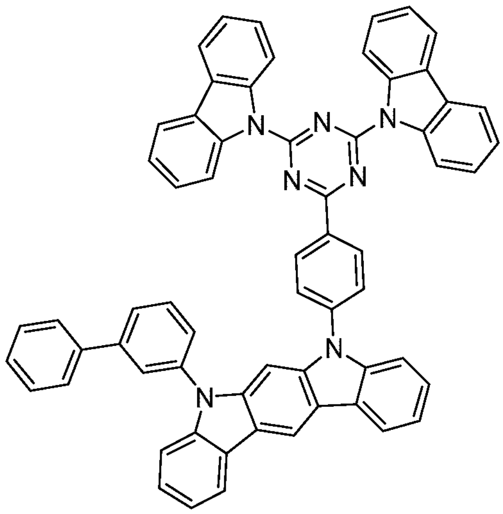

3-145

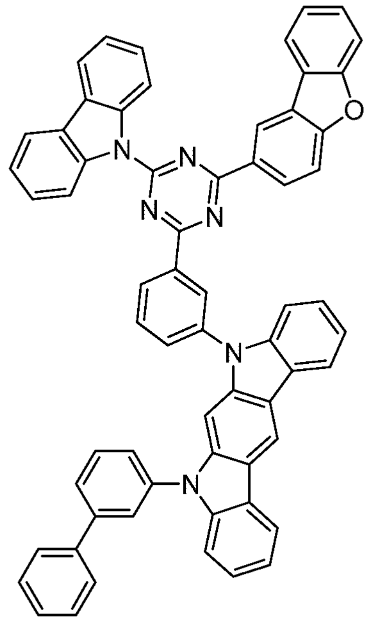

3-146

[C59]

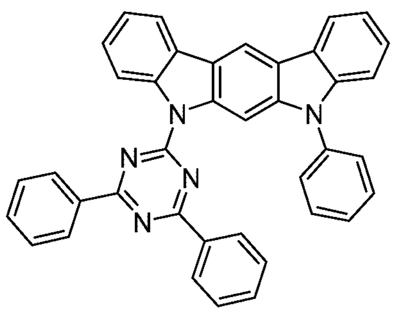

3-147

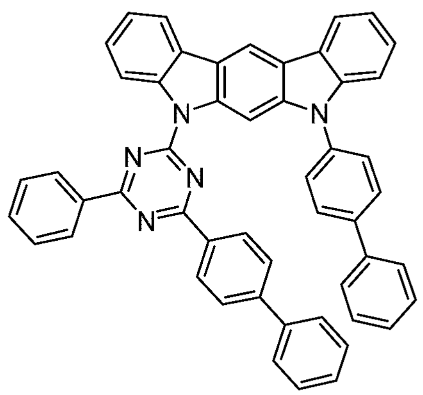

3-148

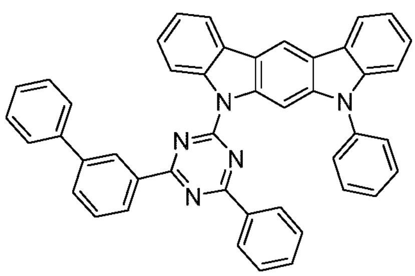

3-149

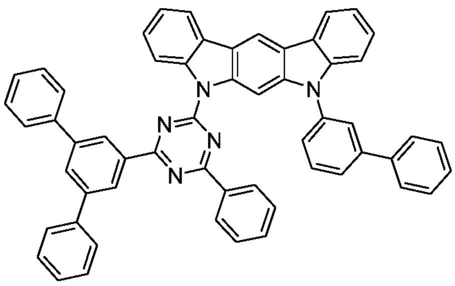

3-150

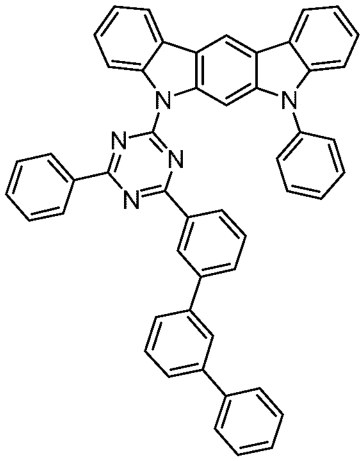

3-151

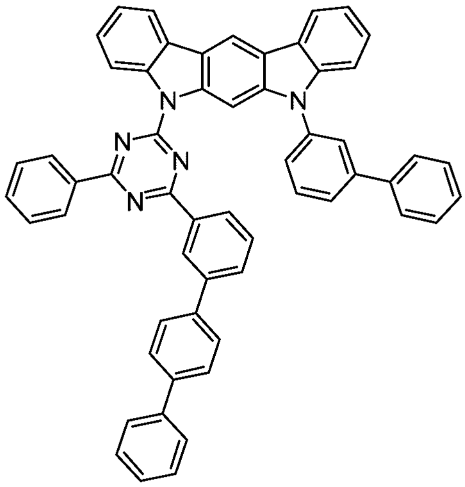

3-152

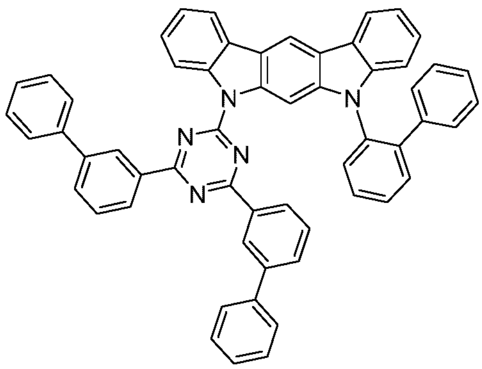

3-153

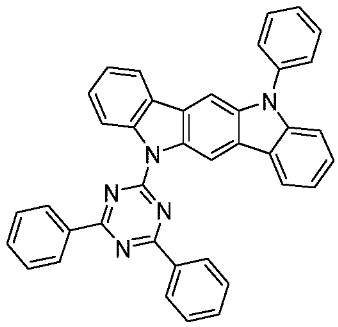

3-154

[C60]

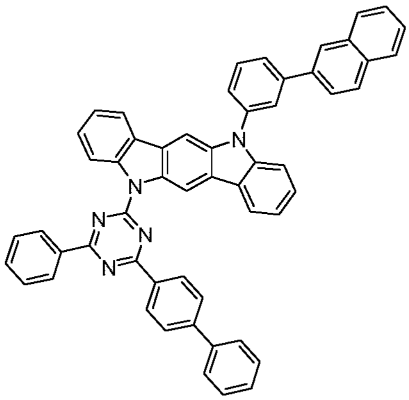

3-155

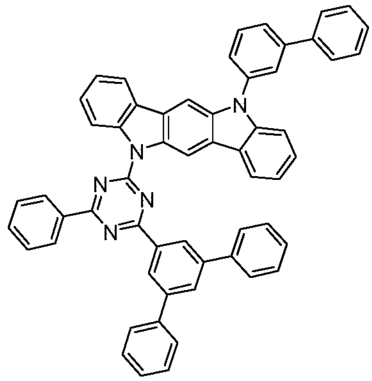

3-156

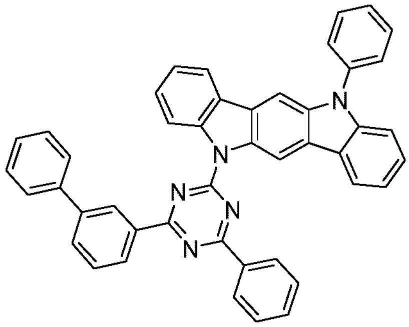

3-157

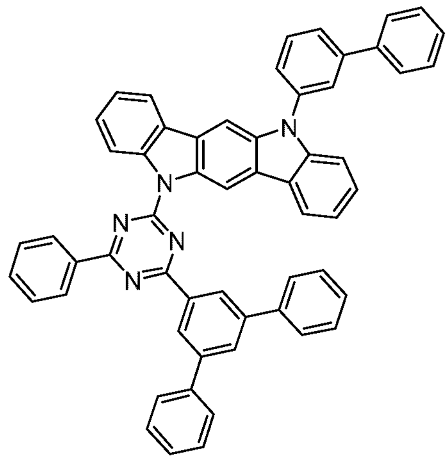

3-158

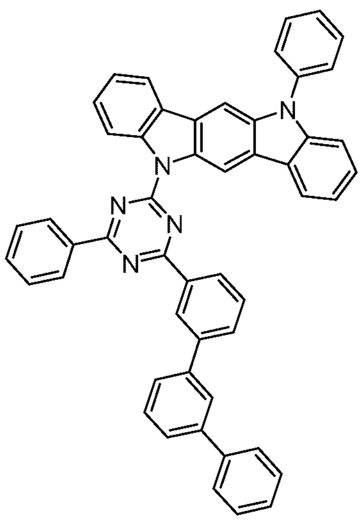

3-159

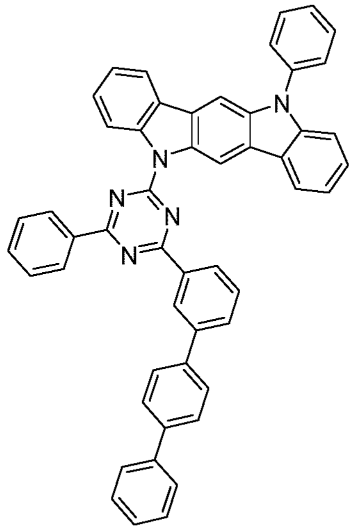

3-160

[C61]

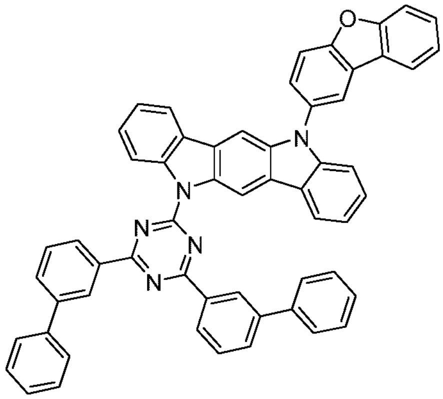

3-161

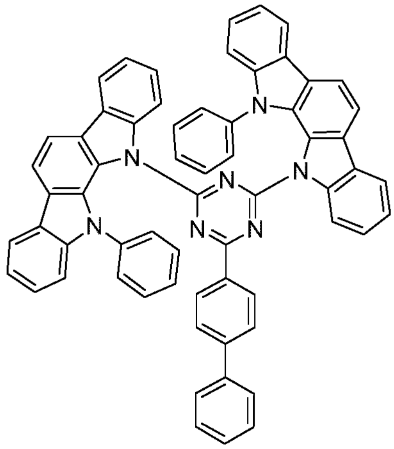

3-162

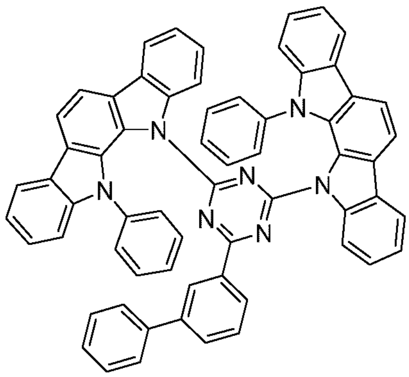

3-163

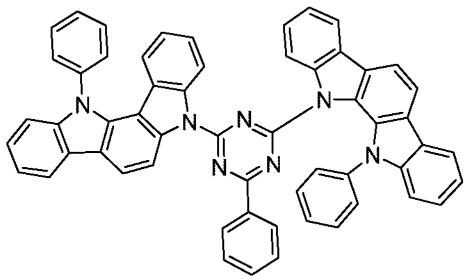

3-164

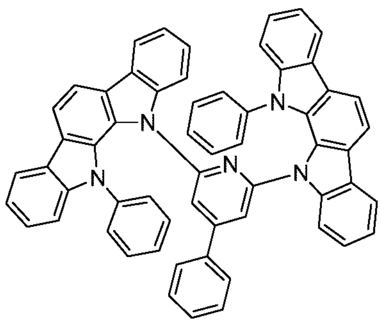

3-165

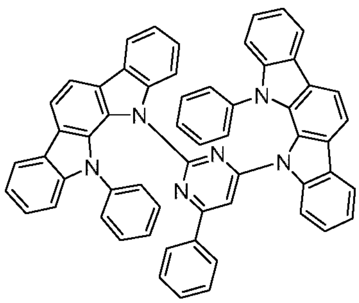

3-166

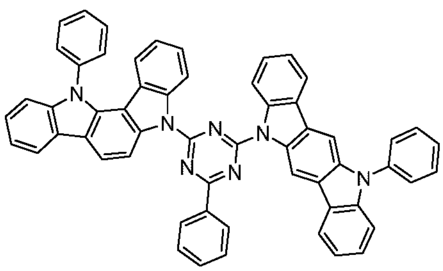

3-167

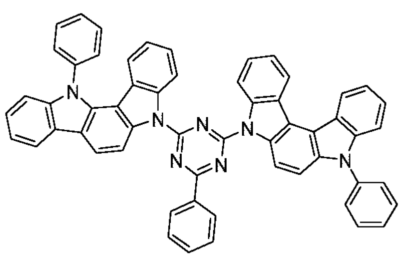

3-168

[C62]

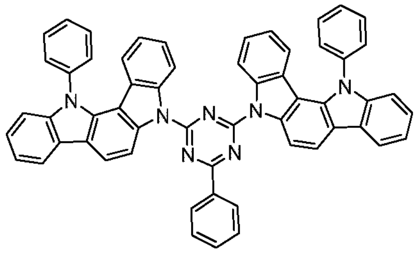

3-169

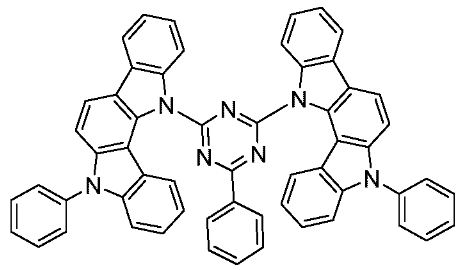

3-170

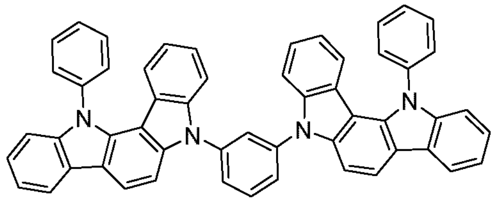

3-171

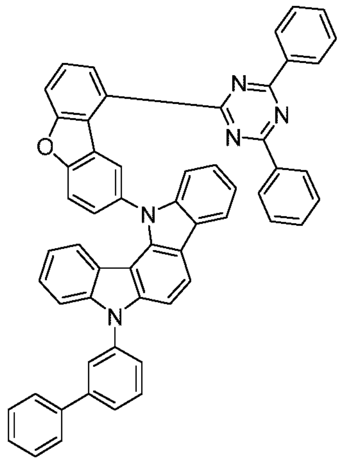

3-172

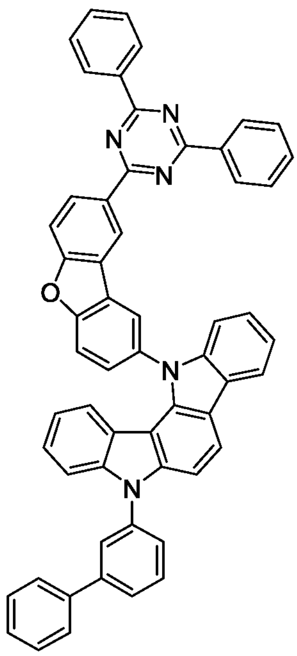

3-173

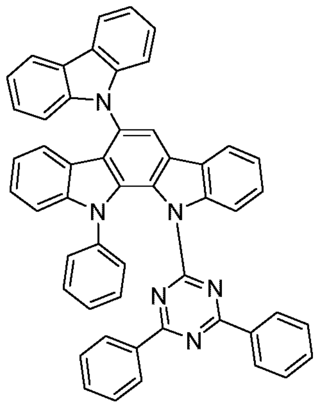

3-174

[C63]

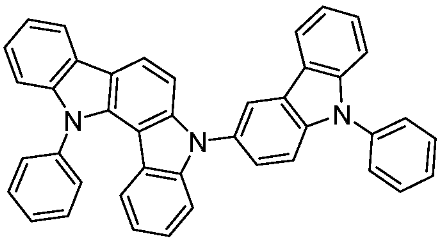
3-175

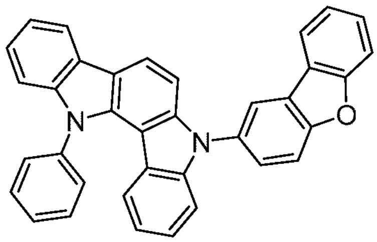
3-176

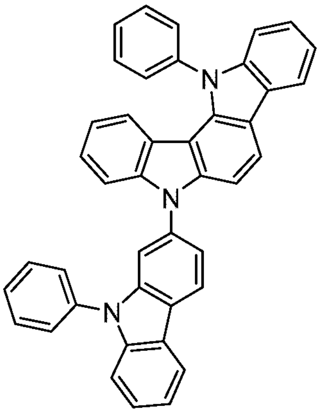
3-178

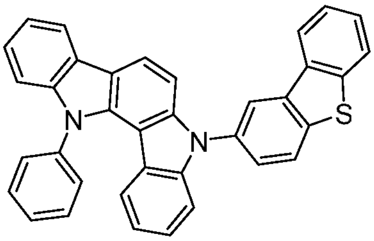
3-177

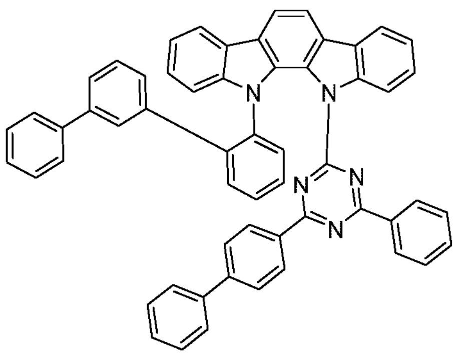
3-180

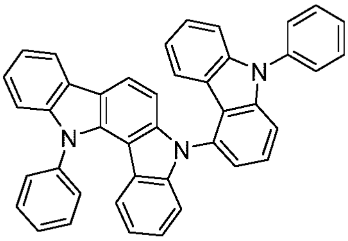
3-179

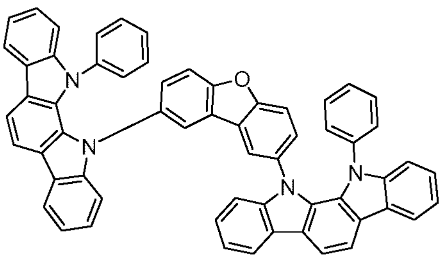
3-181

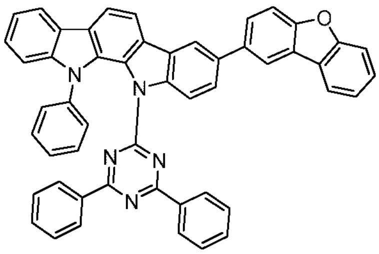
3-182

[C64]

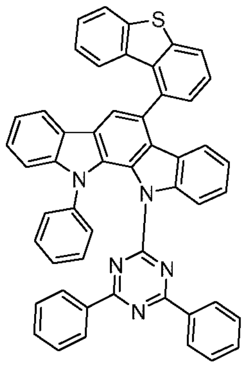
3-183
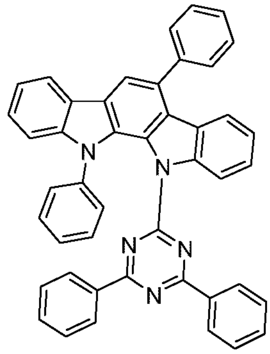
3-184
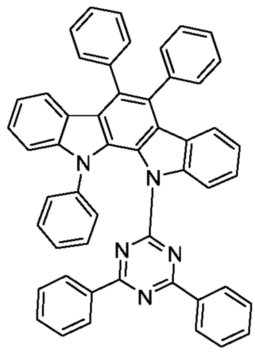
3-185

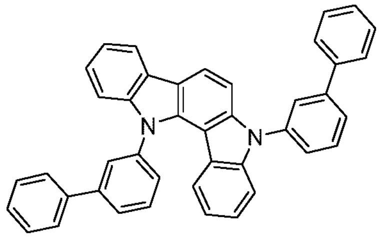
3-186
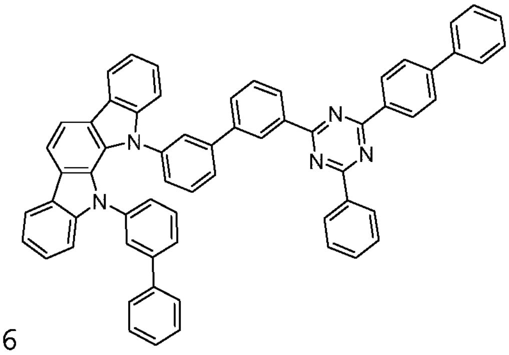
3-187

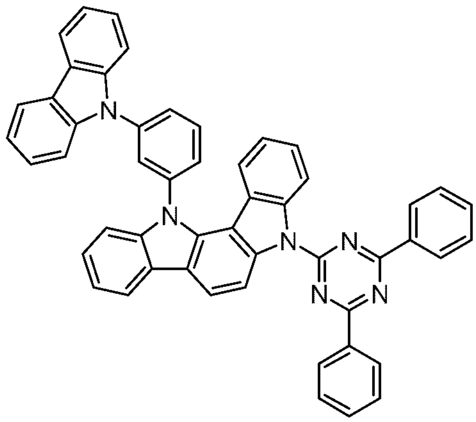
3-188

The light emitting dopant used in the organic EL device of the present invention is a polycyclic aromatic compound represented by the general formula (4) or a polycyclic aromatic compound having a structure represented by the general formula (4) as a partial structure.

The polycyclic aromatic compound having a structure represented by the general formula (4) as a partial structure is also referred to as the substructured polycyclic aromatic compound. The substructured polycyclic aromatic compound is preferably a polycyclic aromatic compound represented by the formula (5), and more preferably a boron-containing polycyclic aromatic compound represented by the formula (6).

In the general formula (4) and the general formula (5), each of the ring C, the ring D, the ring E, the ring F, the ring G, the ring H, the ring I, and the ring J is independently an aromatic hydrocarbon ring having 6 to 24 carbon atoms or an aromatic heterocyclic ring having 3 to 17 carbon atoms, and preferably represents an aromatic hydrocarbon ring having 6 to 20 carbon atoms or an aromatic heterocyclic ring having 3 to 15 carbon atoms. Since the ring C to the ring J are an aromatic hydrocarbon ring or an aromatic heterocyclic ring as described above, they are also referred to as the aromatic ring.

Specific examples of the above aromatic ring include a ring consisting of benzene, naphthalene, acenaphthene, acenaphthylene, azulene, anthracene, chrysene, pyrene, phenanthrene, triphenylene, fluorene, benzo[a]anthracenepyridine, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, or carbazole. The aromatic ring is more preferably a benzene ring, a naphthalene ring, an anthracene ring, a triphenylene ring, a phenanthrene ring, a pyrene ring, a pyridine ring, a dibenzofuran ring, a dibenzothiophene ring, or a carbazole ring.

In the general formula (4), $Y^4$ is B, P, P=O, P=S, Al, Ga, As, Si-$R^4$, or Ge-$R^{41}$, preferably B, P, P=O, or P=S, and more preferably B.

$R^4$ and $R^{41}$ represent an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. $R^4$ and $R^{41}$ are preferably an aliphatic hydrocarbon group having 1 to 8 carbon atoms, a substituted or unsubstituted aromatic hydrocarbon group having 6 to 12 carbon atoms, or a substituted or unsubstituted aromatic heterocyclic group having 3 to 15 carbon atoms. $R^4$ and $R^{41}$ are more preferably a substituted or unsubstituted aromatic hydrocarbon group having 6 to 10 carbon atoms or a substituted or unsubstituted aromatic heterocyclic group having 3 to 12 carbon atoms.

When $R^4$ and $R^{41}$ are an aliphatic hydrocarbon group having 1 to 10 carbon atoms, or are a substituted or unsubstituted aromatic hydrocarbon group having 6 to 18 carbon atoms, or a substituted or unsubstituted aromatic heterocyclic group having 3 to 17 carbon atoms, specific examples thereof are the same as the case where $R^1$ in the general formula (1) is an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.

Each $X^4$ is independently O, N-$Ar^4$, S, or Se, preferably O, N-$Ar^4$, or S, and more preferably O or N-$Ar^4$.

Each $Ar^4$ is independently a substituted or unsubstituted aromatic hydrocarbon group having 6 to 18 carbon atoms, a substituted or unsubstituted aromatic heterocyclic group having 3 to 17 carbon atoms, or a linked aromatic group in which 2 to 8 of these aromatic rings are linked to each other. Each $Ar^4$ preferably represents a substituted or unsubstituted aromatic hydrocarbon group having 6 to 12 carbon atoms, a substituted or unsubstituted aromatic heterocyclic group having 3 to 12 carbon atoms, or a substituted or unsubstituted linked aromatic group formed by linking 2 to 6 aromatic rings thereof. Each $Ar^4$ more preferably represents a substituted or unsubstituted aromatic hydrocarbon group having 6 to 10 carbon atoms, a substituted or unsubstituted aromatic heterocyclic group having 3 to 10 carbon atoms, or a substituted or unsubstituted linked aromatic group formed by linking 2 to 4 aromatic rings thereof.

Each $Ar^4$ is more preferably a phenyl group, a biphenyl group, or a terphenyl group.

When $Ar^4$ is a substituted or unsubstituted aromatic hydrocarbon group having 6 to 18 carbon atoms, a substituted or unsubstituted aromatic heterocyclic group having 3 to 17 carbon atoms, or a linked aromatic group in which 2 to 8 of these aromatic rings are linked to each other, specific examples thereof are the same as the case where $Ar^1$ in the general formula (1) is a substituted or unsubstituted aromatic hydrocarbon group having 6 to 18 carbon atoms, a substituted or unsubstituted aromatic heterocyclic group having 3 to 17 carbon atoms, or a linked aromatic group in which 2 to 8 of these aromatic rings are linked to each other.

N-$Ar^4$ may be bonded to an aromatic ring selected from the ring C, the ring D, or the ring E to form a heterocyclic ring containing N. In addition, at least one hydrogen atom in the ring C, the ring D, the ring E, $R^4$, $R^{41}$, $R^{42}$, and $Ar^4$ may be replaced with a halogen or deuterium.

$R^{42}$ represents a substituent of the ring C, the ring D, and the ring E, and each $R^{42}$ independently represents a cyano group, deuterium, a diarylamino group having 12 to 44 carbon atoms, an arylheteroarylamino group having 12 to 44 carbon atoms, a diheteroarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. Each $R^{42}$ is preferably a diarylamino group having 12 to 36 carbon atoms, an arylheteroarylamino group having 12 to 36 carbon atoms, a diheteroarylamino group having 12 to 36 carbon atoms, a substituted or unsubstituted aromatic hydrocarbon group having 6 to 12 carbon atoms, or a substituted or unsubstituted aromatic heterocyclic ring having 3 to 15 carbon atoms. Each $R^{42}$ is more preferably a diarylamino group having 12 to 24 carbon atoms, an arylheteroarylamino group having 12 to 24 carbon atoms, a diheteroarylamino group having 12 to 24 carbon atoms, a substituted or unsubstituted aromatic hydrocarbon group having 6 to 10 carbon atoms, or a substituted or unsubstituted aromatic heterocyclic group having 3 to 12 carbon atoms.

When $R^{42}$ represents an aliphatic hydrocarbon group having 1 to 10 carbon atoms, specific examples thereof are the same as the case of $R^1$.

When $R^{42}$ represents a substituted or unsubstituted aromatic hydrocarbon group having 6 to 18 carbon atoms or a substituted or unsubstituted aromatic heterocyclic group having 3 to 17 carbon atoms, specific examples thereof are the same as the case of $Ar^1$. Preferred examples thereof include a group produced from benzene, naphthalene, acenaphthene, acenaphthylene, azulene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole,

benzimidazole, benzotriazole, benzisothiazole, benzothiadiazole, purine, pyranone, coumarin, isocoumarin, chromone, dibenzofuran, dibenzothiophene, dibenzoselenophene, or carbazole. More preferred examples thereof include a group produced from benzene or naphthalene.

When $R^{42}$ represents a diarylamino group having 12 to 44 carbon atoms, an arylheteroarylamino group having 12 to 44 carbon atoms, a diheteroarylamino group having 12 to 44 carbon atoms, or an aliphatic hydrocarbon group having 1 to 10 carbon atoms, specific examples thereof include diphenylamino, dibiphenylamino, phenylbiphenylamino, naphthylphenylamino, dinaphthylamino, dianthranilamino, diphenanthrenylamino, dipyrenylamino, dibenzofuranylphenylamino, dibenzofuranylbiphenylamino, dibenzofuranylnaphthylamino, dibenzofuranylanthranylamino, dibenzofuranylphenanthrenylamino, dibenzofuranylpyrenylamino, bisdibenzofuranylamino, carbazolylphenylamino, carbazolylnaphthylamino, carbazolylanthranylamino, carbazolylphenanthrenylamino, carbazolylpyrenylamino, dicarbazolylamino, methyl, ethyl, propyl, butyl, pentyl, hexyl, heptyl, octyl, and nonyl. Preferred examples thereof include diphenylamino, dibiphenylamino, phenylbiphenylamino, naphthylphenylamino, dinaphthylamino, dianthranilamino, diphenanthrenylamino, and dipyrenylamino. More preferred examples thereof include diphenylamino, dibiphenylamino, phenylbiphenylamino, naphthylphenylamino, dinaphthylamino, dibenzofuranylphenylamino, and carbazolylphenylamino.

Each v independently represents an integer of 0 to 4, and is preferably an integer of 0 to 2, and more preferably 0 to 1. x represents an integer of 0 to 3, preferably an integer of 0 to 2, and more preferably 0 to 1.

The polycyclic aromatic compound having a structure represented by the general formula (4) as a partial structure will be described. Since the polycyclic aromatic compound having a structure represented by the general formula (4) as a partial structure can be considered as a condensate of the compound represented by the general formula (4) or its analog, it is also referred to as the substructured polycyclic aromatic compound.

Examples of the substructured polycyclic aromatic compound include the compounds represented by the above formula (5) or formula (6).

In the general formula (4), the formula (5), and the formula (6), common symbols have the same meaning.

In the formula (5), w represents an integer of 0 to 4, y represents an integer of 0 to 3, and z represents an integer of 0 to 2. Preferably, w is 0 or 2, y is 0 or 1, and z is 0 or 1.

In the formula (5), the ring F to the ring J are as described above.

The ring F and the ring G have the same meanings as the ring C and the ring D in the general formula (4), and the ring H and the ring J have the same meanings as the ring E. Since the structure of the ring I is shared, the ring I is a tetravalent group (when z = 0).

In the formula (6), $X^6$ independently represents N-$Ar^6$, O, or S, provided that at least one $X^6$ represents N-$Ar^6$. $X^6$ preferably represents O or N-$Ar^5$, and more preferably N-$Ar^5$. $Ar^6$ has the same meaning as $Ar^4$ in the general formula (4). N-$Ar^6$ may be bonded to the above aromatic ring to form a heterocyclic ring containing N. In this case, $Ar^3$ may be directly bonded to the above aromatic ring, or may be bonded via a linking group.

$R^6$ independently represents a cyano group, deuterium, a diarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.

Specific examples thereof are the same as the case where $R^{42}$ is a cyano group, deuterium, a diarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.

k independently represents an integer of 0 to 4, 1 independently represents an integer of 0 to 3, and m independently represents an integer of 0 to 2. Preferably, k independently represents an integer of 0 to 2, l represents an integer of 0 to 2, and m is an integer of 0 to 1.

The substructured polycyclic aromatic compound will be described with reference to the formula (5) and the formula (6).

The formula (5) consists of the structure represented by the general formula (4) and a part of the structure thereof. From another viewpoint, the formula (5) includes two structures represented by the general formula (4), in which the ring I is shared. That is, the formula (5) has the structure represented by the general formula (4) as a partial structure.

The same applies to the formula (6). Although the formula (6) has a structure in which the central benzene ring is shared, it is recognized that the formula (6) consists of the structure represented by the general formula (4) and a part of the structure thereof.

The substructured polycyclic aromatic compound used in the present invention has the structure represented by the general formula (4) as a partial structure. The substructured polycyclic aromatic compound having a structure in which either one of the ring C to the ring E in the general formula (4) is eliminated, as the other partial structure is suitable. Then, the substructured polycyclic aromatic compound having one structure represented by the general formula (4) as a partial structure and one to three other partial structures described above is preferred. The bond between the structure represented by the general formula (4) and the other partial structure may be bonded by condensation or formation of one or more rings, or may be bonded through one or more bonds.

Examples of preferred modes of the above general formula (4), general formula (5), formula (6), and substructured polycyclic aromatic compound include the following formula (4-a) to formula (4-h).

[C65]

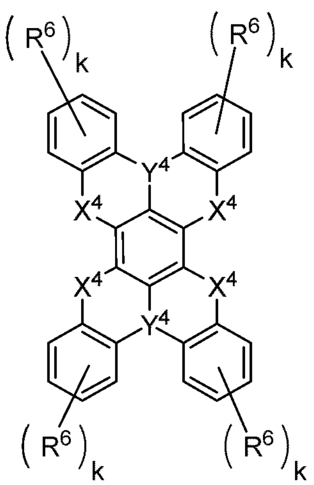
(4-a)

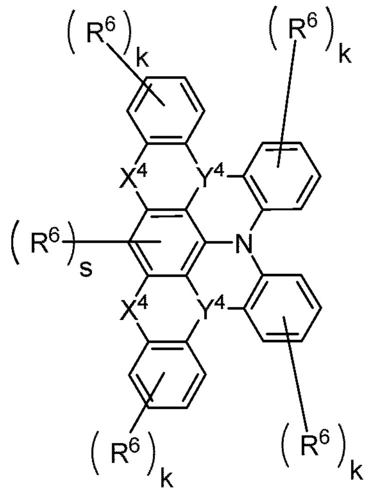
(4-b)

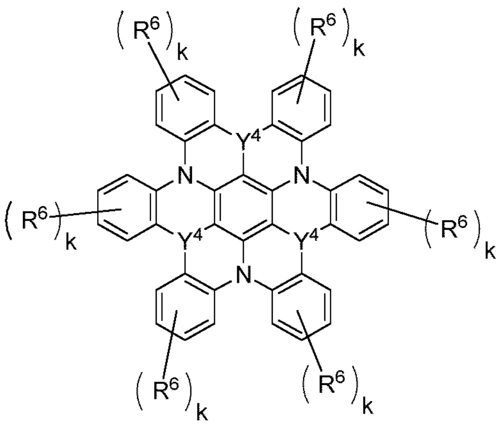
(4-c)

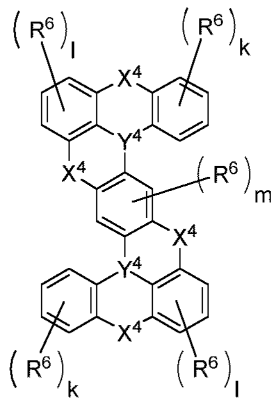
(4-d)

The substructured polycyclic aromatic compound represented by the above formula (4-a) corresponds to, for example, the compound represented by the formula (4-64) described below. That is, the formula (4-a) has a structure in which two structures of the general formula (4) share the central benzene ring, and is understood to be a compound including the structural unit of the general formula (4) and one partial structure thereof.

The substructured polycyclic aromatic compound represented by the formula (4-b) corresponds to, for example, the compound represented by the formula (4-65) described below. That is, the formula (4-b) has a structure in which two structures of the general formula (4) share the central benzene ring, and is understood to be a compound including the structural unit of the general formula (4) and one partial structure thereof. When the structure is described using the general formula (4), the formula (4-b) has a structure in which one of $X^4$ is $NAr^4$ and this $NAr^4$ is bonded to an aromatic ring of the partial structure to form a ring (fused ring structure).

The substructured polycyclic aromatic compound represented by the formula (4-c) corresponds to, for example, the compound represented by the formula (4-66) described below. That is, when the structure is described using the general formula (4), the formula (4-c) has a structure in which three unit structures represented by the general formula (4) share the benzene ring which is the ring E. That is, the formula (4-c) is understood to be a compound having the unit structure represented by the general formula (4) as a partial structure and including two partial structures in which one benzene ring is removed from the general formula (4). In addition, the formula (4-c) has a structure in which $X^4$ is $N\text{-}Ar^4$ and this $NAr^4$ is bonded to an adjacent ring of the partial structure to form a ring.

[C66]

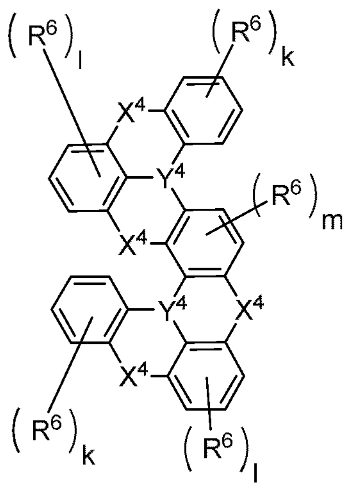

(4-e)

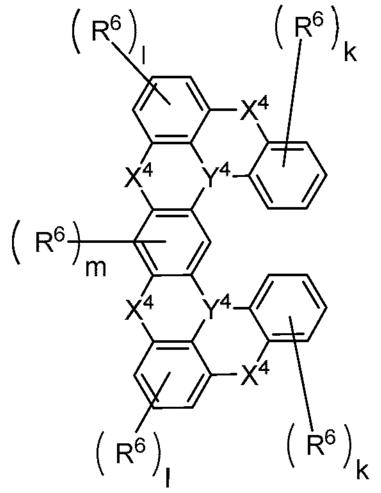

(4-f)

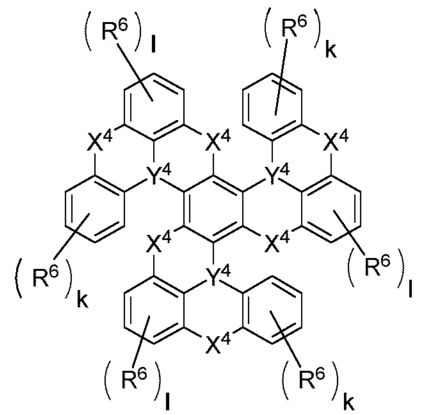

(4-g)

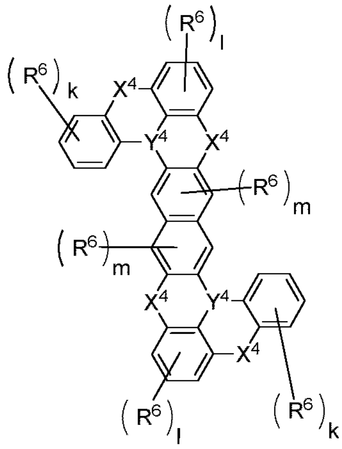

(4-h)

The substructured polycyclic aromatic compounds represented by the formula (4-d), the formula (4-e), the formula (4-f), and the formula (4-g) correspond to, for example, the compounds represented by the formula (4-67), the formula (4-68), the formula (4-69), and the formula (4-70) described below.

That is, the formula (4-d), the formula (4-e), the formula (4-f), and the formula (4-g) are compounds having two or three unit structures represented by the general formula (4) in one compound by sharing the benzene ring which is the ring C (or the ring D). That is, the formula (4-d), the formula (4-e), the formula (4-f), and the formula (4-g) are understood to be compounds having the unit structure represented by the general formula (4) as a partial structure and including one partial structure in which one benzene ring is removed from the general formula (4).

The substructured polycyclic aromatic compound represented by the formula (4-h) corresponds to, for example, the compounds represented by the formula (4-71), the formula (4-72), the formula (4-73), the formula (4-74), and the formula (4-75) described below. That is, when the structure is described using the general formula (4), the formula (4-h) is a substructured polycyclic aromatic compound in which the ring C is a naphthalene ring, and has two unit structures represented by the general formula (4) in one compound by sharing the naphthalene ring. That is, the formula (4-h) is understood to be a compound having the unit structure represented by the general formula (4) as a partial structure and including one or two partial structures in which one ring C (naphthalene ring) is removed from the general formula (4).

In the formula (4-a) to the formula (4-h), $X^4$ and $Y^4$ are as defined in the general formula (4), and $R^6$, k, l, and m are as defined in the formula (6). s is 0 to 1, and preferably 0.

The substructured polycyclic aromatic compound of the present invention can be said to be a compound in which a plurality of the compounds of the general formula (4) is linked by sharing one or two rings (the ring C to the ring E) in the structural unit of the general formula (4), and which includes at least one structural unit of the general formula (4).

The number of the compounds of the general formula (4) that form the above structure is 2 to 5, and preferably 2 to 3. Sharing of the above ring (the ring C to the ring E) may be one or two, or three rings may be shared.

Specific examples of the polycyclic aromatic compounds represented by the general formula (4), the general formula (5), and the formula (6), and other substructured polycyclic aromatic compounds are shown below, but the compounds are not limited to these exemplified compounds.

[C67]

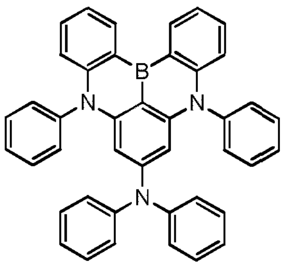
4-1

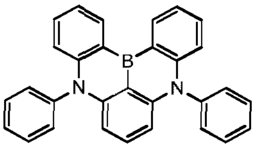
4-2

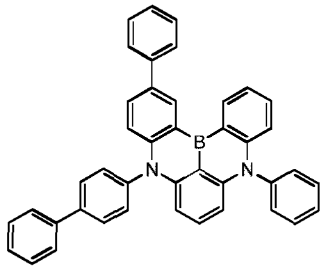
4-3

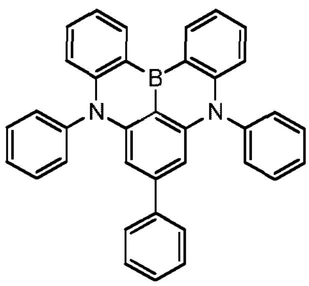
4-4

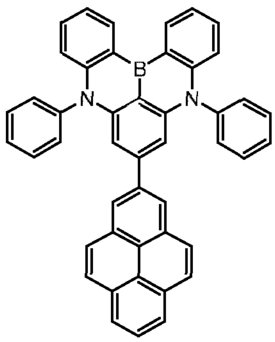
4-5

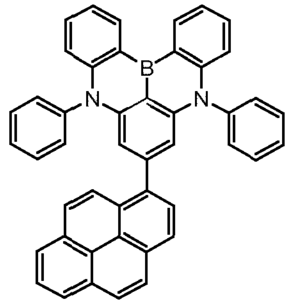
4-6

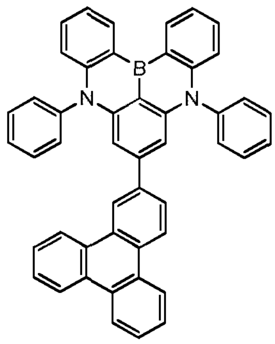
4-7

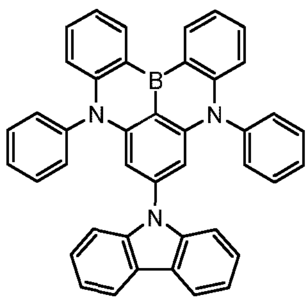
4-8

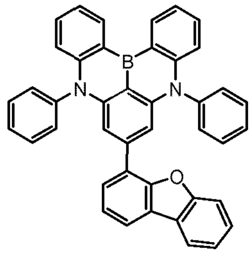
4-9

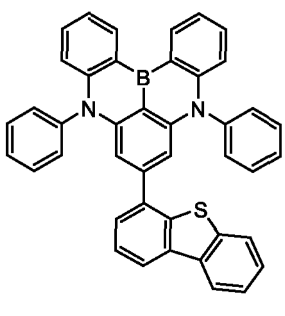
4-10

[C68]

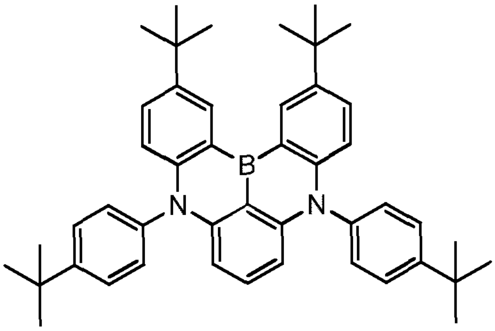
4-11

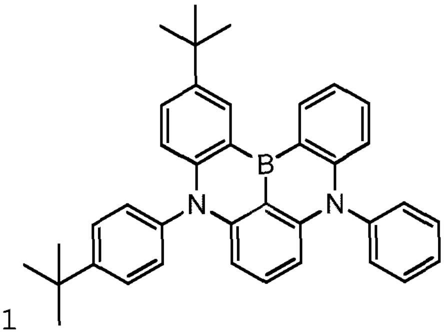
4-12

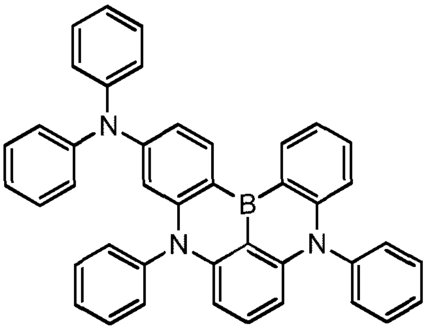
4-13

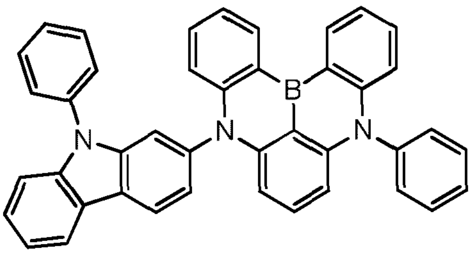
4-14

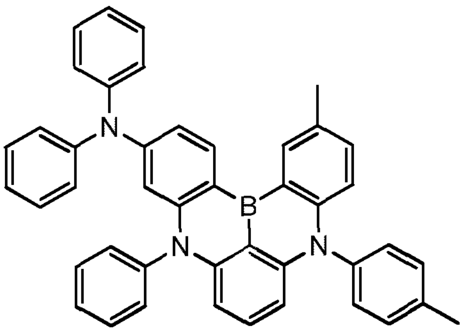
4-15

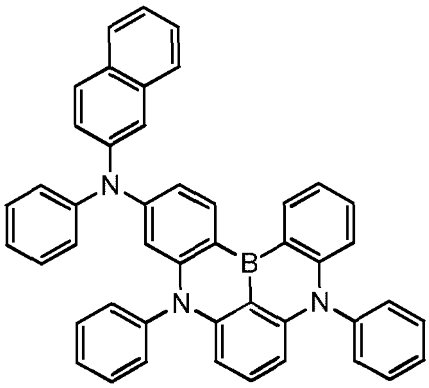
4-16

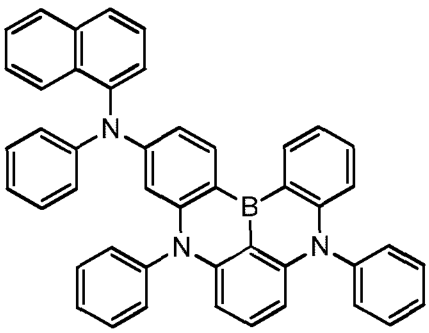
4-17

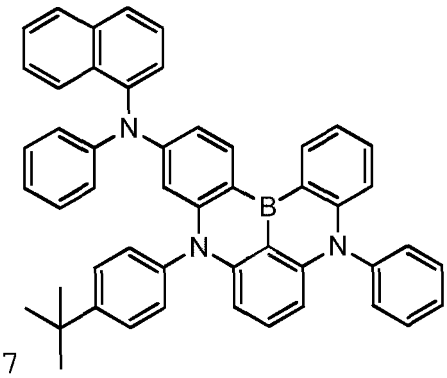
4-18

[C69]

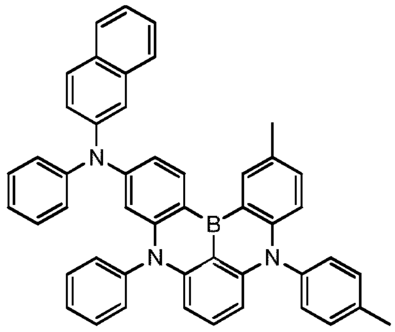
4-19

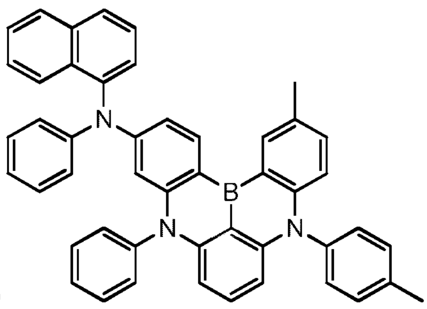
4-20

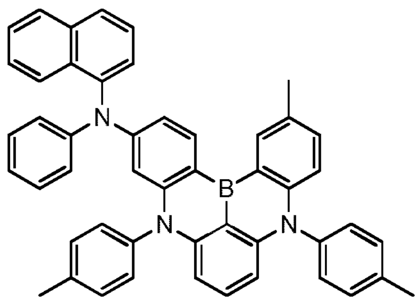
4-21

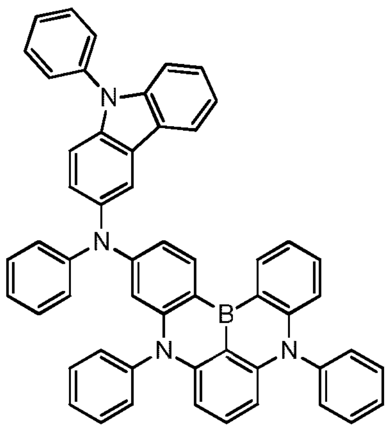
4-22

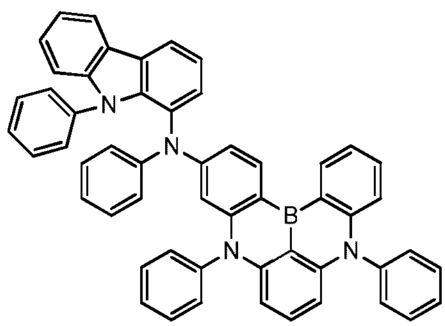
4-23

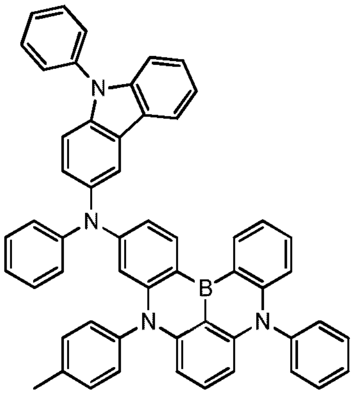
4-24

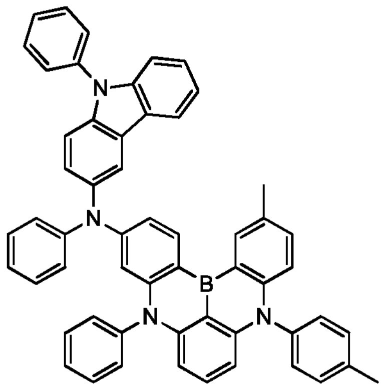
4-25

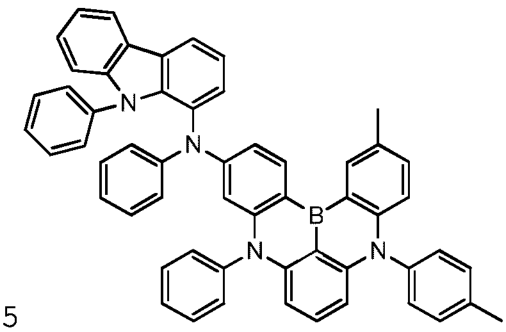
4-26

[C70]

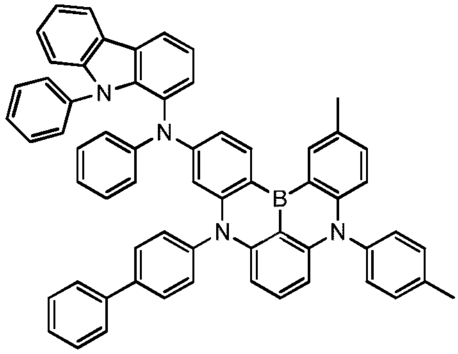

4-27

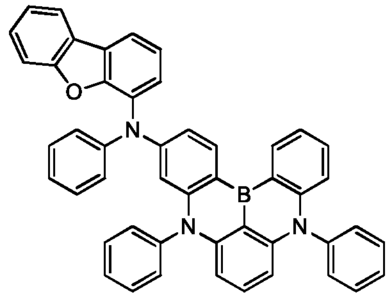

4-28

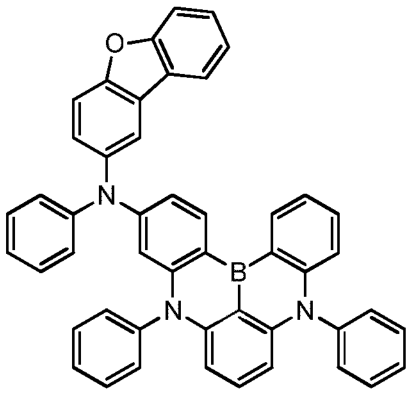

4-29

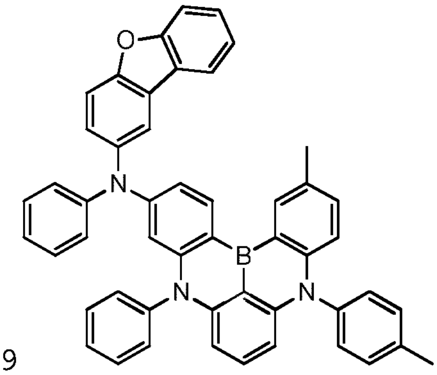

4-30

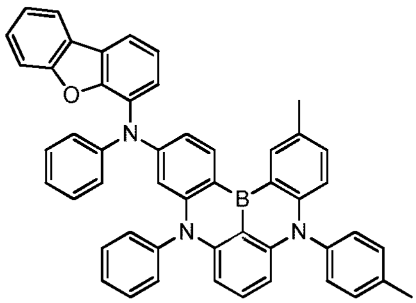

4-31

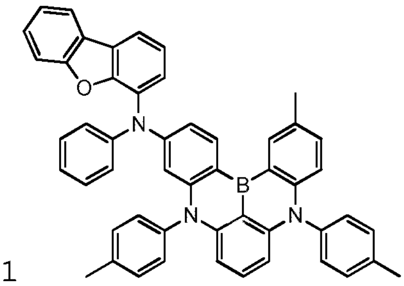

4-32

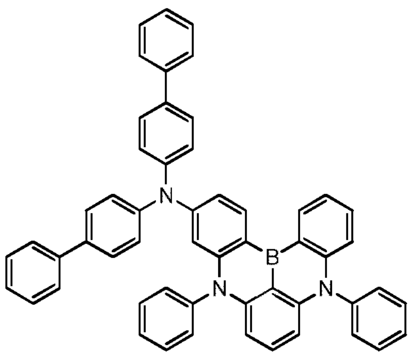

4-33

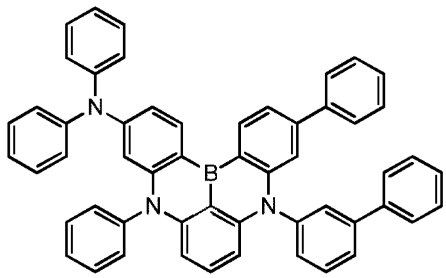

4-34

[C71]

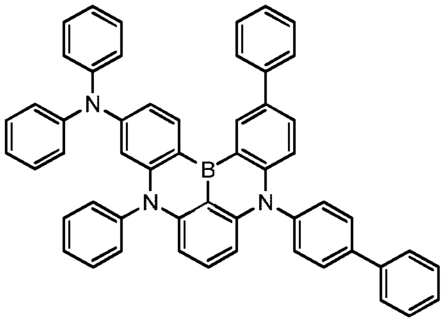
4-35

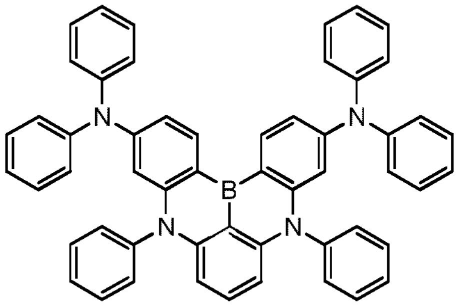
4-36

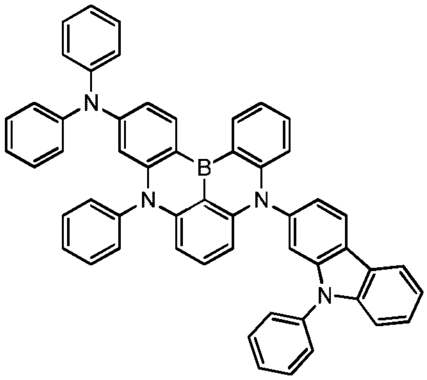
4-37

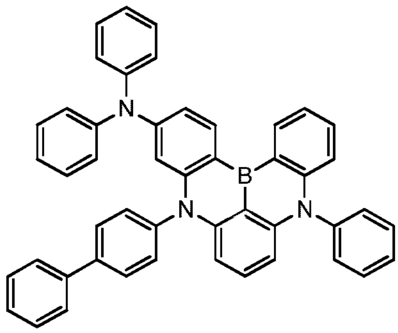
4-38

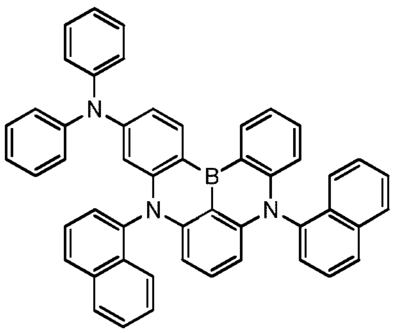
4-39

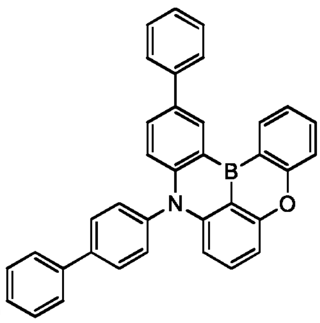
4-40

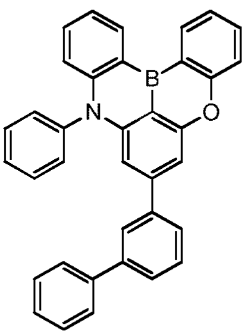
4-41

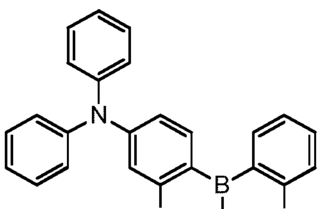
4-42

[C72]

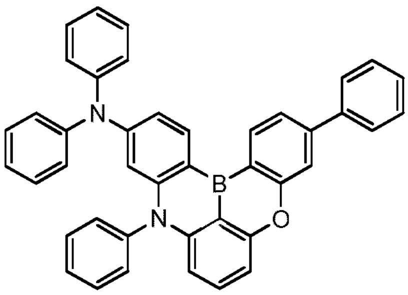
4-43

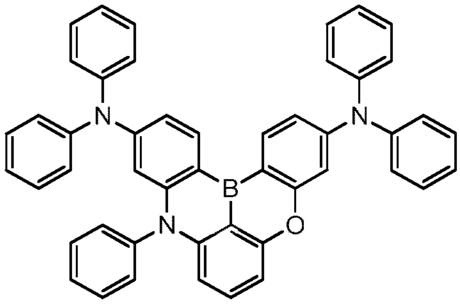
4-44

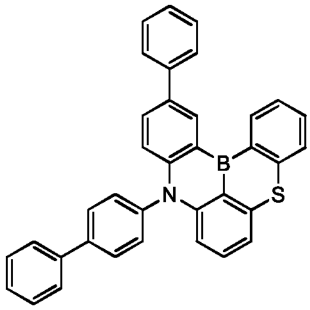
4-45

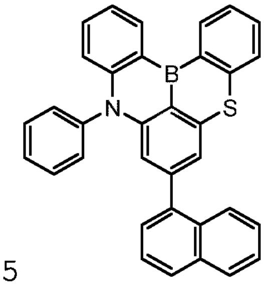
4-46

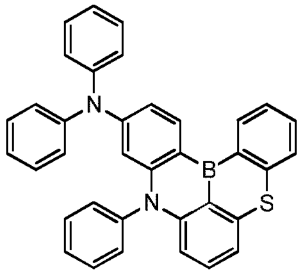
4-47

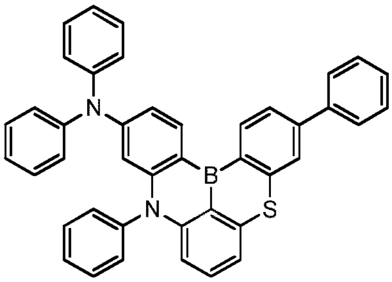
4-48

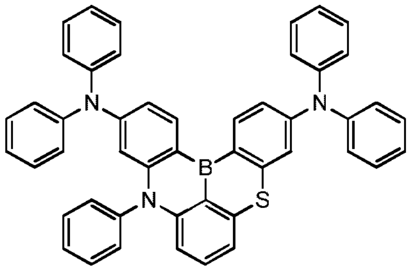
4-49

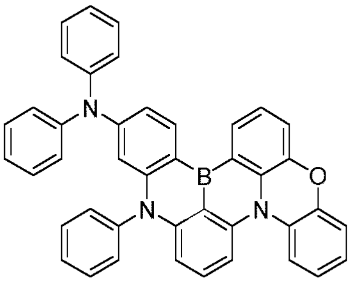
4-50

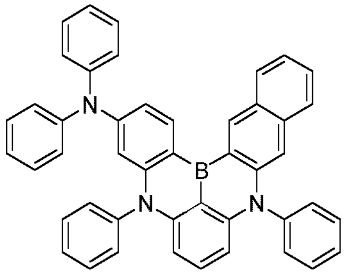
4-51

[C73]

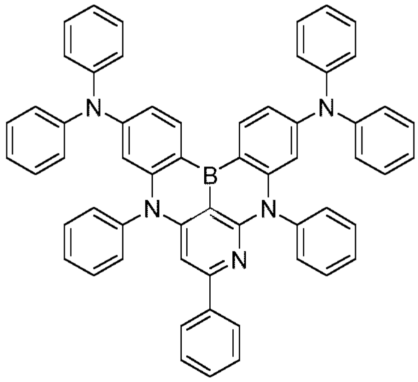
4-52

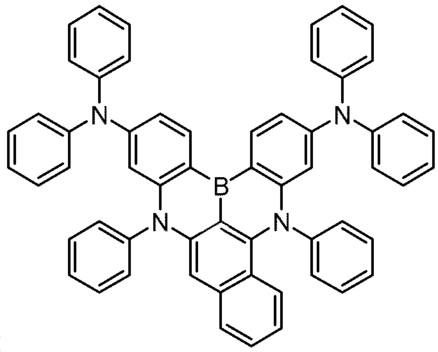
4-53

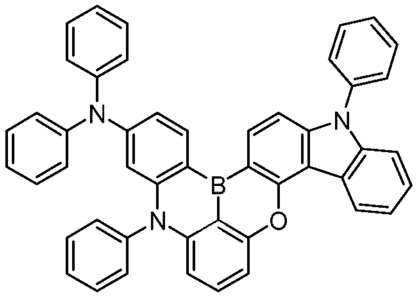
4-54

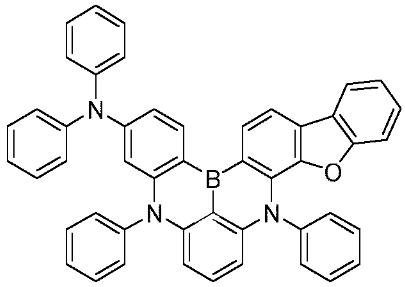
4-55

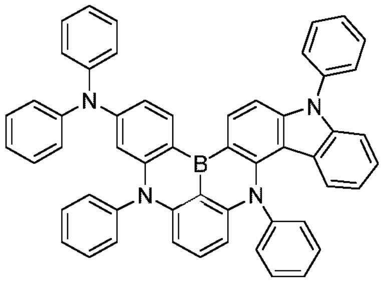
4-56

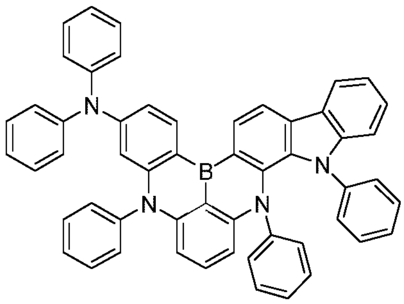
4-57

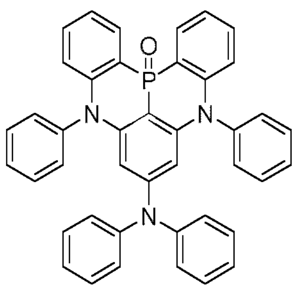
4-58

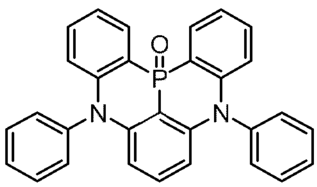
4-59

[C74]

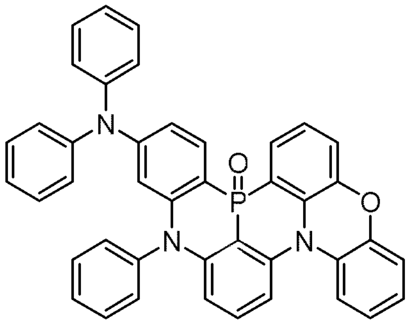
4-60

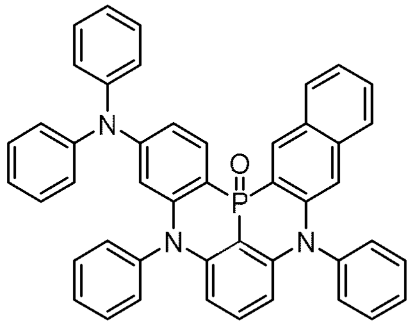
4-61

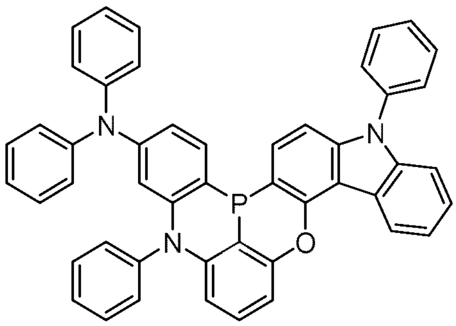
4-62

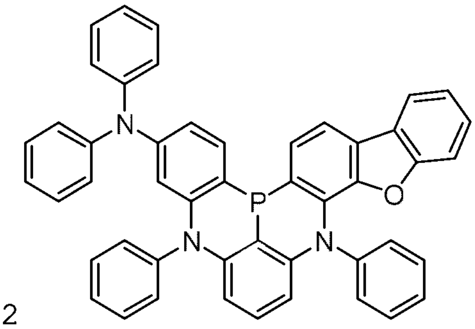
4-63

[C75]

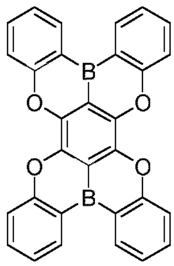
4-64

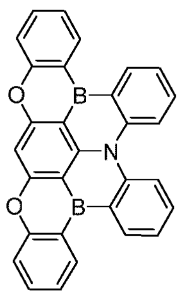
4-65

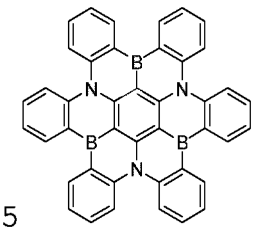
4-66

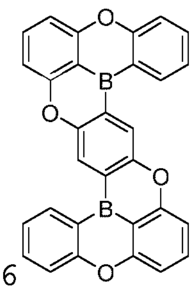
4-67

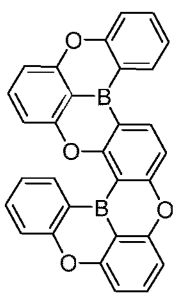
4-68

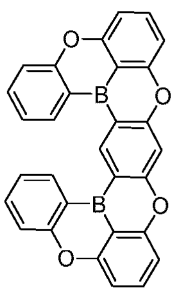
4-69

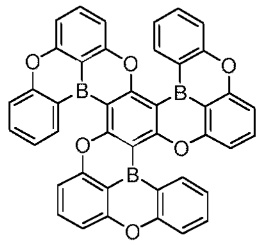
4-70

[C76]

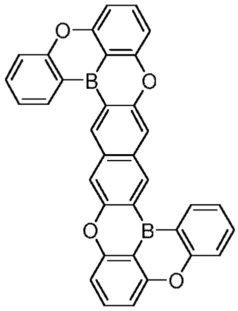 4-71 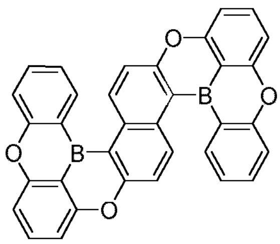 4-72 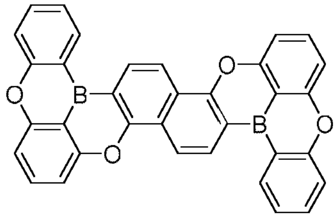 4-73

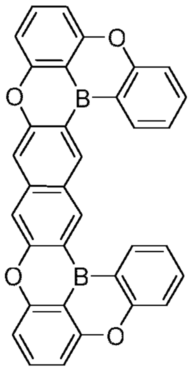 4-74 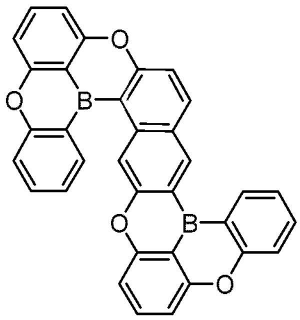 4-75 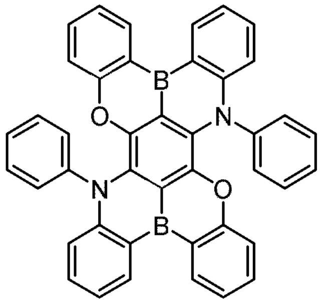 4-76

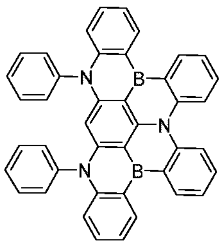 4-77 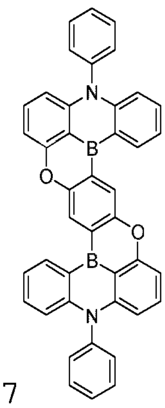 4-78 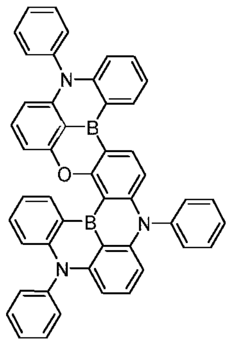 4-79 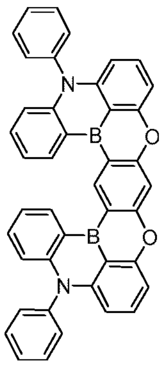 4-80

[C77]

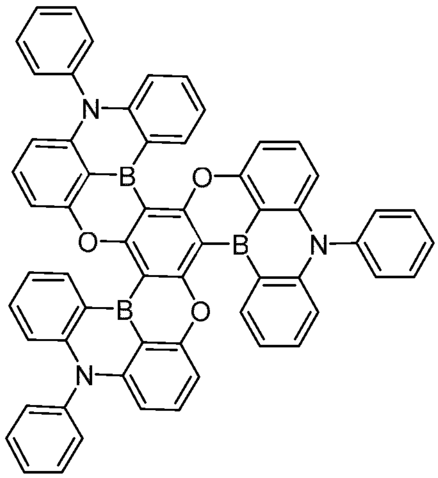
4-81

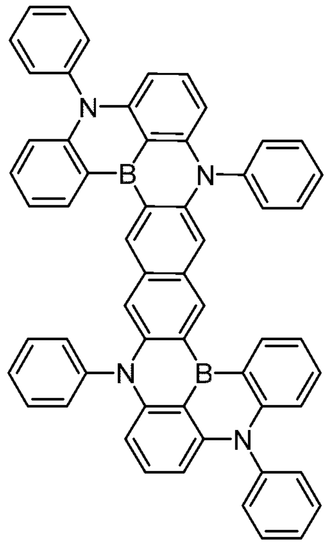
4-82

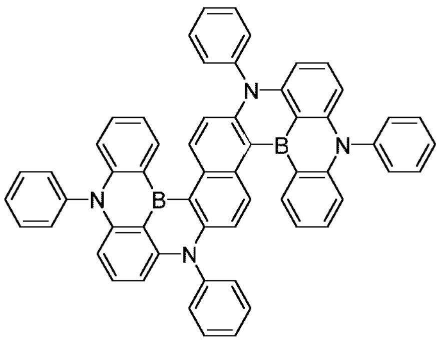
4-83

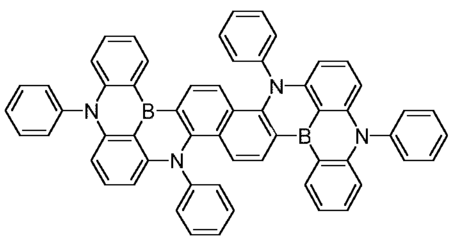
4-84

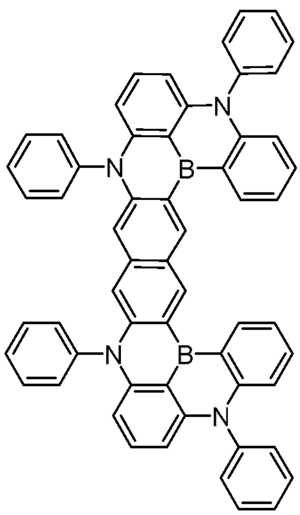
4-85

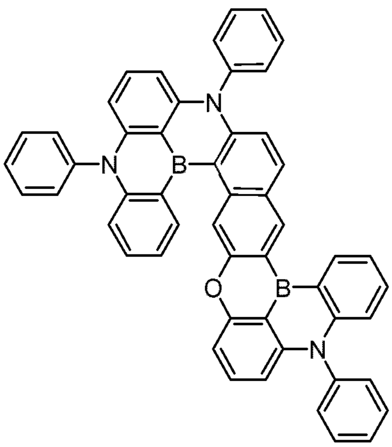
4-86

[C78]

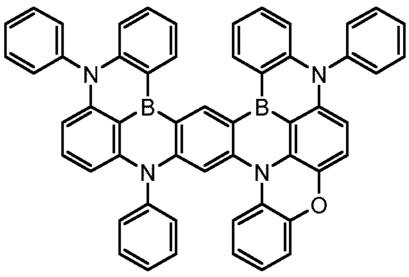

4-87

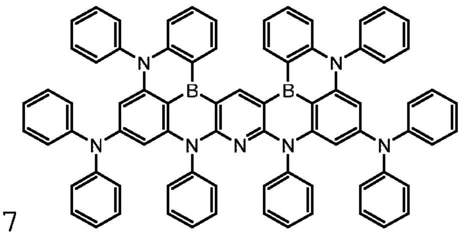

4-88

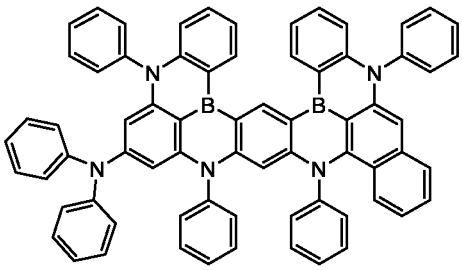

4-89

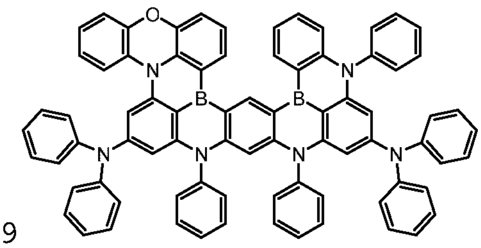

4-90

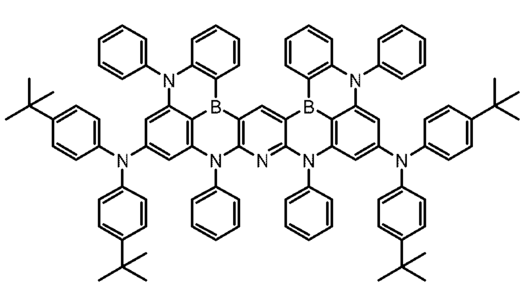

4-91

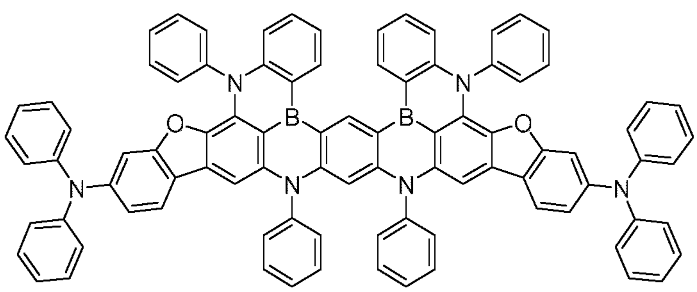

4-92

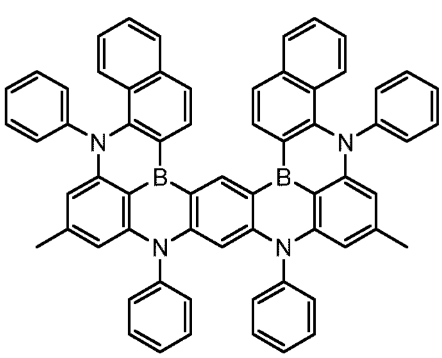

4-93

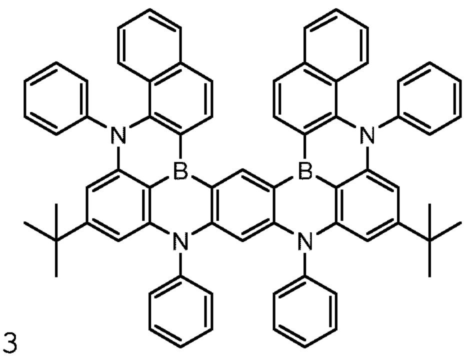

4-94

[0112]

[C79]

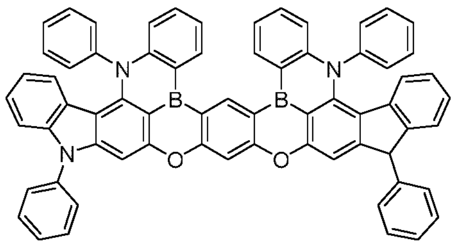

4-95

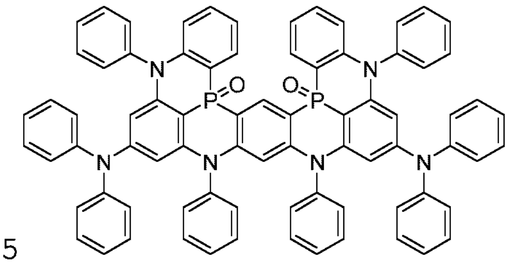

4-96

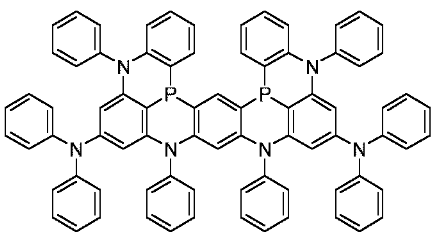

4-97

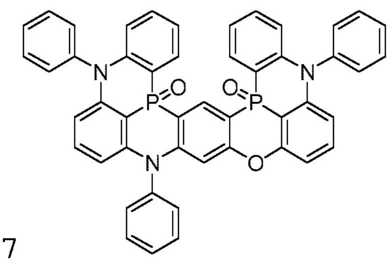

4-98

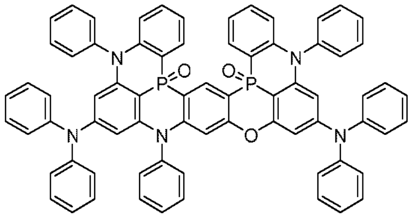

4-99

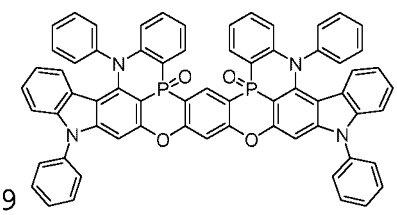

4-100

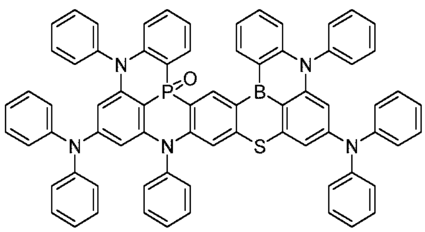

4-101

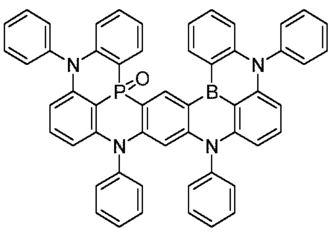

4-102

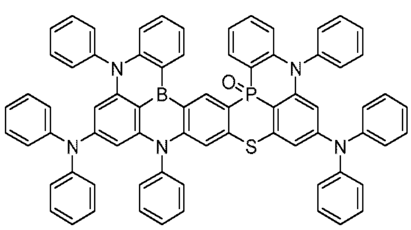

4-103

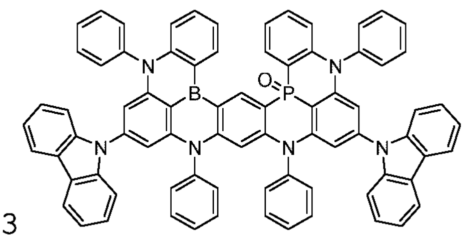

4-104

[C80]

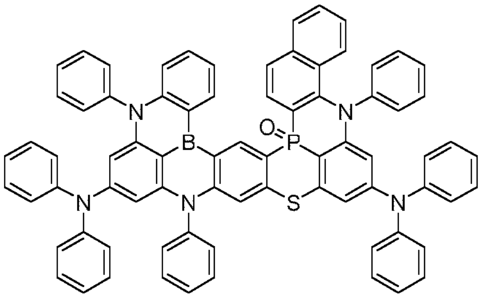
4-105

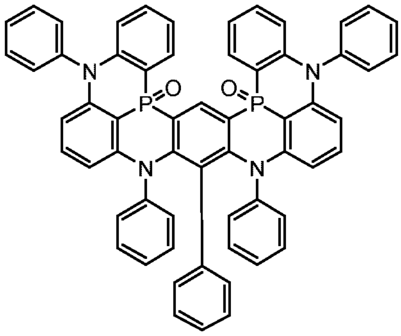
4-106

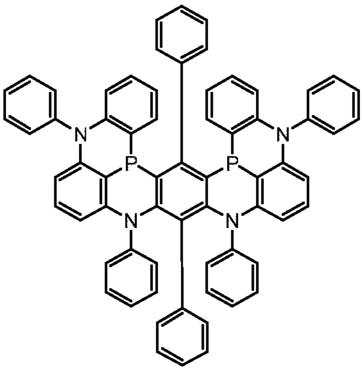
4-107

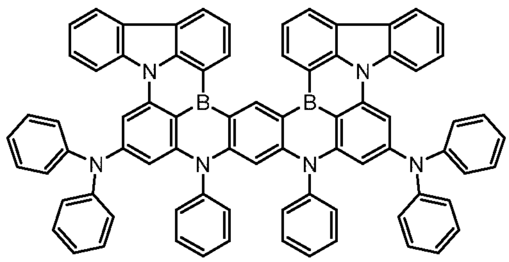
4-108

[C81]

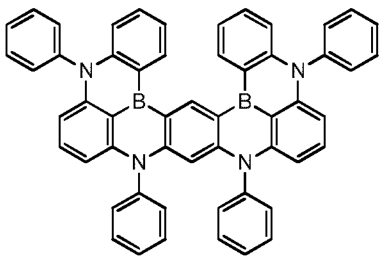
4-109

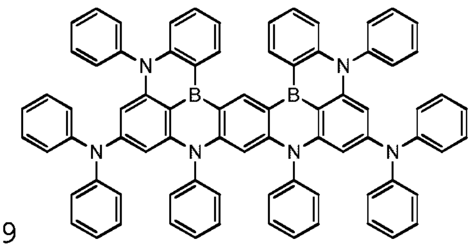
4-110

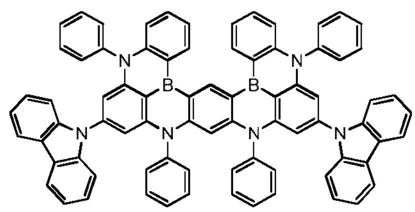
4-111

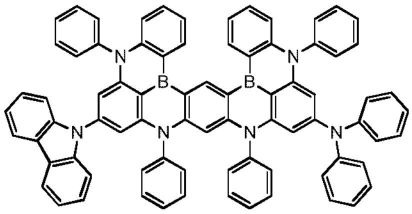
4-112

[C82]

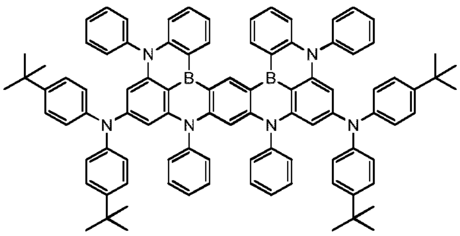
4-113

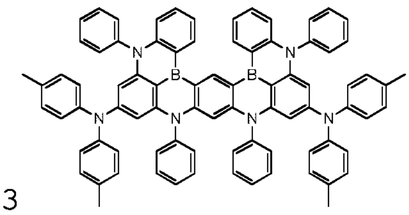
4-114

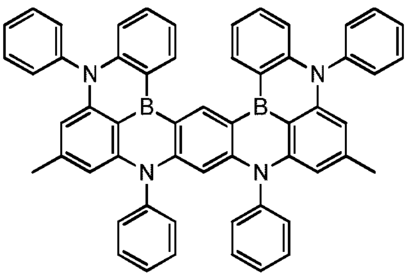
4-115

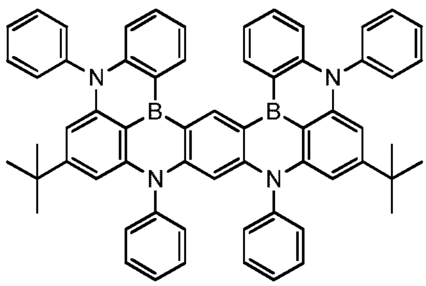
4-116

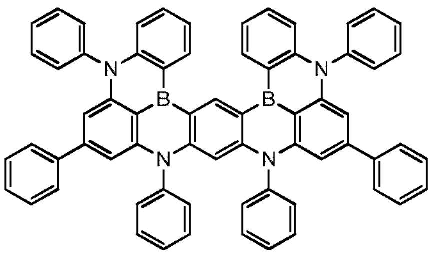
4-117

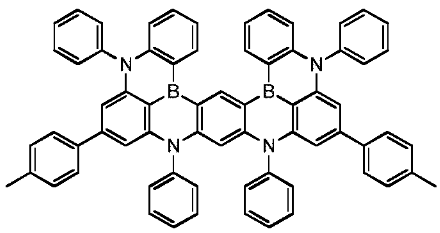
4-118

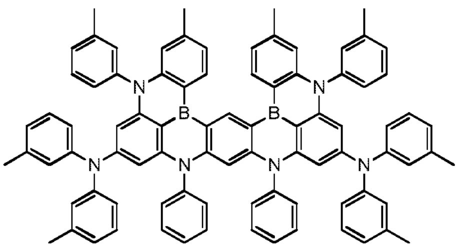
4-119

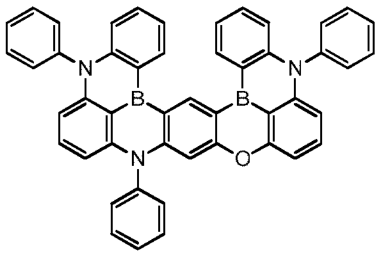
4-120

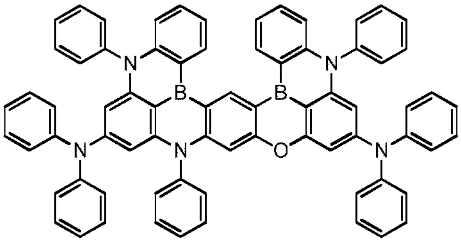
4-121

[C83]

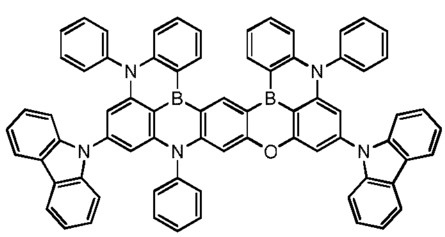

4-122

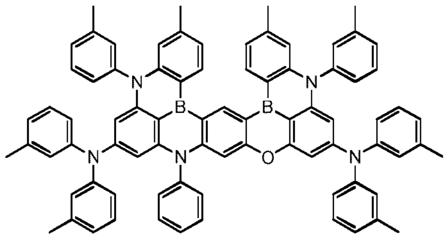

4-123

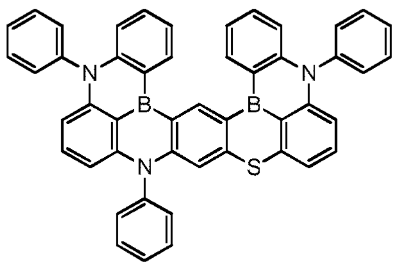

4-124

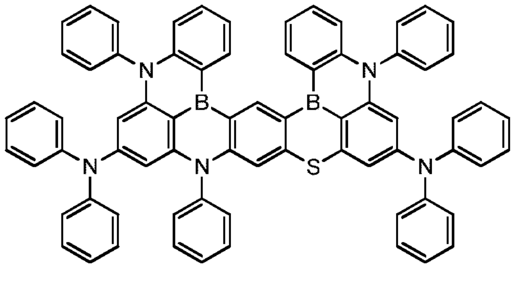

4-125

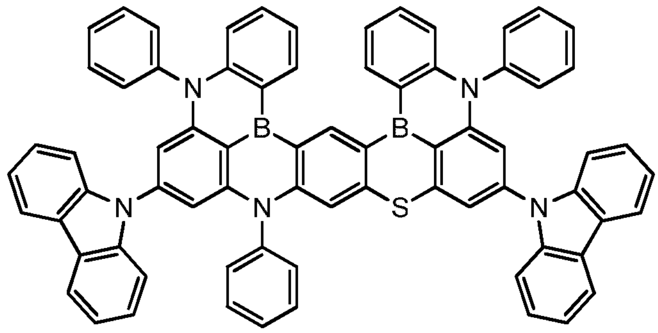

4-126

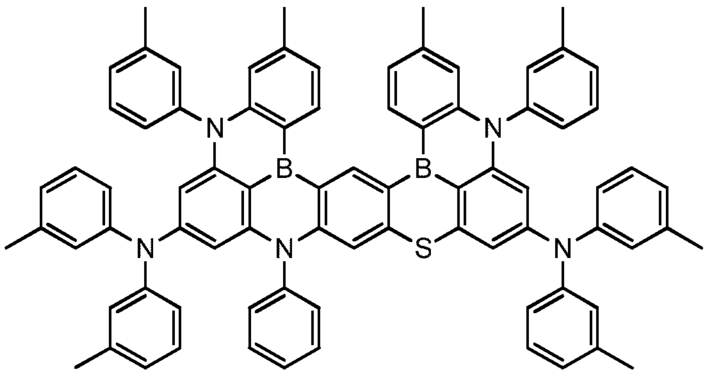

4-127

[C84]

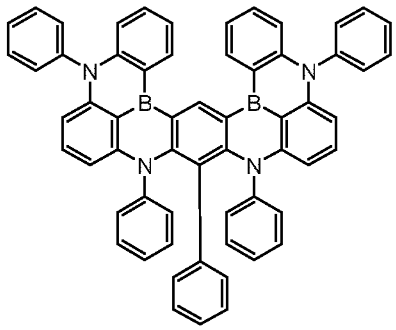

4-128

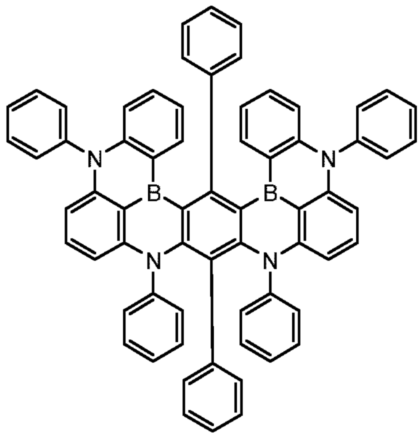

4-129

The organic emission material used as the light-emitting dopant in the organic EL element of the present invention preferably has ΔEST of 0.20 eV. ΔEST is more preferably 0.15 eV or less, and further preferably 0.10 eV.

ΔEST represents a difference between excited singlet energy (S1) and excited triplet energy (T1). Here, the measurement conditions of S1 and T1 are in accordance with the method described in Examples.

An excellent organic EL device can be provided by using a material selected from the polycyclic aromatic compounds or the substructured polycyclic aromatic compounds represented by the general formula (3) (hereinafter, also referred to as the polycyclic aromatic compound material) as the light emitting dopant, a material selected from the compounds represented by the general formula (1) or the general formula (2) as the first host, and a material selected from the compounds represented by the general formula (3) as the second host.

In another mode of the present invention, a compound having ΔEST of 0.20 eV or less is used as the light emitting dopant, with the above first and second hosts. In this case, the compound used as the light emitting dopant is not necessarily the above polycyclic aromatic compound material, and is only required to be a compound having ΔEST of 0.20 eV or less, preferably 0.15 eV or less, and more preferably 0.10 eV. Such compounds are known in many patent literatures such as Patent Literature 2 as the thermally activated delayed fluorescence (TADF) material, and hence may be selected from them.

Next, the structure of the organic EL device of the present invention will be described with reference to the drawing, but the structure of the organic EL device of the present invention is not limited thereto.

Figure 1 shows a cross-sectional view of a structure example of a typical organic EL device used in the present invention. Reference numeral 1 denotes a substrate, reference numeral 2 denotes an anode, reference numeral 3 denotes a hole injection layer, reference numeral 4 denotes a hole transport layer, reference numeral 5 denotes a light emitting layer, reference numeral 6 denotes an electron transport layer, and reference numeral 7 denotes a cathode. The organic EL device of the present invention may have an exciton blocking layer adjacent to the light emitting layer, or may have an electron blocking layer between the light emitting layer and the hole injection layer. The exciton blocking layer may be inserted on either the anode side or the cathode side of the light emitting layer or may be inserted on both sides at the same time. The organic EL device of the present invention has the anode, the light emitting layer, and the cathode as essential layers, but preferably has a hole injection/transport layer and an electron injection/transport layer in addition to the essential layers, and further preferably has a hole blocking layer between the light emitting layer and the electron injection/transport layer. The hole injection/transport layer means either or both of the hole injection layer and the hole transport layer, and the electron injection/transport layer means either or both of the electron injection layer and electron transport layer.

It is also possible to have a structure that is the reverse of the structure shown in Figure 1, that is, the cathode 7, the electron transport layer 6, the light emitting layer 5, the hole transport layer 4, and the anode 2 can be laminated on the substrate 1, in the order presented. Also, in this case, layers can be added or omitted, as necessary.

-Substrate-

The organic EL device of the present invention is preferably supported on a substrate. The substrate is not particularly limited and may be a substrate conventionally used for organic EL devices, and for example, a substrate made of glass, transparent plastic, or quartz can be used.

-Anode-

As the anode material in the organic EL device, a material made of a metal, alloy, or conductive compound having a high work function (4 eV or more), or a mixture thereof is preferably used. Specific examples of such an electrode material include metals such as Au, and conductive transparent materials such as CuI, indium tin oxide (ITO), $SnO_2$, and ZnO. An amorphous material capable of producing a transparent conductive film such as IDIXO ($In_2O_3$-ZnO) may also be used. As the anode, these electrode materials may be formed into a thin film by a method such as vapor deposition or sputtering, and then a pattern of a desired form may be formed by photolithography. Alternatively, when a highly precise pattern is not required (about 100 $\mu$m or more), a pattern may be formed through a mask of a desired form at the time of vapor deposition or sputtering of the above electrode materials. Alternatively, when a coatable material such as an organic conductive compound is used, a wet film forming method such as a printing method and a coating method can also be used. When light is extracted from the anode, the transmittance is desirably more than 10%, and the sheet resistance as the anode is preferably several hundred $\Omega$/square or less. The film thickness is selected within a range of usually 10 to 1,000 nm, and preferably 10 to 200 nm, although it depends on the material.

-Cathode-

On the other hand, a material made of a metal (referred to as an electron injection metal), alloy, or conductive compound having a low work function (4 eV or less) or a mixture thereof is used as the cathode material. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, and a rare earth metal. Among them, in terms of electron injection properties and durability against oxidation and the like, a mixture of an electron injection metal with a second metal that has a higher work function value than the electron injection metal and is stable, for example, a magnesium/silver mixture, a magnesium/aluminum mixture, a magnesium/indium mixture, an aluminum/aluminum oxide ($Al_2O_3$) mixture, a lithium/aluminum mixture, or aluminum is suitable. The cathode can be produced by forming a thin film from these cathode materials by a method such as vapor deposition and sputtering. The sheet resistance as the cathode is preferably several hundred $\Omega$/square or less, and the film thickness is selected within a range of usually 10 nm to 5 $\mu$m, and preferably 50 to 200 nm. To transmit the light emitted, either one of the anode and the cathode of the organic EL device is favorably transparent or translucent because light emission brightness is improved.

The above metal is formed to have a film thickness of 1 to 20 nm on the cathode, and then a conductive transparent material mentioned in the description of the anode is formed on the metal, so that a transparent or translucent cathode can be produced. By applying this process, a device in which both anode and cathode have transmittance can be produced.

-Light Emitting Layer-

The light emitting layer is a layer that emits light after holes and electrons respectively injected from the anode and the cathode are recombined to form excitons, and the light emitting layer includes the light emitting dopant and the hosts.

For the light emitting dopant and the hosts, 0.10 to 10% of the light emitting dopant and 99.9 to 90% of the hosts can be used, for example. Preferably, the amount of the light emitting dopant is 1.0 to 5.0% and the amount of the hosts is 99 to 95%. More preferably, the amount of the light emitting dopant is 1.0 to 3.0% and the amount of the hosts is 99 to 97%.

As used herein, % means % by mass, unless otherwise indicated.

As the hosts in the light emitting layer, the first host represented by the general formula (1) or the general formula (2) and the second host represented by the general formula (3) are used. For the first host and the second host, for example, the first host can be used in an amount of 10 to 90% and the second host can be used in an amount of 90 to 10%. Preferably, the amount of the first host is 30 to 70% and the second host is 70 to 30%. More preferably, the amount of the first host is 40 to 60% and the amount of the second host is 60 to 40%.

Further, one or more known hosts may be combined as the other hosts other than those described above, but the amount used thereof is 50% or less, and is preferably 25% or less based on the total amount of the host material.

The host is preferably a compound having the ability to transport hole, the ability to transport electron, and a high glass transition temperature, and preferably has a higher T1 than the T1 of the light emitting dopant. Specifically, T1 of the host is higher than T1 of the light emitting dopant by preferably 0.010 eV or more, more preferably 0.030 eV or more, further preferably 0.10 eV or more. Further, a TADF active compound may be used as the host material, and this compound preferably has a difference between excited singlet energy (S1) and excited triplet energy (T1) ($\Delta$EST) of 0.20 eV or less.

The above known hosts as other hosts are known in a large number of patent literatures and the like, and hence may be selected from them. Specific examples of the host include, but are not particularly limited to, various metal complexes typified by metal complexes of indole derivatives, carbazole derivatives, indolocarbazole derivatives, triazole derivatives, oxazole derivatives, oxadiazole derivatives, imidazole derivatives, phenylenediamine derivatives, arylamine derivatives, styrylanthracene derivatives, fluorenone derivatives, stilbene derivatives, triphenylene derivatives, carborane derivatives, porphyrin derivatives, phthalocyanine derivatives, and 8-quinolinol derivatives, and metal phthalocyanine, and metal complexes of benzoxazole and benzothiazole derivatives; and polymer compounds such as poly(N-vinyl carbazole)derivatives, aniline-based copolymers, thiophene oligomers, polythiophene derivatives, polyphenylene derivatives, polyphenylene vinylene derivatives, and polyfluorene derivatives.

When a plurality of hosts is used, each host is deposited from different deposition sources, or a plurality of hosts is premixed before vapor deposition to form a premix, whereby a plurality of hosts can be simultaneously deposited from one deposition source.

As the method of premixing, a method by which hosts can be mixed as uniformly as possible is desirable, and examples thereof include, but are not limited to, milling, a method of heating and melting hosts under reduced pressure or under an inert gas atmosphere such as nitrogen, and sublimation.

As the light emitting dopant in the light emitting layer, the above polycyclic aromatic compound material or an organic emission material having ΔEST of 0.20 eV or less may be used. The above polycyclic aromatic compound material that satisfies ΔEST of 0.20 eV or less is preferred.

As the light emitting dopant in the light emitting layer, the above polycyclic aromatic compound material is preferably used. The substructured polycyclic aromatic compound represented by the formula (5) is preferred, and the boron-containing substructured polycyclic aromatic compound represented by the formula (6) is more preferred. ΔEST of the above polycyclic aromatic compound material is preferably 0.20 eV or less.

The light emitting layer may contain two or more light emitting dopants. For example, a light emitting dopant consisting of the above polycyclic aromatic compound material and other compounds may be used. In this case, ΔEST of the above light emitting dopant including other compounds is preferably 0.20 eV or less, but is not limited thereto.

When two or more light emitting dopants are contained in the light emitting layer, it is possible to use the above polycyclic aromatic compound material in the first dopant and known compounds as other light emitting dopants in the second dopant, in combination. The content of the first dopant is preferably 0.05 to 50% and the second dopant is preferably 0.050 to 50% based on the host material, and the total content of the first dopant and the second dopant does not exceed 50% based on the host material.

Such other light emitting dopants are known in a large number of patent literatures and the like, and hence may be selected from them. Specific examples of the dopants include, but are not particularly limited to, fused ring derivatives such as phenanthrene, anthracene, pyrene, tetracene, pentacene, perylene, naphthopyran, dibenzopyrene, rubrene, and chrysene; benzoxazole derivatives, benzothiazole derivatives, benzimidazole derivatives, benzotriazole derivatives, oxazole derivatives, oxadiazole derivatives, thiazole derivatives, imidazole derivatives, thiadiazole derivatives, triazole derivatives, pyrazoline derivatives, stilbene derivatives, thiophene derivatives, tetraphenylbutadiene derivatives, cyclopentadiene derivatives, bisstyryl derivatives such as bisstyrylanthracene derivatives and distyrylbenzene derivatives, bisstyrylarylene derivatives, diazaindacene derivatives, furan derivatives, benzofuran derivatives, isobenzofuran derivatives, dibenzofuran derivatives, coumarin derivatives, dicyanomethylenepyran derivatives, dicyanomethylenethiopyran derivatives, polymethine derivatives, cyanine derivatives, oxobenzoanthracene derivatives, xanthene derivatives, rhodamine derivatives, fluorescein derivatives, pirylium derivatives, carbostyril derivatives, acridine derivatives, oxazine derivatives, phenylene oxide derivatives, quinacridone derivatives, quinazoline derivatives, pyrrolopyridine derivatives, furopyridine derivatives, 1,2,5-thiadiazolopyrene derivatives, pyrromethene derivatives, perynone derivatives, pyrrolopyrrole derivatives, squarylium derivatives, violanthrone derivatives, fenadine derivatives, acridone derivatives, deazaflavin derivatives, fluorene derivatives, and benzofluorene derivatives.

The organic light emitting dopant and the first host or the organic light emitting dopant and the second host may be deposited from different deposition sources, or may be premixed before vapor deposition to form a premix, whereby the light emitting dopant and the first host or the light emitting dopant and the second host can be simultaneously deposited from one deposition source.

-Injection Layer-

The injection layer refers to a layer provided between the electrode and the organic layer to reduce the driving voltage and improve the light emission brightness, and includes the hole injection layer and the electron injection layer. The injection layer may be present between the anode and the light emitting layer or the hole transport layer, as well as between the cathode and the light emitting layer or the electron transport layer. The injection layer may be provided as necessary.

-Hole Blocking Layer-

The hole blocking layer has the function of the electron transport layer in a broad sense, is made of a hole blocking material having a very small ability to transport holes while having the function of transporting electrons, and can improve the recombination probability between the electrons and the holes in the light emitting layer by blocking the holes while transporting the electrons. For the hole blocking layer, a known hole blocking material can be used. To exhibit the characteristics of the light emitting dopant, the material used as the second host can also be used as the material for the hole blocking layer. A plurality of hole blocking materials may be used in combination.

-Electron Blocking Layer-

The electron blocking layer has the function of the hole transport layer in a broad sense, and can improve the recombination probability between the electrons and the holes in the light emitting layer by blocking the electrons while transporting the holes. As the material for the electron blocking layer, a known material for the electron blocking layer can be used. To exhibit the characteristics of the light emitting dopant, the material used as the first host can also be used as the material for the electron blocking layer.
The film thickness of the electron blocking layer is preferably 3 to 100 nm, and more preferably 5 to 30 nm.

-Exciton Blocking Layer-

The exciton blocking layer is a layer to block the diffusion of the excitons generated by recombination of the holes and the electrons in the light emitting layer into a charge transport layer, and insertion of this layer makes it possible to efficiently keep the excitons in the light emitting layer, so that the emission efficiency of the device can be improved. The exciton blocking layer can be inserted between two light emitting layers adjacent to each other in the device in which two or more light emitting layers are adjacent to each other.
As the material for the exciton blocking layer, a known material for the exciton blocking layer can be used.
The layer adjacent to the light emitting layer includes the hole blocking layer, the electron blocking layer, and the exciton blocking layer, and when these layers are not provided, the adjacent layer is the hole transport layer, the electron transport layer, and the like.

-Hole Transport Layer-

The hole transport layer is made of a hole transport material having the function of transporting holes, and the hole transport layer may be provided as a single layer or a plurality of layers.
The hole transport material has any of hole injection properties, hole transport properties, or electron barrier properties, and may be either an organic material or an inorganic material. As the hole transport layer, any of conventionally known compounds may be selected and used. Examples of such a hole transport material include porphyrin derivatives, arylamine derivatives, triazole derivatives, oxadiazole derivatives, imidazole derivatives, polyarylalkane derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline-based copolymers, and conductive polymer oligomers, particularly, thiophene oligomers. Porphyrin derivatives, arylamine derivatives, and styrylamine derivatives are preferably used, and arylamine compounds are more preferably used.

-Electron Transport Layer-

The electron transport layer is made of a material having the function of transporting electrons, and the electron transport layer may be provided as a single layer or a plurality of layers.
The electron transport material (may also serve as the hole blocking material) has the function of transmitting electrons injected from the cathode to the light emitting layer. As the electron transport layer, any of conventionally known compounds may be selected and used, and examples thereof include polycyclic aromatic derivatives such as naphthalene, anthracene, and phenanthroline, tris(8-quinolinolato)aluminum (III) derivatives, phosphine oxide derivatives, nitro-substituted fluorene derivatives, diphenylquinone derivatives, thiopyran dioxide derivatives, carbodiimides, fluorenylidene methane derivatives, anthraquinodimethane and anthrone derivatives, bipyridine derivatives, quinoline derivatives, oxadiazole derivatives, benzimidazole derivatives, benzothiazole derivatives, and indolocarbazole derivatives. Further, polymer materials in which these materials are introduced in the polymer chain or these materials constitute the main chain of the polymer can also be used.
When the organic EL device of the present invention is produced, the film formation method of each layer is

not particularly limited, and the layers may be produced by either a dry process or a wet process.

Examples

Hereinafter, the present invention will be described in further detail with reference to Examples, but the present invention is not limited to these Examples.

The compounds used in Examples and Comparative Examples are shown below.

[C85]

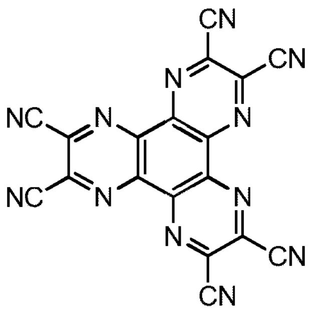

HAT-CN

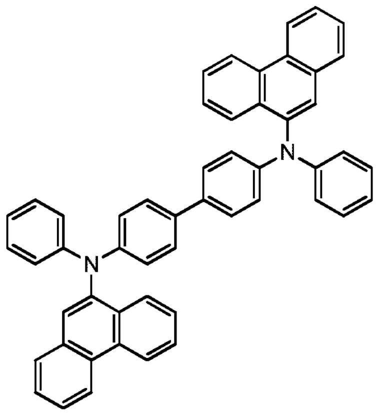

HT-1

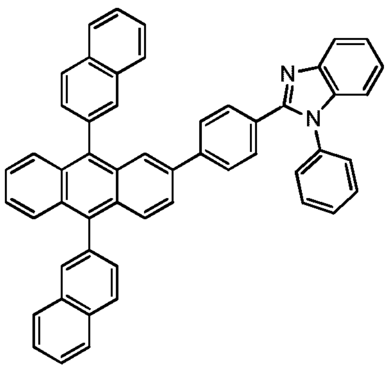

ET-1

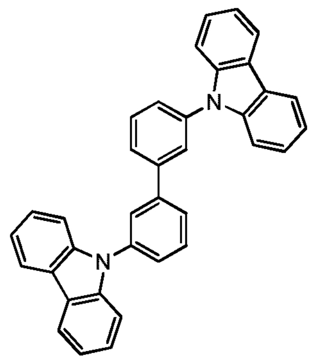

mCBP

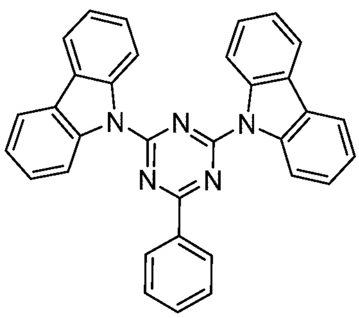

HB1

S1 and T1 of the compounds (4-2) and (4-10) were measured.

S1 and T1 were measured as follows.

compound (2-30) as a host and the compound (4-2) or (4-110) as a light emitting dopant were co-deposited on a quartz substrate from different deposition sources by a vacuum deposition method under conditions of a degree of vacuum of $10^{-4}$ Pa or less to form a deposition film having a thickness of 100 nm. At this time, they were co-deposited under deposition conditions such that the concentration of the compound (4-2) or (4-110) was 3%.

For S1, the emission spectrum of this deposition film was measured, a tangent was drawn to the rise of the emission spectrum on the short-wavelength side, and the wavelength value λedge [nm] of the point of intersection of the tangent and the horizontal axis was substituted into the following equation (i) to calculate S1.

$$S1\ [eV] = 1239.85/\lambda edge \qquad (i)$$

For T1, the phosphorescence spectrum of the above deposition film was measured, a tangent was drawn to the rise of the phosphorescence spectrum on the short-wavelength side, and the wavelength value λedge [nm] of the point of intersection of the tangent and the horizontal axis was substituted into the following equation (ii) to calculate T1.

$$T1\ [eV] = 1239.85/\lambda edge \qquad (ii)$$

The measurement results are shown in Table 1.

[Table 1]

| Compound | S1 (eV) | T1 (eV) | S1-T1 (eV) |
|---|---|---|---|
| 4-2 | 2.79 | 2.61 | 0.18 |
| 4-110 | 2.71 | 2.67 | 0.04 |

Example 1

Each thin film was laminated on the glass substrate on which an anode made of ITO having a film thickness of 70 nm was formed by a vacuum deposition method at a degree of vacuum of $4.0 \times 10^{-5}$ Pa. First, HAT-CN was formed on ITO to a thickness of 10 nm as a hole injection layer, and then HT-1 was formed to a thickness of 25 nm as a hole transport layer. Then, a compound (1-77) was formed to a thickness of 5 nm as an electron blocking layer. Then, the compound (1-77) as the first host, a compound (3-3) as the second host, and the compound (4-110) as the light emitting dopant were co-deposited from different deposition sources to form a light emitting layer having a thickness of 30 nm. At this time, they were co-deposited under deposition conditions such that the concentration of the compound (4-110) was 2% and the weight ratio of the first host to the second host was 50:50. Then, compound (HB1) was formed to a thickness of 5 nm as a hole blocking layer. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device was produced.

Examples 2 to 16

Each organic EL device was produced in the same manner as in Example 1, except that the light emitting dopant, the first host, and the second host, as well as the weight ratio of the first host to the second host were changed to the compounds shown in Table 2.

Comparative Example 1

Each thin film was laminated on the glass substrate on which an anode made of ITO having a film thickness of 70 nm was formed, by a vacuum deposition method at a degree of vacuum of $4.0 \times 10^{-5}$ Pa. First, HAT-CN was formed on ITO to a thickness of 10 nm as a hole injection layer, and then HT-1 was formed to a thickness of 25 nm as a hole transport layer. Then, the compound (2-30) was formed to a thickness of 5 nm as an electron blocking layer. Then, the compound (1-77) as the first host and the compound (4-110) as the light emitting dopant were co-deposited from different deposition sources to form a light emitting layer having a thickness of 30 nm. At this time, they were co-deposited under deposition conditions such that the concentration of the compound (4-110) was 2%. Then, the compound (HB1) was formed to a thickness of 5 nm as a hole blocking layer. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device was produced.

Comparative Examples 2, 3, 4, 7, 8, and 9

Each organic EL device was produced in the same manner as in Comparative Example 1, except that the light emitting dopant and the first host (no second host) were changed to the compounds shown in Table 2.

Comparative Examples 5, 6, and 10

Each organic EL device was produced in the same manner as in Example 1, except that the light emitting dopant, the first host, and the second host were changed to the compounds shown in Table 2.

[Table 2]

| | Dopant | First host | Second host |
|---|---|---|---|
| Example 1 | 4-110 | 1-77 (50%) | 3-3(50%) |
| Example 2 | 4-110 | 1-77 (30%) | 3-3(70%) |
| Example 3 | 4-110 | 1-77 (70%) | 3-3(30%) |
| Example 4 | 4-110 | 1-132(50%) | 3-3 (50%) |
| Example 5 | 4-110 | 2-14(50%) | 3-1(50%) |
| Example 6 | 4-110 | 2-30(50%) | 3-3(50%) |
| Example 7 | 4-110 | 2-22(50%) | 3-77(50%) |
| Example 8 | 4-110 | 2-27(50%) | 3-111(50%) |
| Example 9 | 4-2 | 1-77(50%) | 3-3(50%) |
| Example 10 | 4-110 | 1-77 (50%) | 3-162 (50%) |
| Example 11 | 4-110 | 1-89 (50%) | 3-3(50%) |
| Example 12 | 4-110 | 1-77 (70%) | 3-24(30%) |
| Example 13 | 4-110 | 1-77 (70%) | 3-43(30%) |
| Example 14 | 4-110 | 2-30 (70%) | 3-188 (30%) |
| Example 15 | 4-110 | 1-77 (70%) | 3-77(30%) |
| Example 16 | 4-110 | 1-153(70%) | 3-79(30%) |
| Comp. Example 1 | 4-110 | 1-77 | - |
| Comp. Example 2 | 4-110 | 3-3 | - |
| Comp. Example 3 | 4-110 | 2-30 | |
| Comp. Example 4 | 4-110 | mCBP | - |
| Comp. Example 5 | 4-110 | mCBP(50%) | 3-3(50%) |
| Comp. Example 6 | 4-110 | mCBP(50%) | 3-162(50%) |
| Comp. Example 7 | 4-2 | 1-77 | |
| Comp. Example 8 | 4-2 | 3-3 | |
| Comp. Example 9 | 4-2 | mCBP | |
| Comp. Example 10 | 4-2 | mCBP(50%) | 3-162(50%) |

The voltage, maximum emission wavelength of the emission spectrum, external quantum efficiency, and lifetime of each organic EL device produced in Examples and Comparative Examples are shown in Table 3. The voltage, the maximum emission wavelength, and the external quantum efficiency were values at luminance of 500 cd/$m^2$ and were initial characteristics. The time taken for the luminance to reduce to 50% of the initial luminance when the initial luminance was 500 cd/$m^2$ was measured as the lifetime.

[Table 3]

| | Voltage (V) | Maximum emission wavelength (nm) | External quantum efficiency (%) | Lifetime (h) |
|---|---|---|---|---|
| Example 1 | 3.8 | 472 | 24.1 | 211 |

(continued)

| | Voltage (V) | Maximum emission wavelength (nm) | External quantum efficiency (%) | Lifetime (h) |
|---|---|---|---|---|
| Example 2 | 3.8 | 472 | 24.6 | 205 |
| Example 3 | 3.8 | 473 | 21.1 | 199 |
| Example 4 | 3.8 | 471 | 24.4 | 132 |
| Example 5 | 3.9 | 472 | 23.6 | 104 |
| Example 6 | 3.8 | 470 | 22.1 | 188 |
| Example 7 | 3.7 | 472 | 23.9 | 240 |
| Example 8 | 3.7 | 473 | 21.9 | 228 |
| Example 9 | 3.8 | 462 | 19.0 | 113 |
| Example 10 | 3.7 | 472 | 21.0 | 101 |
| Example 11 | 3.8 | 472 | 20.2 | 156 |
| Example 12 | 3.9 | 472 | 19.1 | 147 |
| Example 13 | 3.9 | 472 | 19.3 | 200 |
| Example 14 | 3.9 | 472 | 22.2 | 215 |
| Example 15 | 3.9 | 472 | 23.5 | 223 |
| Example 16 | 3.9 | 472 | 23.9 | 197 |
| Comp. Example 1 | 4.5 | 473 | 23.0 | 50 |
| Comp. Example 2 | 4.0 | 471 | 18.9 | 26 |
| Comp. Example 3 | 4.7 | 471 | 13.6 | 18 |
| Comp. Example 4 | 4.0 | 472 | 17.2 | 31 |
| Comp. Example 5 | 4.1 | 472 | 12.3 | 10 |
| Comp. Example 6 | 4.2 | 460 | 13.3 | 70 |
| Comp. Example 7 | 4.8 | 459 | 8.5 | 8 |
| Comp. Example 8 | 4.4 | 461 | 10.2 | 32 |
| Comp. Example 9 | 4.0 | 461 | 9.2 | 32 |
| Comp. Example 10 | 4.2 | 461 | 8.3 | 5 |

It is found from Table 3 that the organic EL devices of Examples of the present invention have high efficiency and long lifetime characteristics and it is also found from the maximum emission wavelength that they exhibit blue light emission.

Reference Signs List

1 substrate, 2 the anode, 3 hole injection layer, 4 hole transport layer, 5 light emitting layer, 6 electron transport layer, 7 cathode

## Claims

1. An organic electroluminescent device comprising one or more light emitting layers between an anode and a cathode opposite to each other, wherein at least one of the light emitting layers contains hosts and a light emitting dopant, the hosts include a first host represented by the general formula (1) or the general formula (2) and a second host represented by the general formula (3); and the light emitting dopant contains a polycyclic aromatic compound represented by the general formula (4) or a polycyclic aromatic compound having a structure represented by the general formula (4) as a partial structure:

[C1]

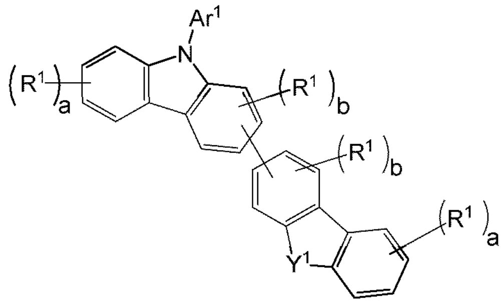

(1)

wherein $Y^1$ represents O, S, or N-$Ar^1$;
$Ar^1$ independently represents a substituted or unsubstituted aromatic hydrocarbon group having 6 to 18 carbon atoms, a substituted or unsubstituted aromatic heterocyclic group having 3 to 17 carbon atoms, or a linked aromatic group formed by linking 2 to 8 aromatic rings thereof;
$R^1$ independently represents deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms;
a independently represents an integer of 0 to 4; and
b independently represents an integer of 0 to 3,

[C2]

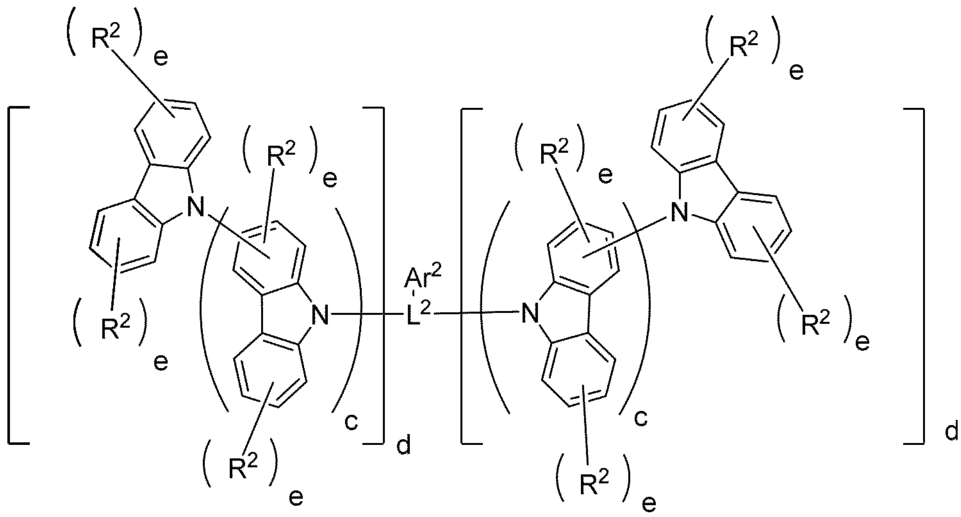

(2)

wherein c is independently an integer of 0 to 5; d is independently an integer of 0 to 2 and at least one d is 1 or more; e is independently an integer of 0 to 2;

$R^2$ is independently a cyano group, an aliphatic hydrocarbon group having 1 to 10 carbon atoms, or a substituted or unsubstituted aromatic hydrocarbon group having 6 to 18 carbon atoms;

$L^2$ is a substituted or unsubstituted aromatic hydrocarbon group having 6 to 18 carbon atoms or a substituted or unsubstituted aromatic heterocyclic group having 3 to 17 carbon atoms; and

$Ar^2$ is hydrogen, a cyano group, an aliphatic hydrocarbon group having 1 to 10 carbon atoms, a substituted or unsubstituted aromatic hydrocarbon group having 6 to 18 carbon atoms, a substituted or unsubstituted aromatic heterocyclic group having 3 to 17 carbon atoms, or a linked aromatic group in which 2 to 3 of these aromatic rings are linked to each other,

[C3]

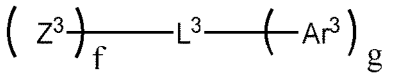

(3)

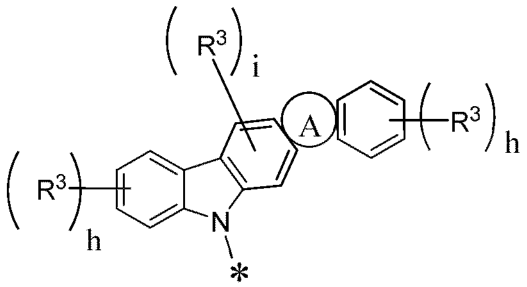

(3a)

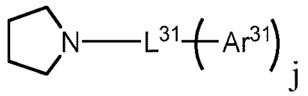

(3b)

wherein $Z^3$ is an indolocarbazole ring-containing group represented by the formula (3a);

* is a bonding site to $L^3$;

the ring A is a heterocyclic ring represented by the formula (3b) and is fused with an adjacent ring at an arbitrary position;

each of $L^3$ and $L^{31}$ is independently a substituted or unsubstituted aromatic hydrocarbon group having 6 to 30 carbon atoms or a substituted or unsubstituted aromatic heterocyclic group having 3 to 17 carbon atoms;

each of $Ar^3$ and $Ar^{31}$ is independently a substituted or unsubstituted aromatic hydrocarbon group having 6 to 30 carbon atoms, a substituted or unsubstituted aromatic heterocyclic group having 3 to 17 carbon atoms, or a linked aromatic group in which 2 to 8 of these aromatic rings are linked to each other;

$R^3$ is independently an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms;

f represents an integer of 1 to 3; g represents an integer of 0 to 3; h independently represents an integer of 0 to 4; i represents an integer of 0 to 2; and j represents an integer of 0 to 3,

[C4]

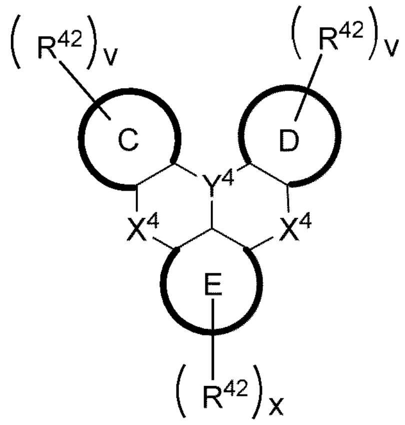

(4)

wherein the ring C, the ring D, and the ring E are independently an aromatic hydrocarbon ring having 6 to 24 carbon atoms or an aromatic heterocyclic ring having 3 to 17 carbon atoms;
$Y^4$ is B, P, P=O, P=S, AL, Ga, As, Si-$R^4$, or Ge-$R^{41}$;
$X^4$ is independently O, N-$Ar^4$, S, or Se;
each of $R^4$ and $R^{41}$ is independently an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms;
$Ar^4$ is independently a substituted or unsubstituted aromatic hydrocarbon group having 6 to 18 carbon atoms, a substituted or unsubstituted aromatic heterocyclic group having 3 to 17 carbon atoms, or a linked aromatic group in which 2 to 8 of these aromatic rings are linked to each other; N-$Ar^4$ is optionally bonded to the ring C, the ring D, or the ring E to form a heterocyclic ring containing N;
each $R^{42}$ independently represents a cyano group, deuterium, a diarylamino group having 12 to 44 carbon atoms, an arylheteroarylamino group having 12 to 44 carbon atoms, a diheteroarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms;
each v independently represents an integer of 0 to 4; x represents an integer of 0 to 3; and
at least one hydrogen in the ring C, the ring D, the ring E, $R^4$, $R^{41}$, $R^{42}$, and $Ar^4$ is optionally replaced with a halogen or deuterium.

**2.** The organic electroluminescent device according to claim 1, wherein the polycyclic aromatic compound having a structure represented by the general formula (4) as a partial structure is a polycyclic aromatic compound represented by the following general formula (5):

[C5]

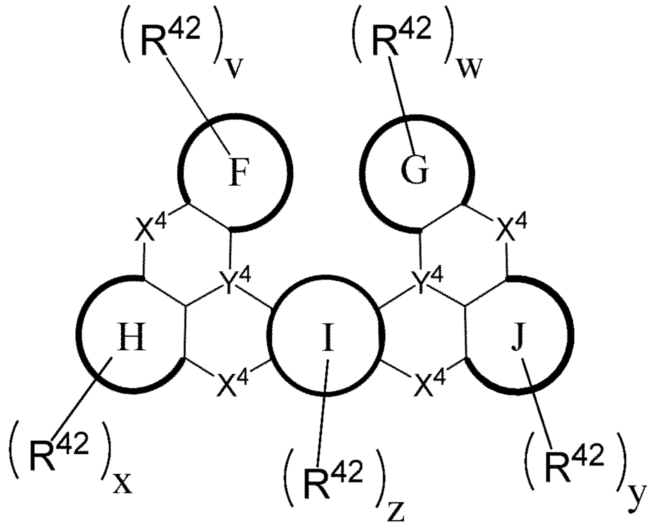

(5)

wherein each of the ring F, the ring G, the ring H, the ring I, and the ring J is independently an aromatic hydrocarbon ring having 6 to 24 carbon atoms or an aromatic heterocyclic ring having 3 to 17 carbon atoms; at least one hydrogen in the ring F, the ring G, the ring H, the ring I, and the ring J is optionally replaced with a halogen or deuterium;

$X^4$, $Y^4$, $R^{42}$, x, and v are as defined in the general formula (4); w represents an integer of 0 to 4; y represents an integer of 0 to 3; and z represents an integer of 0 to 2.

**3.** The organic electroluminescent device according to claim 1 or 2, wherein the polycyclic aromatic compound having a structure represented by the general formula (4) as a partial structure is a boron-containing polycyclic aromatic compound represented by the following formula (6) :

[C6]

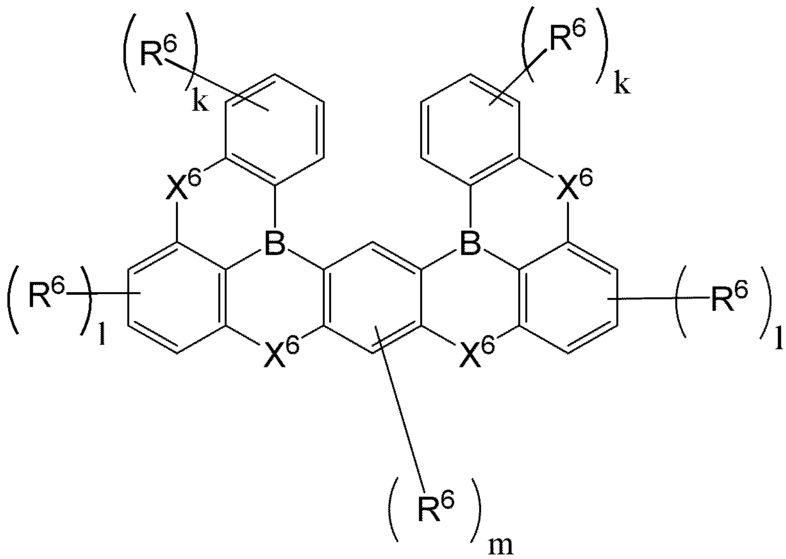

(6)

wherein $X^6$ independently represents N-$Ar^6$, O, or S, provided that at least one $X^6$ represents N-$Ar^6$;

$Ar^6$ independently represents a substituted or unsubstituted aromatic hydrocarbon group having 6 to 18 carbon atoms, a substituted or unsubstituted aromatic heterocyclic group having 3 to 17 carbon atoms, or a linked aromatic group formed by linking 2 to 8 aromatic rings thereof; N-$Ar^6$ is optionally bonded to an aromatic ring to which $X^6$ is bonded to form a heterocyclic ring containing N;

$R^6$ independently represents a cyano group, deuterium, a diarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms;

k independently represents an integer of 0 to 4; 1 independently represents an integer of 0 to 3; and m represents an integer of 0 to 2.

**4.** The organic electroluminescent device according to any one of claims 1 to 3, comprising the first host represented by the general formula (1).

**5.** The organic electroluminescent device according to any one of claims 1 to 4, wherein $Y^1$ in the general formula (1) is N-$Ar^1$.

**6.** The organic electroluminescent device according to claim 5, wherein the general formula (1) is the following formula (7):

[C7]

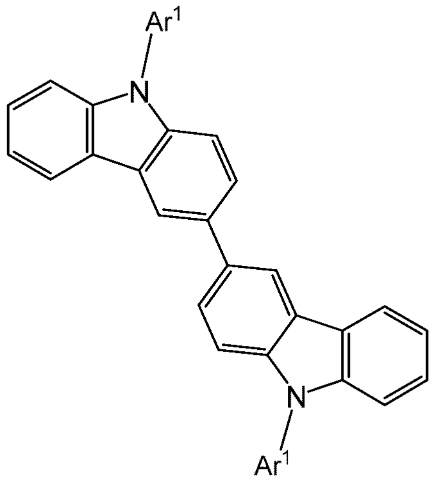

(7)

wherein $Ar^1$ is as defined in the general formula (1).

**7.** The organic electroluminescent device according to any one of claims 1 to 6, wherein the light emitting layer contains the first host represented by the general formula (2) and the second host represented by the general formula (3).

**8.** The organic electroluminescent device according to any one of claims 1 to 7, wherein the general formula (2) is the following formula (8):

[C8]

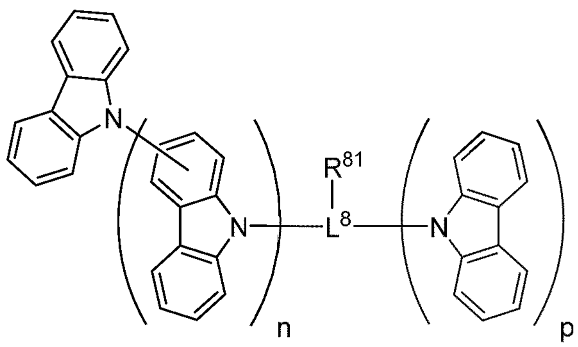

(8)

wherein n is an integer of 1 to 5; p is an integer of 0 to 1;
$L^8$ represents a group produced from benzene, dibenzofuran, or dibenzothiophene; and
$R^{81}$ represents hydrogen or a group produced from benzene, dibenzofuran, or dibenzothiophene.

**9.** The organic electroluminescent device according to any one of claims 1 to 8, wherein f in the general formula (3) is 1.

**10.** The organic electroluminescent device according to any one of claims 1 to 9, wherein the light emitting dopant has a difference between excited singlet energy (S1) and excited triplet energy (T1) (ΔEST) of 0.20 eV or less.

**11.** The organic electroluminescent device according to claim 10, wherein ΔEST is 0.10 eV or less.

**12.** The organic electroluminescent device according to claims 1 to 11, wherein 99.9 to 90 wt% of the hosts and 0.1 to 10 wt% of the light-emitting dopant are contained, and the first host is contained in an amount of 10 to 90 wt% and the second host is contained in an amount of 90 to 10 wt%, based on the hosts.

**13.** An organic electroluminescent device comprising one or more light emitting layers between an anode and a cathode opposite to each other, wherein at least one of the light emitting layers contains a first host represented by the general formula (1) or the general formula (2), a second host represented by the general formula (3), and a light emitting dopant having ΔEST of 0.20 eV or less:

[C9]

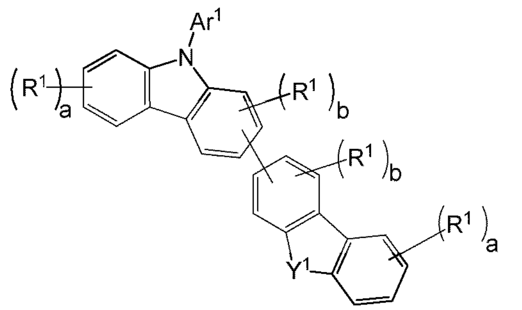

(1)

wherein $Y^1$ represents O, S, or N-$Ar^1$;
$Ar^1$ independently represents a substituted or unsubstituted aromatic hydrocarbon group having 6 to 18 carbon atoms, a substituted or unsubstituted aromatic heterocyclic group having 3 to 17 carbon atoms, or a linked aromatic group formed by linking 2 to 8 aromatic rings thereof;
$R^1$ independently represents deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms;
a independently represents an integer of 0 to 4; and
b independently represents an integer of 0 to 3,

[C10]

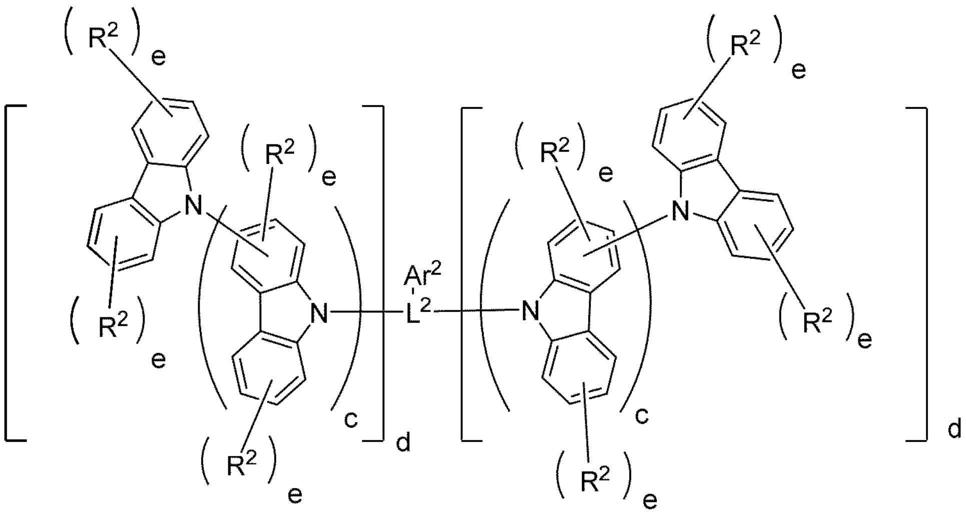

(2)

wherein c is independently an integer of 0 to 5; d is independently an integer of 0 to 2 and at least one d is 1 or more; e is independently an integer of 0 to 2;
$R^2$ is independently a cyano group, an aliphatic hydrocarbon group having 1 to 10 carbon atoms, or a substituted or unsubstituted aromatic hydrocarbon group having 6 to 18 carbon atoms;
$L^2$ is a substituted or unsubstituted aromatic hydrocarbon group having 6 to 18 carbon atoms or a substituted or unsubstituted aromatic heterocyclic group having 3 to 17 carbon atoms;
$Ar^2$ is hydrogen, a cyano group, an aliphatic hydrocarbon group having 1 to 10 carbon atoms, a substituted or unsubstituted aromatic hydrocarbon group having 6 to 18 carbon atoms, a substituted or unsubstituted aromatic heterocyclic group having 3 to 17 carbon atoms, or a linked aromatic group in which 2 to 3 of these aromatic rings are linked to each other,

[C11]

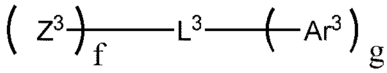

(3)

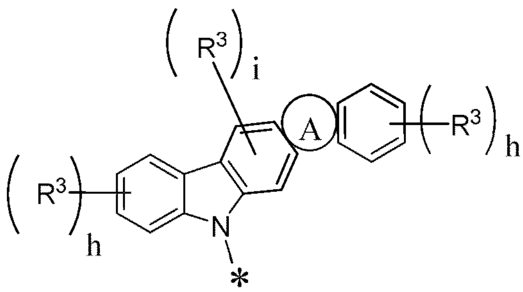

(3a)

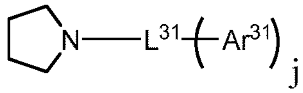

(3b)

wherein $Z^3$ is an indolocarbazole ring-containing group represented by the formula (3a);
* is a bonding site to $L^3$;
the ring A is a heterocyclic ring represented by the formula (3b) and is fused with an adjacent ring at an arbitrary

position;
each of $L^3$ and $L^{31}$ is independently a substituted or unsubstituted aromatic hydrocarbon group having 6 to 30 carbon atoms or a substituted or unsubstituted aromatic heterocyclic group having 3 to 17 carbon atoms;
each of $Ar^3$ and $Ar^{31}$ is independently a substituted or unsubstituted aromatic hydrocarbon group having 6 to 30 carbon atoms, a substituted or unsubstituted aromatic heterocyclic group having 3 to 17 carbon atoms, or a linked aromatic group in which 2 to 8 of these aromatic rings are linked to each other;
$R^3$ is independently an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms;
f represents an integer of 1 to 3; g represents an integer of 0 to 3; h independently represents an integer of 0 to 4; i represents an integer of 0 to 2; and j represents an integer of 0 to 3.

[Fig. 1]

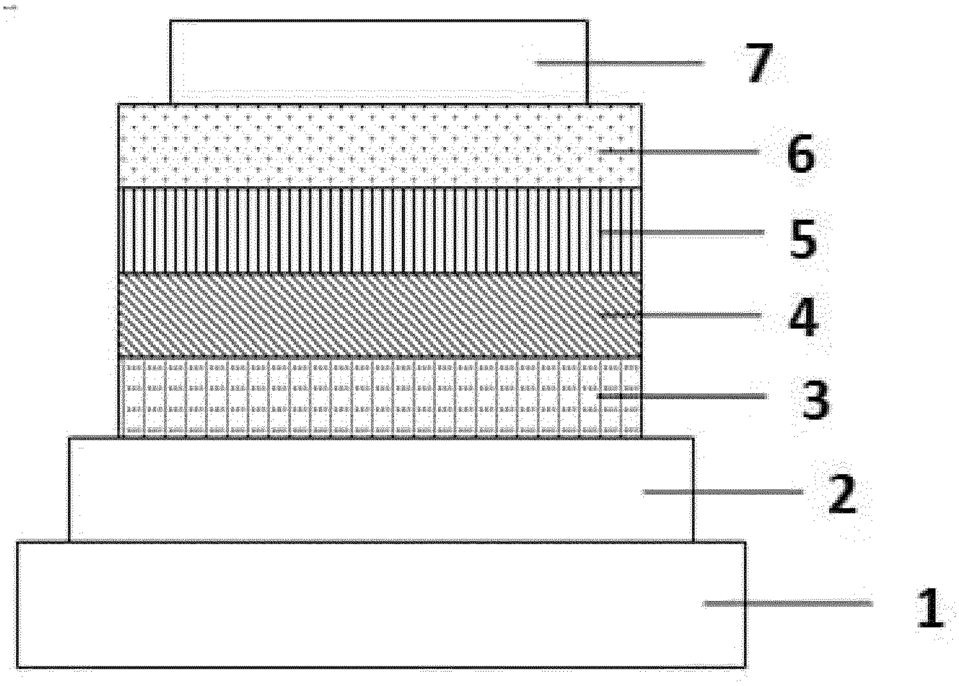

**INTERNATIONAL SEARCH REPORT**

International application No.
PCT/JP2021/011289

A. CLASSIFICATION OF SUBJECT MATTER
C09K 11/06(2006.01)i; H01L 51/50(2006.01)i
FI: H05B33/14 B; C09K11/06 660

According to International Patent Classification (IPC) or to both national classification and IPC

B. FIELDS SEARCHED

Minimum documentation searched (classification system followed by classification symbols)
C09K11/06; H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>A | WO 2018/198844 A1 (NIPPON STEEL & SUMIKIN CHEMICAL CO., LTD.) 01 November 2018 (2018-11-01) claims, paragraphs [0060]-[0063], etc. | 13<br>1-12 |
| P, X | JP 2020-167149 A (SUMITOMO CHEMICAL CO., LTD.) 08 October 2020 (2020-10-08) paragraph [0239] D69-D72, etc. | 1, 7, 9-13 |
| P, X | JP 2020-167393 A (SUMITOMO CHEMICAL CO., LTD.) 08 October 2020 (2020-10-08) paragraph [0229] D48, etc. | 1, 7, 10-13 |
| P, X | WO 2020/203210 A1 (SUMITOMO CHEMICAL CO., LTD.) 08 October 2020 (2020-10-08) paragraph [0196] D6, D7, etc. | 1, 7, 10-13 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 June 2021 (07.06.2021) | 22 June 2021 (22.06.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/011289

C (Continuation). DOCUMENTS CONSIDERED TO BE RELEVANT

| Category* | Citation of document, with indication, where appropriate, of the relevant passages | Relevant to claim No. |
|---|---|---|
| P, X | JP 2020-120096 A (SAMSUNG DISPLAY CO., LTD.) 06 August 2020 (2020-08-06) paragraph [0189], example 12, etc. | 1, 7, 9-13 |
| A | CN 109411634 A (KUNSHAN GOVISIONOX OPTOELECTRONICS CO., LTD.) 01 March 2019 (2019-03-01) entire text, all drawings | 1-13 |
| A | CN 109192874 (KUNSHAN GOVISIONOX OPTOELECTRONICS CO., LTD.) 11 January 2019 (2019-01-11) entire text, all drawings | 1-13 |
| A | US 2019/0378982 A1 (GUANGZHOU CHINARAY OPTOELECTRONIC MATERIALS LTD.) 12 December 2019 (2019-12-12) entire text | 1-13 |
| A | WO 2020/040298 A1 (KWANSEI GAKUIN EDUCATIONAL FOUNDATION) 27 February 2020 (2020-02-27) entire text, all drawings | 1-13 |
| A | WO 2011/070963 A1 (NIPPON STEEL CHEMICAL CO., LTD.) 16 June 2011 (2011-06-16) entire text, all drawings | 1-13 |

Form PCT/ISA/210 (continuation of second sheet) (January 2015)

**INTERNATIONAL SEARCH REPORT**
Information on patent family members

International application No.
PCT/JP2021/011289

| Patent Documents referred in the Report | Publication Date | Patent Family | Publication Date |
|---|---|---|---|
| WO 2018/198844 A1 | 01 Nov. 2018 | EP 3618132 A1<br>claims, paragraphs [0059]-[0061], etc.<br>CN 110574180 A<br>KR 10-2020-0002885 A<br>TW 201843156 A | |
| JP 2020-167149 A | 08 Oct. 2020 | (Family: none) | |
| JP 2020-167393 A | 08 Oct. 2020 | (Family: none) | |
| WO 2020/203210 A1 | 08 Oct. 2020 | (Family: none) | |
| JP 2020-120096 A | 06 Aug. 2020 | (Family: none) | |
| CN 109411634 A | 01 Mar. 2019 | US 2020/0203652 A1<br>entire text, all drawings<br>WO 2020/042626 A1 | |
| CN 109192874 A | 11 Jan. 2019 | US 2020/0203651 A1<br>entire text, all drawings<br>WO 2020/042606 A1 | |
| US 2019/0378982 A1 | 12 Dec. 2019 | WO 2018/095394 A1<br>entire text<br>CN 109792002 A | |
| WO 2020/040298 A1 | 27 Feb. 2020 | (Family: none) | |
| WO 2011/070963 A1 | 16 Jun. 2011 | US 2015/0166886 A1<br>entire text, all drawings<br>EP 2511360 A1<br>CN 102648268 A<br>KR 10-2012-0112517 A<br>TW 201136931 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010134350 A
- WO 2011070963 A
- WO 2017138526 A
- WO 2018198844 A
- WO 2020040298 A